(19)

**Europäisches Patentamt**
**European Patent Office**
**Office européen des brevets**

(11) **EP 4 131 380 A1**

(12) **EUROPEAN PATENT APPLICATION**
published in accordance with Art. 153(4) EPC

(43) Date of publication:
**08.02.2023 Bulletin 2023/06**

(21) Application number: **21778940.3**

(22) Date of filing: **24.03.2021**

(51) International Patent Classification (IPC):
**H01L 27/146** (1990.01)    **H04N 5/359** (2011.01)
**H04N 5/374** (2011.01)

(52) Cooperative Patent Classification (CPC):
**H01L 27/146; H04N 25/62; H04N 25/76;**
**Y02E 10/549**

(86) International application number:
**PCT/JP2021/012399**

(87) International publication number:
**WO 2021/200508 (07.10.2021 Gazette 2021/40)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **31.03.2020 JP 2020064018**
**19.03.2021 JP 2021045946**

(71) Applicants:
• **Sony Group Corporation**
**Tokyo 108-0075 (JP)**
• **Sony Semiconductor Solutions Corporation**
**Atsugi-shi, Kanagawa 243-0014 (JP)**

(72) Inventors:
• **NAKANO, Hiroshi**
**Tokyo 108-0075 (JP)**

• **HIRATA, Shintarou**
**Atsugi-shi, Kanagawa 243-0014 (JP)**
• **MUROYAMA, Masakazu**
**Tokyo 108-0075 (JP)**
• **YAMAZAKI, Yusuke**
**Tokyo 108-0075 (JP)**
• **MORIWAKI, Toshiki**
**Tokyo 108-0075 (JP)**
• **IINO, Yoichiro**
**Tokyo 108-0075 (JP)**
• **KURISHIMA, Kazunori**
**Atsugi-shi, Kanagawa 243-0014 (JP)**
• **MURAKAMI, Yosuke**
**Tokyo 108-0075 (JP)**

(74) Representative: **Müller Hoffmann & Partner**
**Patentanwälte mbB**
**St.-Martin-Strasse 58**
**81541 München (DE)**

(54) **IMAGING ELEMENT AND IMAGING DEVICE**

(57) An imaging element according to an embodiment of the present disclosure includes: a first electrode and a second electrode; a third electrode; a photoelectric conversion layer; and a semiconductor layer. The first electrode and the second electrode are disposed in parallel. The third electrode is disposed to be opposed to the first electrode and the second electrode. The photoelectric conversion layer is provided between the first electrode and second electrode and the third electrode. The photoelectric conversion layer includes an organic material. The semiconductor layer includes a first layer and a second layer that are stacked in order from the first electrode and second electrode side between the first electrode and second electrode and the photoelectric conversion layer. The first layer has a larger value for C5s indicating a contribution ratio of a 5s orbital to a conduction band minimum than a value of the second layer for C5s. The second layer has a larger value for $E_{VO}$ indicating oxygen deficiency generation energy or a larger value for $E_{VN}$ indicating nitrogen deficiency generation energy than a value of the first layer for $E_{VO}$ or $E_{VN}$.

**EP 4 131 380 A1**

[ FIG. 1 ]

**Description**

Technical Field

The present disclosure relates to an imaging element in which, for example, an organic material is used and an imaging device including the imaging element.

Background Art

For example, PTL 1 discloses an imaging element provided with an electrode for electric charge accumulation in a photoelectric conversion section including a first electrode, a photoelectric conversion layer, and a second electrode that are stacked, thereby achieving an improvement in image quality in imaging. The electrode for electric charge accumulation is disposed to be spaced apart from the first electrode and disposed to be opposed to the photoelectric conversion layer with an insulating layer interposed in between.

Citation List

Patent Literature

PTL 1: Japanese Unexamined Patent Application Publication No. 2017-157816

Summary of the Invention

Incidentally, an imaging element is requested to have improved afterimage characteristics.

It is desirable to provide an imaging element and an imaging device each of which makes it possible to improve the afterimage characteristics.

An imaging element according to an embodiment of the present disclosure includes: a first electrode and a second electrode; a third electrode; a photoelectric conversion layer; and a semiconductor layer. The first electrode and the second electrode are disposed in parallel. The third electrode is disposed to be opposed to the first electrode and the second electrode. The photoelectric conversion layer is provided between the first electrode and second electrode and the third electrode. The photoelectric conversion layer includes an organic material. The semiconductor layer includes a first layer and a second layer that are stacked in order from the first electrode and second electrode side between the first electrode and second electrode and the photoelectric conversion layer. The first layer has a larger value for C5s indicating a contribution ratio of a 5s orbital to a conduction band minimum than a value of the second layer for C5s. The second layer has a larger value for $E_{VO}$ indicating oxygen deficiency generation energy or a larger value for $E_{VN}$ indicating nitrogen deficiency generation energy than a value of the first layer for $E_{VO}$ or $E_{VN}$.

An imaging device according to an embodiment of the present disclosure includes the one or more imaging elements according to the embodiment of the present disclosure described above for each of a plurality of pixels.

The imaging element according to the embodiment of the present disclosure and the imaging device according to the embodiment are each provided with the semiconductor layer between the first electrode and second electrode and the photoelectric conversion layer. The first electrode and the second electrode are disposed in parallel. In the semiconductor layer, the first layer and the second layer are stacked in this order from the first electrode and second electrode side. This first layer has a larger value for C5s than the value of the second layer for C5s. This improves the characteristics of transporting the electric charge accumulated in the semiconductor layer above the first electrode in the in-plane direction. In addition, the second layer has a larger value for $E_{VO}$ or $E_{VN}$ than the value of the first layer for $E_{VO}$ or $E_{VN}$. This reduces the elimination of oxygen or nitrogen from the first layer and reduces the occurrence of traps at the interface between the semiconductor layer and the photoelectric conversion layer.

Brief Description of Drawing

[FIG. 1] FIG. 1 is a cross-sectional schematic diagram illustrating an example of a configuration of an imaging element according to a first embodiment of the present disclosure.

[FIG. 2] FIG. 2 is a plane schematic diagram illustrating an example of a pixel configuration of an imaging device including the imaging element illustrated in FIG. 1.

[FIG. 3] FIG. 3 is a cross-sectional schematic diagram illustrating an example of a configuration of an organic photoelectric conversion section illustrated in FIG. 1.

[FIG. 4] FIG. 4 is a schematic diagram of a pattern obtained by subjecting of a TEM image of a crystal layer to two-dimensional FFT.

[FIG. 5] FIG. 5 is a schematic diagram of a pattern obtained by subjecting of a TEM image of an amorphous layer to the two-dimensional FFT.

[FIG. 6] FIG. 6 is a diagram illustrating a relationship between the pattern of the crystal layer illustrated in FIG. 4 and an intensity profile thereof.

[FIG. 7] FIG. 7 is a diagram illustrating a relationship between the pattern of the amorphous layer illustrated in FIG. 5 and an intensity profile thereof.

[FIG. 8] FIG. 8 is a diagram describing a configuration of elements in a semiconductor layer included in an organic photoelectric conversion section illustrated in FIG. 1.

[FIG. 9] FIG. 9 is a diagram describing movement of electric charge in a layer including a 4s element and a 5s element as principal components.

[FIG. 10] FIG. 10 is a diagram describing movement of electric charge in a layer including only a 5s element as a principal component.

[FIG. 11] FIG. 11 is an equivalent circuit diagram of the imaging element illustrated in FIG. 1.

[FIG. 12] FIG. 12 is a schematic diagram illustrating disposition of a lower electrode and a transistor included in a controller in the imaging element illustrated in FIG. 1.

[FIG. 13] FIG. 13 is a cross-sectional view for describing a method of manufacturing the imaging element illustrated in FIG. 1.

[FIG. 14] FIG. 14 is a cross-sectional view of a step subsequent to FIG. 13.

[FIG. 15] FIG. 15 is a cross-sectional view of a step subsequent to FIG. 14.

[FIG. 16] FIG. 16 is a cross-sectional view of a step subsequent to FIG. 15.

[FIG. 17] FIG. 17 is a cross-sectional view of a step subsequent to FIG. 16.

[FIG. 18] FIG. 18 is a cross-sectional view of a step subsequent to FIG. 17.

[FIG. 19] FIG. 19 is a timing chart illustrating an operation example of the imaging element illustrated in FIG. 1.

[FIG. 20] FIG. 20 is a cross-sectional schematic diagram illustrating a configuration of an organic photoelectric conversion section according to a modification example 1 of the present disclosure.

[FIG. 21] FIG. 21 is a cross-sectional schematic diagram illustrating an example of a configuration of an organic photoelectric conversion section according to a modification example 2 of the present disclosure.

[FIG. 22] FIG. 22 is a cross-sectional schematic diagram illustrating another example of the configuration of the organic photoelectric conversion section according to the modification example 2 of the present disclosure.

[FIG. 23] FIG. 23 is a cross-sectional schematic diagram illustrating an example of a configuration of an organic photoelectric conversion section according to a modification example 3 of the present disclosure.

[FIG. 24] FIG. 24 is a cross-sectional schematic diagram illustrating an example of a configuration of an imaging element according to a second embodiment of the present disclosure.

[FIG. 25] FIG. 25 is a plane schematic diagram illustrating an example of a pixel configuration of an imaging device including the imaging element illustrated in FIG. 24.

[FIG. 26] FIG. 26 is a characteristic diagram illustrating a relationship between a content and carrier mobility of Ga in an experimental example 1 to an experimental example 6.

[FIG. 27] FIG. 27 is a characteristic diagram illustrating a relationship between a content and carrier concentration of Ga in an experimental example 1 to an experimental example 6.

[FIG. 28] FIG. 28 is a cross-sectional schematic diagram illustrating an example of a configuration of an imaging element according to a modification example 4 of the present disclosure.

[FIG. 29] FIG. 29 is a cross-sectional schematic diagram illustrating an example of a configuration of an imaging element according to a modification example 5 of the present disclosure.

[FIG. 30A] FIG. 30A is a cross-sectional schematic diagram illustrating an example of a configuration of an imaging element according to a modification example 6 of the present disclosure.

[FIG. 30B] FIG. 30B is a plane schematic diagram illustrating an example of a pixel configuration of an imaging device including the imaging element illustrated in FIG. 30A.

[FIG. 31A] FIG. 31A is a cross-sectional schematic diagram illustrating an example of a configuration of an imaging element according to a modification example 7 of the present disclosure.

[FIG. 31B] FIG. 31B is a plane schematic diagram illustrating an example of a pixel configuration of an imaging device including the imaging element illustrated in FIG. 31A.

[FIG. 32] FIG. 32 is a cross-sectional schematic diagram illustrating an example of a configuration of an imaging element according to a modification example 8 of the present disclosure.

[FIG. 33] FIG. 33 is a block diagram illustrating an example of a configuration of an imaging device in which the imaging element illustrated in FIG. 1 or the like is used as a pixel.

[FIG. 34] FIG. 34 is a functional block diagram illustrating an example of an electronic apparatus (camera) in which the imaging device illustrated in FIG. 33 is used.

[FIG. 35] FIG. 35 is a block diagram illustrating another example of the configuration of the imaging device in which the imaging element illustrated in FIG. 1 or the like is used as a pixel.

[FIG. 36] FIG. 36 is a block diagram illustrating another example of a configuration of an electronic apparatus including the imaging device illustrated in FIG. 33 or the like.

[FIG. 37] FIG. 37 is a block diagram depicting an example of a schematic configuration of an in-vivo information acquisition system.

[FIG. 38] FIG. 38 is a view depicting an example of a schematic configuration of an endoscopic surgery system.

[FIG. 39] FIG. 39 is a block diagram depicting an example of a functional configuration of a camera head and a camera control unit (CCU).

[FIG. 40] FIG. 40 is a block diagram depicting an example of schematic configuration of a vehicle control system.

[FIG. 41] FIG. 41 is a diagram of assistance in explaining an example of installation positions of an outside-vehicle information detecting section and an imaging section.

Modes for Carrying Out the Invention

The following describes an embodiment of the present disclosure in detail with reference to the drawings. The following description is a specific example of the present disclosure, but the present disclosure is not limited to the following modes. In addition, the present disclosure is not also limited to the disposition, dimensions, dimension ratios, and the like of the respective components illustrated in the respective diagrams. It is to be noted that description is given in the following order.

1. First Embodiment (an example of an imaging element including a semiconductor layer including two layers having a predetermined value for C5s and a value for Evo or $E_{VN}$ between a lower electrode and a photoelectric conversion layer)

1-1. Configuration of Imaging Element
1-2. Method of Manufacturing Imaging Element
1-3. Signal Acquisition Operation of Imaging Element
1-4. Workings and Effects

2. Modification Examples

2-1. Modification Example 1 (an example in which a protective layer is further provided between a semiconductor layer and a photoelectric conversion layer)
2-2. Modification Example 2 (an example in which a semiconductor layer having a three-layer structure is provided between a lower electrode and a photoelectric conversion layer)
2-3. Modification Example 3 (an example in which a transfer electrode is further provided as a lower electrode)

3. Second Embodiment (an example of an imaging element including a semiconductor layer including two layers having a predetermined value for ΔEN and a value for Evo between a lower electrode and a photoelectric conversion layer)
4. Modification Examples

4-1. Modification Example 4 (an example in which two organic photoelectric conversion sections are stacked on a semiconductor substrate)
4-2. Modification Example 5 (an example in which three organic photoelectric conversion sections are stacked on a semiconductor substrate)
4-3. Modification Example 6 (an example of an imaging element that uses a color filter to disperse light)
4-4. Modification Example 7 (another example of an imaging element that uses a color filter to disperse light)
4-5. Modification Example 8 (an example in which two organic photoelectric conversion sections are stacked on a semiconductor substrate)

5. Application Examples
6. Practical Application Examples

<1. First Embodiment>

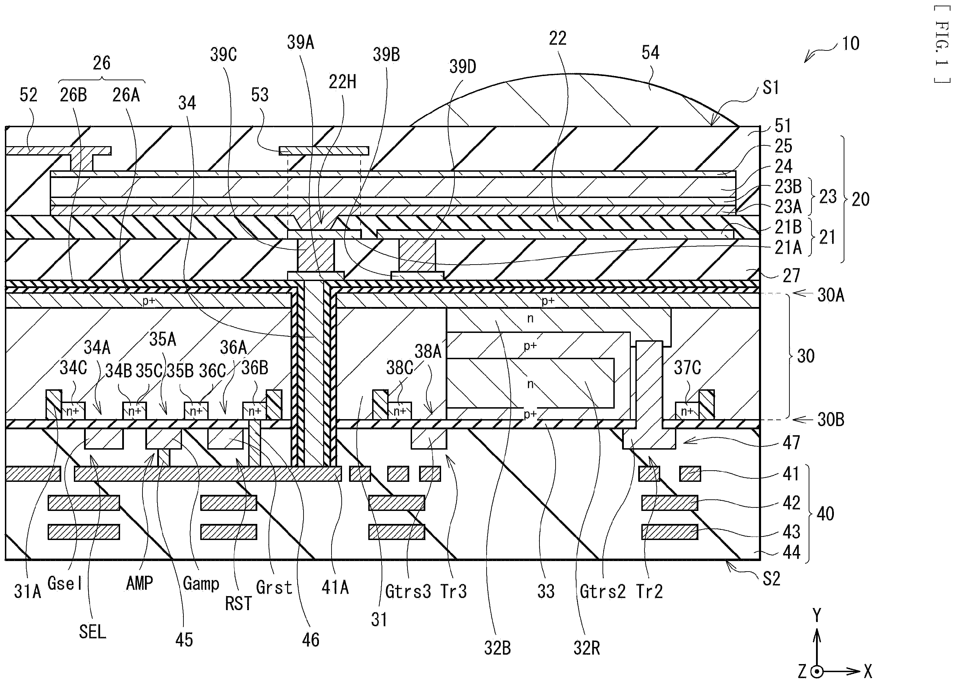

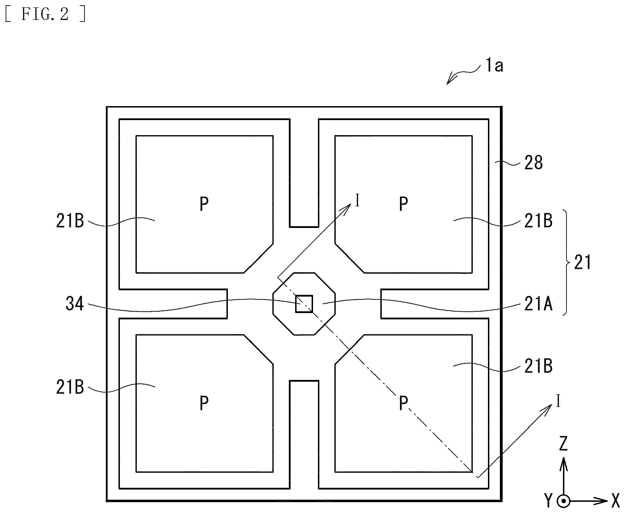

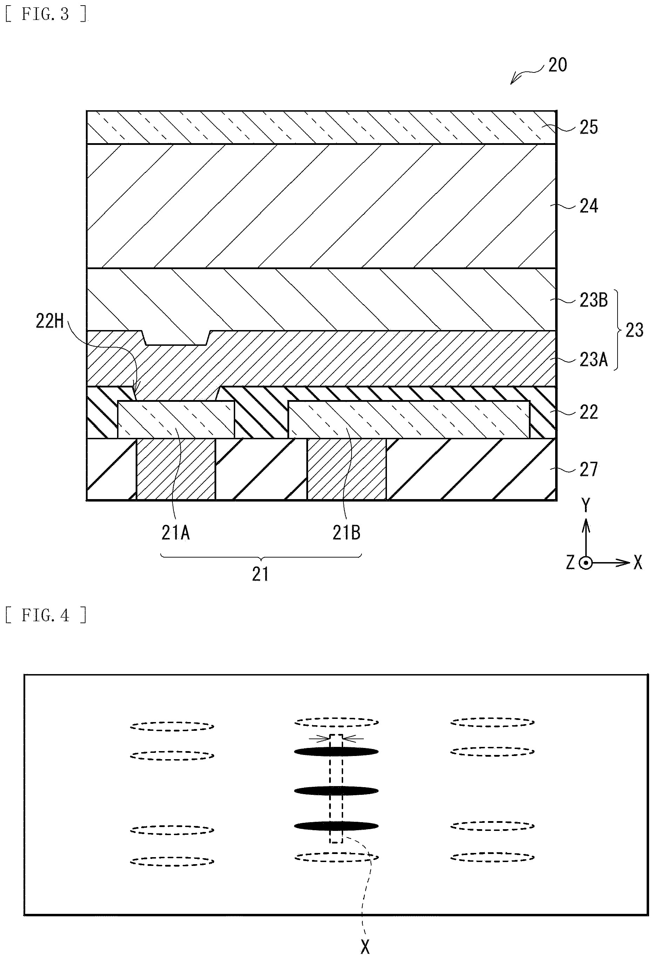

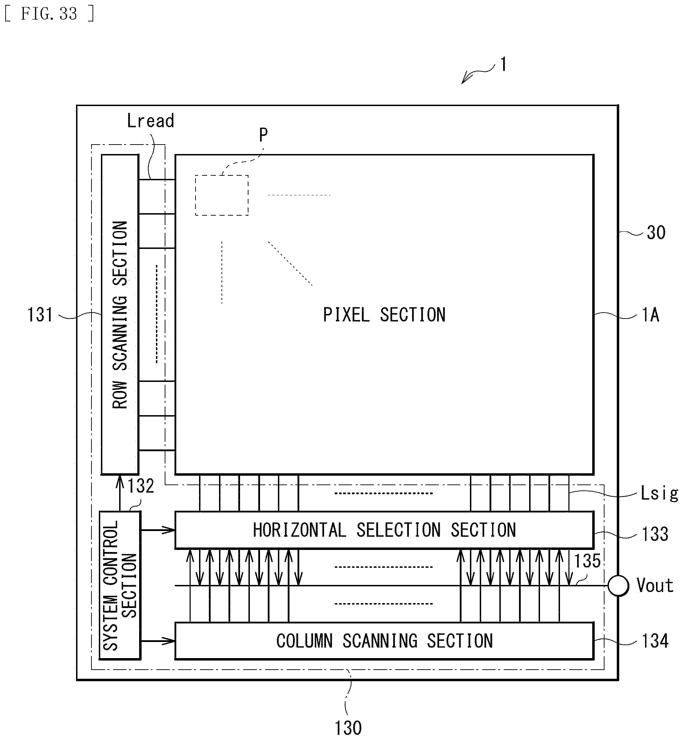

FIG. 1 illustrates a cross-sectional configuration of an imaging element (imaging element 10) according to a first embodiment of the present disclosure. FIG. 2 schematically illustrates an example of a planar configuration of the imaging element 10 illustrated in FIG. 1. FIG. 1 illustrates a cross section taken along the I-I line illustrated in FIG. 2. FIG. 3 is a schematic enlarged view of an example of a cross-sectional configuration of the main portion (organic photoelectric conversion section 20) of the imaging element 10 illustrated in FIG. 1. The imaging element 10 is included, for example, in one of pixels (unit pixels P) that are repeatedly disposed in an array in a pixel section 1A of an imaging device (e.g., an imaging device 1; see FIG. 33) such as a CMOS (Complementary Metal Oxide Semiconductor) image sensor used for an electronic apparatus such as a digital still camera or a video camera. In the pixel section 1A, pixel units 1a are repeatedly disposed as repeating units in an array having the row direction and the column direction. Each of the pixel units 1a includes the four unit pixels P that are disposed, for example, in two rows and two columns as illustrated in FIG. 2.

The imaging element 10 according to the present embodiment is provided with a semiconductor layer 23 having a stacked structure between a lower electrode 21 and a photoelectric conversion layer 24 in the organic photoelectric conversion section 20 provided on a semiconductor substrate 30. The lower electrode 21 includes a readout electrode 21A and an accumulation electrode 21B. This semiconductor layer 23 includes, for example, a first semiconductor layer 23A and a second semiconductor layer 23B. The first semiconductor layer 23A and the second semiconductor layer 23B are stacked in this order from the lower electrode 21 side. The first semiconductor layer 23A has a larger value for C5s than the value of the second semiconductor layer 23B for C5s. The second semiconductor layer 23B has a larger value for $E_{VO}$ or $E_{VN}$ than the value of the first semiconductor layer 23A for $E_{VO}$ or $E_{VN}$. This readout electrode 21A corresponds to a specific example of a "second electrode" according to the present disclosure and the accumulation electrode 21B corresponds to a specific example of a "first electrode" according to the present disclosure. In addition, the first semiconductor layer 23A corresponds to a specific example of a "first layer" according to the present disclosure and the second semiconductor layer 23B corresponds to a specific example of a "second layer" according to the present disclosure.

(1-1. Configuration of Imaging Element)

The imaging element 10 is a so-called vertical spectroscopic imaging element in which the one organic photoelectric conversion section 20 and two inorganic photoelectric conversion sections 32B and 32R are stacked in the vertical direction. The organic photoelectric conversion section 20 is provided on a first surface (back surface) 30A side of the semiconductor substrate 30. The inorganic photoelectric conversion sections 32B and 32R are formed to be buried in the semiconductor substrate 30 and stacked in the thickness direction of the semiconductor substrate 30.

The organic photoelectric conversion section 20 and the inorganic photoelectric conversion sections 32B and 32R perform photoelectric conversion by selectively detecting respective pieces of light in different wavelength ranges. For example, the organic photoelectric conversion section 20 acquires a color signal of green (G). The inorganic photoelectric conversion sections 32B and 32R respectively acquire a color signal of blue (B) and a color signal of red (R) by using a difference between absorption coefficients. This allows the imaging element 10 to acquire a plurality of types of color signals in the one unit pixel P without using any color filter.

It is to be noted that, in the present embodiment, a case is described where the electron of a pair (exciton) of an electron and a hole generated through photoelectric conversion is read out as signal charge (a case where the n-type semiconductor region is used as a photoelectric conversion layer). In addition, in the drawings, "+ (plus)" attached to "p" and "n" indicates a high p-type or n-type impurity concentration.

A second surface (front surface) 30B of the semiconductor substrate 30 is provided, for example, with floating diffusions (floating diffusion layers) FD1 (a region 36B in the semiconductor substrate 30), FD2 (a region 37C in the semiconductor substrate 30), and FD3 (a region 38C in the semiconductor substrate 30), transfer transistors Tr2 and Tr3, an amplifier transistor (modulation element) AMP, a reset transistor RST, and a selection transistor SEL. The second surface 30B of the semiconductor substrate 30 is further provided with a multilayer wiring layer 40 with a gate insulating layer 33 interposed in between. The multilayer wiring layer 40 has, for example, a configuration in which wiring layers 41, 42, and 43 are stacked in an insulating layer 44. A peripheral portion of the semiconductor substrate 30 or the periphery of the pixel section 1A is provided with a peripheral circuit portion 130 (see FIG. 33) including a logic circuit or the like.

It is to be noted that the diagram illustrates the first surface 30A side of the semiconductor substrate 30 as a light incidence side S1, and the second surface 30B side thereof as a wiring layer side S2.

In the organic photoelectric conversion section 20, the semiconductor layer 23 and the photoelectric conversion layer 24 are stacked in this order from the lower electrode 21 side between the lower electrode 21 and an upper electrode 25 that are disposed to be opposed to each other. The photoelectric conversion layer 24 is formed by using an organic material. As described above, the first semiconductor layer 23A and the second semiconductor layer 23B are stacked in this order from the lower electrode 21 side in the semiconductor layer 23. The first semiconductor layer 23A has a larger value for C5s than the value of the second semiconductor layer 23B for C5s. The second semiconductor layer 23B has a larger value for $E_{VO}$ or $E_{VN}$ than the value of the first semiconductor layer 23A for $E_{VO}$ or $E_{VN}$. The photoelectric conversion layer 24 includes a p-type semiconductor and an n-type semiconductor and has a bulk heterojunction structure therein. The bulk heterojunction structure is a pin junction surface formed by mixing a p-type semiconductor and an n-type semiconductor.

The organic photoelectric conversion section 20 further includes an insulating layer 22 between the lower electrode 21 and the semiconductor layer 23. The insulating layer 22 is provided, for example, over the whole of the pixel section 1A. In addition, the insulating layer 22 has an opening 22H on the readout electrode 21A included in the lower electrode 21. The readout electrode 21A is electrically coupled to the first semiconductor layer 23A of the semiconductor layer 23 through this opening 22H.

It is to be noted that FIG. 1 illustrates an example in which the semiconductor layers 23, the photoelectric conversion layers 24, and the upper electrodes 25 are separately formed for the respective imaging elements 10, but the semiconductor layer 23, the photoelectric conversion layer 24, and the upper electrode 25 may be provided, for example, as continuous layers that are common to the plurality of imaging elements 10.

For example, there are provided an insulating layer 26 and an interlayer insulating layer 27 between the first surface 30A of the semiconductor substrate 30 and the lower electrode 21. The insulating layer 26 includes a layer (fixed electric charge layer) 26A having fixed electric charge and a dielectric layer 26B having an insulation property.

The inorganic photoelectric conversion sections 32B and 32R each allow light to be dispersed in the vertical direction by using the fact that pieces of light to be absorbed have different wavelengths in accordance with the light incidence depth in the semiconductor substrate 30 including a silicon substrate. The inorganic photoelectric conversion sections 32B and 32R each have a pn junction in a predetermined region in the semiconductor substrate 30.

There is provided a through electrode 34 between the first surface 30A and the second surface 30B of the semiconductor substrate 30. The through electrode 34 is electrically coupled to the readout electrode 21A. The organic photoelectric conversion section 20 is coupled to a gate Gamp of the amplifier transistor AMP and the one source/drain region 36B of the reset transistor RST (reset transistor Trirst) also serving as the floating diffusion FD1 through the through electrode 34. This allows the imaging element 10 to favorably transfer the electric charge (electrons here) generated by the organic photoelectric conversion section 20 on the first surface 30A side of the semiconductor substrate 30 to the second surface 30B side of the semiconductor substrate 30 through the through electrode 34 and increase the characteristics.

The lower end of the through electrode 34 is coupled to a coupling section 41A in the wiring layer 41 and the coupling section 41A and the gate Gamp of the amplifier transistor AMP are coupled through a lower first contact 45. The coupling section 41A and the floating diffusion FD1 (region 36B) are coupled, for example, through a lower second contact 46. The upper end of the through electrode 34 is coupled to the readout electrode 21A, for example, through a pad section 39A and an upper first contact 39C.

There is provided a protective layer 51 above the organic photoelectric conversion section 20. There are provided a wiring line 52 and a light shielding film 53 in the protective layer 51. The wiring line 52 electrically couples the upper electrode 25 and the peripheral circuit portion 130, for example, around the pixel section 1A. There is further provided an optical member such as a planarization layer (not illustrated) or an on-chip lens 54 above the protective layer 51.

In the imaging element 10 according to the present embodiment, light having entered the organic photoelectric conversion section 20 from the light incidence side S1 is absorbed by the photoelectric conversion layer 24. The excitons generated by this move to the interface between an electron donor and an electron acceptor included in the photoelectric conversion layer 24 and undergo exciton separation. In other words, the excitons are dissociated into electrons and holes. The electric charge (electrons and holes) generated here is transported to different electrodes by diffusion due to a carrier concentration difference and an internal electric field caused by a work function difference between the anode (e.g., the upper electrode 25) and the cathode (e.g., the lower electrode 21). The transported electric charge is detected as a photocurrent. In addition, the application of a potential between the lower electrode 21 and the upper electrode 25 makes it possible to control the transport directions of electrons and holes.

The following describes configurations, materials, and the like of the respective sections in detail.

The organic photoelectric conversion section 20 is an organic photoelectric conversion element that absorbs green light corresponding to a portion or the whole of a selective wavelength range (e.g., 450 nm or more and 650 nm or less) and generates excitons.

The lower electrode 21 includes, for example, the readout electrode 21A and the accumulation electrode 21B disposed in parallel on the interlayer insulating layer 27. The readout electrode 21A is for transferring the electric charge generated in the photoelectric conversion layer 24 to the floating diffusion FD1. Each of the pixel units 1a is provided with the one readout electrode 21A. The pixel unit 1a includes the four unit pixels P that are disposed, for example, in two rows and two columns. The readout electrode 21A is coupled to the floating diffusion FD1, for example, through the upper first contact 39C, the pad section 39A, the through electrode 34, the coupling section 41A, and the lower second contact 46. The accumulation electrode 21B is for accumulating the electrons of the electric charge generated in the photoelectric conversion layer 24, for example, in the semiconductor layer 23 as signal charge. The accumulation electrode 21B is provided for each of the unit pixels P. Each of the unit pixels P is provided with the accumulation electrode 21B is provided in a region that is opposed to the light receiving surfaces of the inorganic photoelectric conversion sections 32B and 32R formed in the semiconductor substrate 30 and covers these light receiving surfaces. It is preferable that the accumulation electrode 21B be larger than the readout electrode 21A. This makes it possible to accumulate more electric charge.

The lower electrode 21 includes an electrically conducive film having light transmissivity. The lower electrode 21 includes, for example, ITO (indium tin oxide). In addition to ITO, a tin oxide ($SnO_2$)-based material to which a dopant is added or a zinc oxide-based material obtained by adding a dopant to zinc oxide (ZnO) may be used as a material included in the lower electrode 21. Examples of the zinc oxide-based material include aluminum zinc oxide (AZO) to which aluminum (Al) is added as a dopant, gallium zinc oxide (GZO) to which gallium (Ga) is added, and indium zinc oxide (IZO) to which indium (In) is added. In addition, IGZO, ITZO, CuI, $InSbO_4$, ZnMgO, $CuInO_2$, $MgIN_2O_4$, CdO, $ZnSnO_3$, or the like may also be used in addition to these.

The insulating layer 22 is for electrically separating the accumulation electrode 21B and the semiconductor layer 23. The insulating layer 22 is provided, for example, above the interlayer insulating layer 27 to cover the lower electrode 21. The insulating layer 22 is provided with the opening 22H on the readout electrode 21A of the lower electrode 21 and the readout electrode 21A and the semiconductor layer 23 are electrically coupled through this opening 22H. The insulating layer 22 includes, for example, a single layer film including one of silicon oxide ($SiO_x$), silicon nitride ($SiN_x$), silicon oxynitride (SiON), or the like or a stacked film including two or more of them. The insulating layer 22 has, for example, a thickness of 20 nm or more and 500 nm or less.

The semiconductor layer 23 is for accumulating the electric charge generated by the photoelectric conversion layer 24. As described above, the semiconductor layer 23 is provided between the lower electrode 21 and the photoelectric conversion layer 24. The semiconductor layer 23 has a stacked structure in which the first semiconductor layer 23A and the second semiconductor layer 23B are stacked in this order from the lower electrode 21 side. Specifically, the first semiconductor layer 23A is provided on the insulating layer 22 that electrically separates the lower electrode 21 and the semiconductor layer 23. The first semiconductor layer 23A is electrically coupled directly to the readout electrode 21A in the opening 22H provided on the readout electrode 21A. The second semiconductor layer 23B is provided between the first semiconductor layer 23A and the photoelectric conversion layer 24.

It is possible to form the semiconductor layer 23 by using, for example, an oxide semiconductor material. Especially in the present embodiment, electrons of the electric charge generated by the photoelectric conversion layer 24 are used as signal charge. It is thus possible to form the semiconductor layer 23 by using an n-type oxide semiconductor material.

The first semiconductor layer 23A is for preventing the electric charge accumulated in the semiconductor layer 23 from being trapped at the interface with the insulating layer 22 and efficiently transferring the electric charge to the readout electrode 21A. The second semiconductor layer 23B is for preventing oxygen from being eliminated from the surface of the first semiconductor layer 23A and preventing the electric charge generated by the photoelectric conversion layer 24 from being trapped at the interface with the photoelectric conversion layer 24. It is therefore possible to form the first semiconductor layer 23A to cause an oxide semiconductor material to be included that has a larger value for C5s than the value of the second semiconductor layer 23B for C5s. It is possible to form the second semiconductor layer 23B to cause an oxide semiconductor material to be included that has a larger value for $E_{VO}$ than the value of the first semiconductor layer 23A for $E_{VO}$. Specifically, it is possible to form the first semiconductor layer 23A to cause an oxide semiconductor material to be included that satisfies C5s > 50%. More preferably, it is possible to form the first semiconductor layer 23A to cause an oxide semiconductor material to be included that satisfies C5s > 80%. It is possible to form the second semiconductor layer 23B to cause an oxide semiconductor material to be included that satisfies $E_{VO}$ > 2.3 eV More preferably, it is possible to form the second semiconductor layer 23B to cause an oxide semiconductor material to be included that satisfies $E_{VO}$ > 2.8 eV

C5s is a value indicating the contribution ratio of the 5s orbitals to the conduction band minimum (Conduction Band Minimum: CBM). In general, it is the CMB that serves as a passage of electrons in an oxide semiconductor. The CMB of the oxide semiconductor is made by mixing the s orbitals of the respective metal elements. In a case where the 5s orbitals (the s orbitals of cadmium (Cd), indium (In), and tin (Sn)), which spatially spread out the most among them, have a high ratio, transfer traps decrease.

It is possible to obtain C5s, for example, from the first-principles calculation. A model is created by a calculation technique used to calculate the oxygen defect generation energy described below. As with the method of calculating the oxygen defect generation energy, a model is created by using the number calculated from the valence with no subtraction from the number of oxygen atoms. The orbital corresponding to the CBM is identified from the electron state obtained by performing calculation for that model. It is to be noted that the CBM is the smallest energy orbital that is not occupied by electrons. The contribution ratio of the 5s orbitals (the s orbitals of Cd, In and Sn) to the CBM is obtained. Vienna Ab Initio Simulation Package (VASP) and other similar first-principles calculation software basically have techniques of calculating the contribution ratio. As an example, VASP describes the contribution ration in a file called PROCAR. In addition, in a case where Partial Density Of States (PDOS) is obtained, the contribution ratio may be obtained by identifying the CBM from PDOS.

$E_{VO}$ refers to the average oxygen deficiency generation energy value of a plurality of types of metal atoms. As the value of the oxygen deficiency generation energy is higher, oxygen atoms are less likely to be eliminated and oxygen atoms, oxygen molecules, or other atoms or molecules are less likely to be incorporated. It can be said that the state is stable.

It is possible to obtain the oxygen deficiency generation energy Evo, for example, from the first-principles calculation. The oxygen deficiency generation energy Evo is calculated from the following expression (1). Specifically, first, an amorphous structure having atoms having the same proportion as the metal element composition of interest and the corresponding number of oxygen atoms is created. The valence of typical metal ions is used for the number of oxygen atoms. In other words, zinc (Zn) and Cd are represented as +2-valent, gallium (Ga) and In are represented as +3-valent, and germanium (Ge) and Sn are represented as +4-valent. An oxygen ion is ⁻2-valent and a few oxygen atoms are used for neutralization. In addition, it is preferable that the total number of atoms be 80 or more. For example, in a case of the composition of $In_2SnZnO_6$, In: Sn:Zn = 2:1:1 is obtained. A model including 20 In atoms, 10 Sn atoms, 10 Zn atoms, and 60 O atoms in one unit cell is thus created. The total energy in this case is represented as $E_0$. To create a model, an amorphous structure is created by using a technique called simulated annealing and structure optimization is then performed. The detailed calculation conditions are described, for example, in non-Patent Literature (Phys. Status Solidi A 206, No. 5, 860-867 (2009)/DOI 10.1002/pssa.200881303).) Energy $E_{O2}$ of only oxygen molecules $O_2$ is calculated in the same unit cell size. Next, to create oxygen deficiency from the model described above, structure optimization is performed by eliminating one oxygen atom and the total energy is calculated. Similar calculation is performed for all the oxygen atoms and the average value thereof is calculated. This energy is represented as $E_1$.

$$\text{(Expression 1)} \quad E_{VO} = E_1 + (1/2)E_{O2} - E_0 \quad ..... \quad (1)$$

It is possible to form the first semiconductor layer 23A, for example, as an amorphous layer. This makes it possible to prevent the carrier density of the first semiconductor layer 23A from increasing and achieve a low carrier concentration. In addition, it is possible to suppress the occurrence of dangling bonds on a grain boundary in the first semiconductor layer 23A or at the interface with the insulating layer 22 and further reduce traps as compared with a case where the first semiconductor layer 23A is formed as a crystal layer. It is to be noted that the film quality of the second semiconductor layer 23B is not limited in particular. The second semiconductor layer 23B may be a crystal layer or the second semiconductor layer 23B may be formed as an amorphous layer.

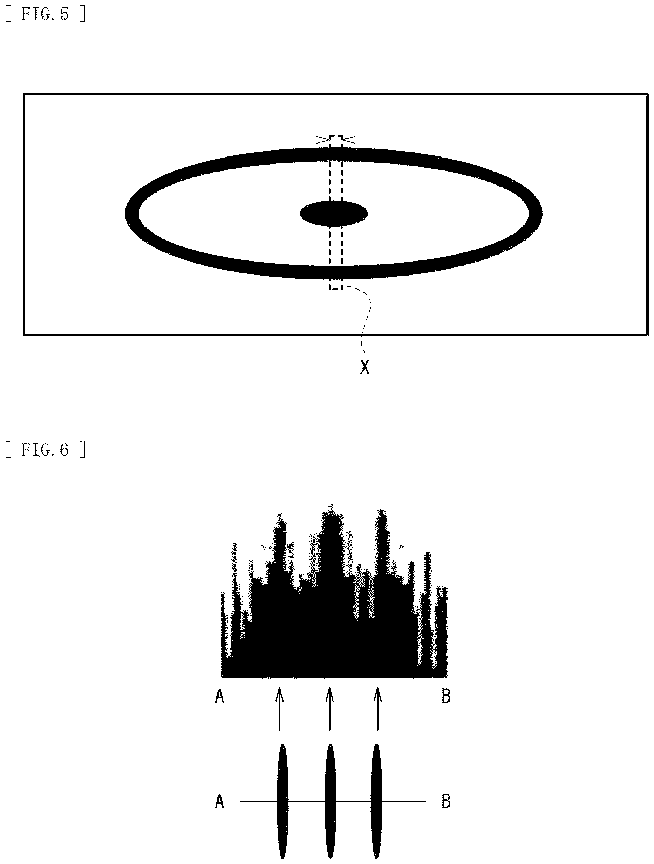

It is to be noted that it is possible to determine an amorphous layer or a crystal layer by using the presence or absence of a halo ring of a fast Fourier transform (FFT) image of a transmission electron microscope (TEM) image. For example, the TEM has, on the crystal layer, an image having a bright and dark fringe pattern that is caused by interference between a diffracted wave and a transmitted wave from a certain lattice plane of a crystal and corresponds to both intervals of the lattice. This is referred to as lattice fringe. In contrast, no lattice fringe is confirmed in a case of the amorphous layer. Further, it is possible to confirm the patterns illustrated in FIGs. 4 and 5 by subjecting a TEM image to FFT two-dimensionally. As illustrated in FIG. 4, it is possible to confirm a spotted pattern that corresponds, for example, the cycle of lattice fringes and extends in one direction in a case of the crystal layer. In contrast, in a case of an amorphous layer, a broad ring-shaped pattern is confirmable as illustrated in FIG. 5. This is a halo ring.

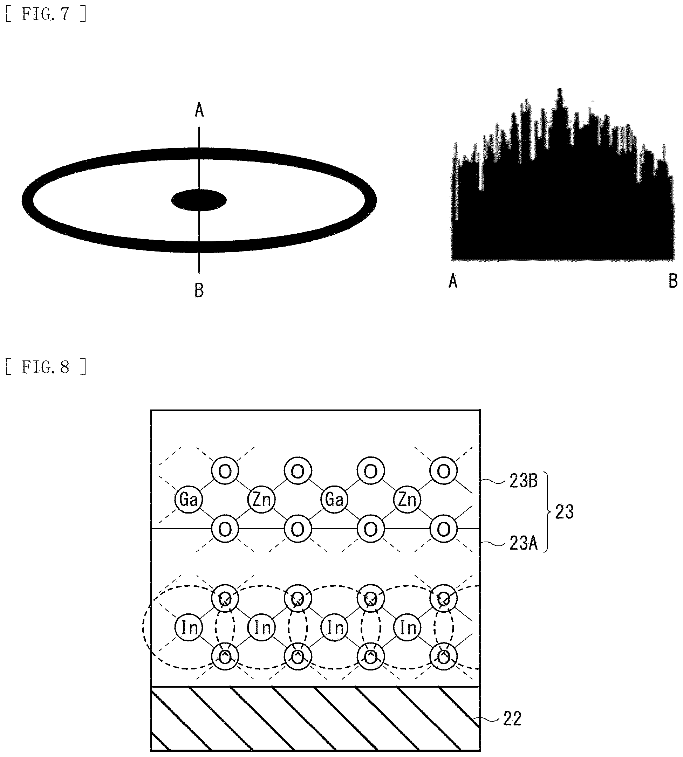

FIGs. 6 and 7 respectively illustrate the relationships between the patterns of the crystal layer and the amorphous layer illustrated in FIGs. 4 and 5 and the intensity profiles thereof. It is to be noted that the respective intensity profiles are actual intensity profiles (histograms) in which the unit pixels P are integrated by 30 pixels (regions X illustrated in FIGs. 4 and 5) in the horizontal direction of the diagrams for the FFT patterns of rectangular regions defined by the respective film thicknesses of the crystal layer and the amorphous layer × a width of 45 nm. While three peaks corresponding to three spots colored in FIG. 4 are confirmable in the intensity profile of the crystal layer, a broad intensity profile is illustrated for the amorphous layer.

Examples of materials included in the semiconductor layer 23 (the first semiconductor layer 23A and the second semiconductor layer 23B) include ITO, IZO, IGO, ZTO, IGZO (In-Ga-Zn-O-based oxide semiconductor), GZTO (Ga-Zn-Sn-O-based oxide semiconductor), ITZO (In-Sn-Zn-O-based oxide semiconductor), IGZTO (In-Ga-Zn-Sn-O-based oxide semiconductor), and the like. In addition, it is possible to use IGTO (In-Ga-Sn-O-based oxide semiconductor) as a material included in the semiconductor layer 23. In addition, the semiconductor layer 23 may include, for example, silicon (Si), aluminum (Al), titanium (Ti), molybdenum (Mo), carbon (C), cadmium (Cd), and the like.

It is preferable to form the first semiconductor layer 23A by using ITO, IZO, indium-rich ITZO (a cation ratio of In > 50%), IGO, or tin-rich SnZnO (a cation ratio of Sn > 50%) among the materials described above. More specifically, it is preferable to form the first semiconductor layer 23A by using, for example, $In_2O_3$ (ITO) to which 10wt% of $SnO_2$ is added or $In_2O_3$ (IZO) to which 10wt% of ZnO is added. It is preferable to use IGZO, IGZTO, ZTO, GZTO, or IGTO for the second semiconductor layer 23B. More specifically, it is preferable to form the second semiconductor layer 23B by using, for example, ZTO having a cation ratio of Zn > 60%, IGZO in which In:Ga:Zn = 1:1:1 is satisfied, or IGZTO having a cation ratio of 50% or less for In + Sn and a ratio of 50% or more for Ga + An.

It is possible to adjust the values of the materials described above for C5s as follows. First, a candidate composition (cation ratio) is determined and oxygen atoms are added that are enough to cause cations thereof to be neutral with no excess or shortage in a case where the cations are ionized. In this case, it is desirable that the number of cations be about 30 to 40 or more. The valence of Sn is represented as +4, the valence of In is represented as +3, the valence of Ga is represented as +3, the valence of Zn is represented as +2, and the valence of O is represented as -2. For example, in a case of In12Ga12Zn12O48, $+ 3 \times 12 + 3 \times 12 + 2 \times 12 - 2 \times 48 = 0$ holds. A first-principles calculation model having the numbers of respective elements is then created and C5s is formed by using the method described above. This makes it possible to calculate the value of the composition of interest for C5s. It is to be noted that the value of C5s tends to increase as a 5s element such as In or Sn increases.

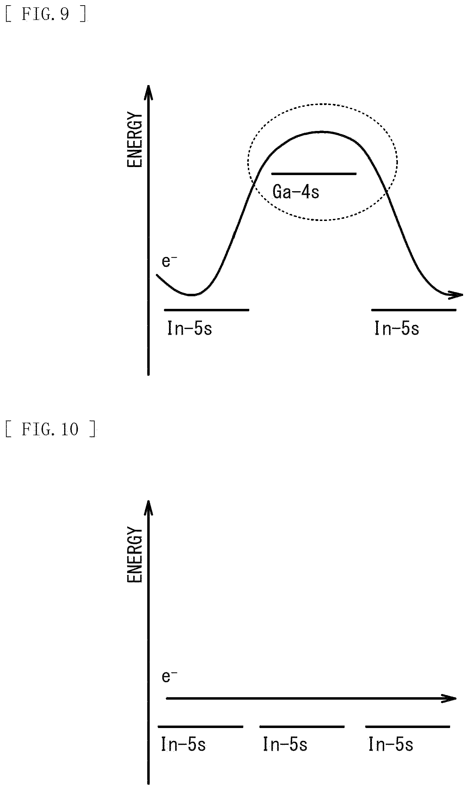

FIG. 8 illustrates a configuration of elements in the semiconductor layer 23 in a case where the first semiconductor layer 23A is formed by using, for example, ITO ($In_2O_3$ to which 10wt% of $SnO_2$ is added), which satisfies C5s > 80%, and the second semiconductor layer 23B is formed by using, for example, IGZO (In:Ga:Zn = 1:1:1), which satisfies $E_{VO}$ > 2.8 V FIG. 9 illustrates the movement of electric charge in a layer (C5s = 0.66) including an oxide semiconductor material including an element (4s element) having a 4s orbital and an element (5s element) having a 5s orbital as principal components. FIG. 10 illustrates the movement of electric charge in a layer (C5s = 1.0) including an oxide semiconductor material including only a 5s element as a principal component. In the first semiconductor layer 23A including an oxide semiconductor material including In, which is a 5s element, as a principal component, the 5s orbitals of the respective In elements are mixed as illustrated in FIG. 8. The electric charge accumulated in the semiconductor layer 23 is transferred from the photoelectric conversion layer 24 toward the readout electrode 21A in a transfer period described below with no change in energy as illustrated in FIG. 10. The electric charge is read out from the readout electrode 21A to the floating diffusion FD1. In contrast, in a layer including an oxide semiconductor material including, for example, Ga, which is a 4s element, and In, which is a 5s element, as principal components, the electric charge accumulated in the semiconductor layer 23 from the photoelectric conversion layer 24 is trapped on the 4s orbitals of Ga as illustrated in FIG. 9 and the movement to the readout electrode 21A is blocked .

The first semiconductor layer 23A has, for example, a thickness of 2 nm or more and 10 nm or less. The second semiconductor layer 23B has, for example, a thickness of 15 nm or more and 100 nm or less. Although within the thickness ranges described above, it is preferable that the ratio (t2/t1) of a thickness (t2) of the second semiconductor layer 23B to a thickness (t1) of the first semiconductor layer 23A be 4 or more and 8 or less. This allows the second semiconductor layer 23B to sufficiently absorb the carriers generated from the first semiconductor layer 23A.

Table 1 tabulates on-voltages at the film thickness ratios (t2/t1) between the first semiconductor layer 23A and the second semiconductor layer 23B. The on-voltages are calculated from an $I_D$-$V_{GS}$ curve obtained from the TFT evaluation of a fabricated simple TFT (Thin-Film-Transistor) element. The TFT element is obtained by forming a $SiO_2$ film, the first semiconductor layer 23A, and the second semiconductor layer 23B in order on a silicon substrate and providing a source electrode and a drain electrode on the second semiconductor layer 23B. It is desirable that the on-voltages be within a range of $\pm 2V$. Table 1 indicates that favorable results are obtained within the range of the film thickness ratio (t2/t1) = 4 to 8.

[Table 1]

|  | film thickness ratio (t2/t1) | | | | | | |
|---|---|---|---|---|---|---|---|
|  | 3 | 4 | 5 | 6 | 7 | 8 | 9 |
| on-voltage $V_{ON}$[V] | - 12V | -2V | 0V | 1V | 0V | 2V | 4V |

It is to be noted that, in a case where the first semiconductor layer 23A is further formed as an amorphous layer described above, it is possible to achieve a low carrier concentration while preventing the carrier density of the semiconductor layer 23 from increasing.

It is to be noted that nitride semiconductor materials or oxynitride semiconductor materials are also usable as materials included in the first semiconductor layer 23A and the second semiconductor layer 23B in addition to the oxide semiconductor materials described above. In a case where the first semiconductor layer 23A and the second semiconductor layer 23B are formed by using nitride semiconductor materials, the nitrogen deficiency generation energy $E_{VN}$ is used as an index in place of the oxygen deficiency generation energy $E_{VO}$. In other words, it is possible to form the second semiconductor layer 23B to cause a nitride semiconductor material to be included that has a larger value (e.g., $E_{VN} > 2.3$ eV) for $E_{VN}$ than the value of the first semiconductor layer 23A for $E_{VN}$. It is possible to similarly calculate the nitrogen deficiency generation energy $E_{VN}$ by replacing an oxygen atom with a nitrogen atom in the method of calculating the oxygen deficiency generation energy $E_{VO}$ described above.

The photoelectric conversion layer 24 is for converting light energy to electric energy. The photoelectric conversion layer 24 includes, for example, two or more types of organic semiconductor materials (a p-type semiconductor material or an n-type semiconductor material) that each function as a p-type semiconductor or an n-type semiconductor. The photoelectric conversion layer 24 has the junction surface (pin junction surface) therein between the p-type semiconductor material and the n-type semiconductor material. The p-type semiconductor relatively functions as an electron donor (donor) and the n-type semiconductor relatively functions as an electron acceptor (acceptor). The photoelectric conversion layer 24 provides a field in which excitons generated in absorbing light are separated into electrons and holes. Specifically, excitons are separated into electrons and holes at the interface (pin junction surface) between the electron donor and the electron acceptor.

The photoelectric conversion layer 24 may include an organic material or a so-called dye material in addition to the p-type semiconductor material and the n-type semiconductor material. The organic material or the dye material photoelectrically converts light in a predetermined wavelength range and transmits light in another wavelength range. In a case where the photoelectric conversion layer 24 is formed by using the three types of organic materials including a p-type semiconductor material, an n-type semiconductor material, and a dye material, it is preferable that the p-type semiconductor material and the n-type semiconductor material be materials each having light transmissivity in a visible region (e.g., 450 nm to 800 nm). The photoelectric conversion layer 24 has, for example, a thickness of 50 nm or more and 500 nm or less.

It is preferable that the photoelectric conversion layer 24 according to the present embodiment include an organic material and have absorption between the visible light and the near-infrared light. Examples of organic materials included in the photoelectric conversion layer 24 include a quinacridone derivative, a naphthalene derivative, an anthracene derivative, a phenanthrene derivative, a tetracene derivative, a pyrene derivative, a perylene derivative, and a fluoranthene derivative. The photoelectric conversion layer 24 includes two or more of the organic materials described above in combination. The organic materials described above function as a p-type semiconductor or an n-type semiconductor depending on the combination.

It is to be noted that the organic materials included in the photoelectric conversion layer 24 are not limited in particular. It is possible to use, for example, a polymer including phenylenevinylene, fluorene, carbazole, indole, pyrene, pyrrole, picoline, thiophene, acetylene, diacetylene, and the like or a derivative thereof in addition to the organic materials described above. Alternatively, it is possible to use a metal complex dye, a cyanine-based dye, a merocyanine-based dye, a phenylxanthene-based dye, a triphenylmethane-based dye, a rhodacyanine-based dye, a xanthene-based dye, a macrocyclic azaannulene-based dye, an azulene-based dye, a naphthoquinone-based dye, an anthraquinone-based dye, a chain compound in which a fused polycyclic aromatic group including pyrene and the like, an aromatic ring, or a heterocyclic compound is fused, a cyanine-like dye bonded by two nitrogen-containing hetero rings including quinoline, benzothiazole, benzoxazole, and the like that have a squarylium group and a croconic methine group as a bonded chain or by a squarylium group and a croconic methine group, or the like. It is to be noted that a dithiol metal complex-based dye, a metallophthalocyanine dye, a metalloporphyrine dye, or a ruthenium complex dye is included as the metal complex dye. A ruthenium complex dye is preferable in particular among them, but the metal complex dye is not limited to this.

The upper electrode 25 includes an electrically conducive film having light transmissivity as with the lower electrode 21. The upper electrode 25 includes, for example, ITO. In addition to this ITO, a tin oxide ($SnO_2$)-based material to which a dopant is added or a zinc oxide-based material obtained by adding a dopant to zinc oxide (ZnO) may be used as a material included in the upper electrode 25. Examples of the zinc oxide-based material include aluminum zinc oxide (AZO) to which aluminum (Al) is added as a dopant, gallium zinc oxide (GZO) to which gallium (Ga) is added, and indium zinc oxide (IZO) to which indium (In) is added. In addition, IGZO, ITZO, CuI, $InSbO_4$, ZnMgO, $CuInO_2$, $MgIN_2O_4$, CdO, $ZnSnO_3$, or the like may also be used in addition to these. The upper electrodes 25 may be separated for the respective unit pixels P or the upper electrode 25 may be formed as an electrode common to the respective unit pixels P. The upper electrode 25 has, for example, a thickness of 10 nm or more and 200 nm or less.

It is to be noted that there may be provided other layers between the photoelectric conversion layer 24 and the lower electrode 21 (e.g., between the semiconductor layer 23 and the photoelectric conversion layer 24) and between the photoelectric conversion layer 24 and the upper electrode 25. For example, the semiconductor layer 23, a buffer layer also serving as an electron blocking film, the photoelectric conversion layer 24, a buffer layer also serving as a hole blocking film, a work function adjustment layer, and the like may be stacked in order from the lower electrode 21 side. In addition, the photoelectric conversion layer 24 may have a pin bulk heterostructure in which, for example, a p-type blocking layer, a layer (i layer) including a p-type semiconductor and an n-type semiconductor, and an n-type blocking layer are stacked.

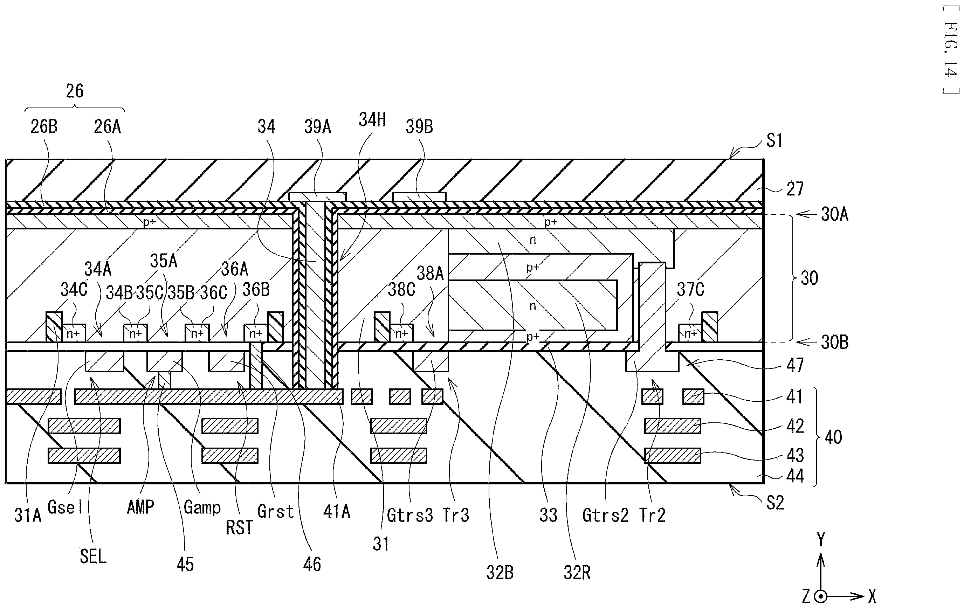

The insulating layer 26 covers the first surface 30A of the semiconductor substrate 30 and reduces the interface state with the semiconductor substrate 30. In addition, the insulating layer 26 is for suppressing the generation of dark currents from the interface with the semiconductor substrate 30. In addition, the insulating layer 26 extends from the first surface 30A of the semiconductor substrate 30 to a side surface of the opening 34H (see FIG. 14) in which the through electrode 34 is formed. The through electrode 34 penetrates the second surface 30B. The insulating layer 26 has, for example, a stacked structure of the fixed electric charge layer 26A and the dielectric layer 26B.

The fixed electric charge layer 26A may be a film having positive fixed electric charge or a film having negative fixed electric charge. It is preferable that a semiconductor material or an electrically conductive material having a wider band gap than that of the semiconductor substrate 30 be used as a material of the fixed electric charge layer 26A. This makes it possible to suppress the generation of dark currents at the interface of the semiconductor substrate 30. Examples of materials included in the fixed electric charge layer 26A include hafnium oxide ($HfO_x$), aluminum oxide ($AlO_x$), zirconium oxide ($ZrO_x$), tantalum oxide ($TaO_x$), titanium oxide ($TiO_x$), lanthanum oxide ($LaO_x$), praseodymium oxide ($PrO_x$), cerium oxide ($CeO_x$), neodymium oxide ($NdO_x$), promethium oxide ($PmO_x$), samarium oxide ($SmO_x$), europium oxide ($EuO_x$), gadolinium oxide ($GdO_x$), terbium oxide ($TbO_x$), dysprosium oxide ($DyO_x$), holmium oxide ($HoO_x$), thulium oxide ($TmO_x$), ytterbium oxide ($YbO_x$), lutetium oxide ($LuO_x$), yttrium oxide ($YO_x$), hafnium nitride ($HfN_x$), aluminum nitride ($AlN_x$), hafnium oxynitride ($HfO_xN_y$), aluminum oxynitride ($AlO_xN_y$), and the like.

The dielectric layer 26B is for preventing the reflection of light caused by a refractive index difference between the semiconductor substrate 30 and the interlayer insulating layer 27. It is preferable that a material included in the dielectric layer 26B be a material having a refractive index between the refractive index of the semiconductor substrate 30 and the refractive index of the interlayer insulating layer 27. Examples of a material included in the dielectric layer 26B include silicon oxide, TEOS, silicon nitride, silicon oxynitride (SiON), and the like.

The interlayer insulating layer 27 includes, for example, a single layer film including one of silicon oxide, silicon nitride, silicon oxynitride, or the like or a stacked film including two or more of them.

Although not illustrated in FIG. 1, there is provided a shield electrode 28 on the interlayer insulating layer 27 along with the lower electrode 21. The shield electrode 28 is for preventing capacitive coupling between the adjacent pixel units 1a. The shield electrode 28 is provided around the pixel units 1a each including the four unit pixels P that are disposed, for example, in two rows and two columns. A fixed potential is applied to the shield electrode 28. The shield electrode 28 further extends between the unit pixels P adjacent in the row direction (Z axis direction) and the column direction (X axis direction) in the pixel unit 1a.

The semiconductor substrate 30 includes, for example, an n-type silicon (Si) substrate and includes a p-well 31 in a predetermined region.

The inorganic photoelectric conversion sections 32B and 32R each include a photodiode (PD) having a pn junction in a predetermined region in the semiconductor substrate 30. The inorganic photoelectric conversion sections 32B and 32R each allow light to be dispersed in the vertical direction by using the fact that pieces of light to be absorbed have different wavelengths in accordance with the light incidence depth in the Si substrate. The inorganic photoelectric conversion section 32B selectively detects blue light to accumulate the signal charge corresponding to blue. The inorganic photoelectric conversion section 32B is installed at a depth that allows the blue light to be photoelectrically converted efficiently. The inorganic photoelectric conversion section 32R selectively detects red light to accumulate the signal charge corresponding to red. The inorganic photoelectric conversion section 32R is installed at a depth that allows the red light to be photoelectrically converted efficiently. It is to be noted that blue (B) is a color corresponding, for example, to a wavelength range of 450 nm or more and 495 nm or less and red (R) is a color corresponding, for example, to a wavelength range of 620 nm or more and 750 nm or less. It is sufficient if each of the inorganic photoelectric conversion sections 32B and 32R is configured to detect light in a portion or the whole of the wavelength range.

The inorganic photoelectric conversion section 32B includes, for example, a p+ region serving as a hole accumulation layer and an n region serving as an electron accumulation layer. The inorganic photoelectric conversion section 32R includes, for example, a p+ region serving as a hole accumulation layer and an n region serving as an electron accumulation layer (has a p-n-p stacked structure). The n region of the inorganic photoelectric conversion section 32B is coupled to the vertical transfer transistor Tr2. The p+ region of the inorganic photoelectric conversion section 32B is bent along the transfer transistor Tr2 and leads to the p+ region of the inorganic photoelectric conversion section 32R.

The gate insulating layer 33 includes, for example, a single layer film including one of silicon oxide, silicon nitride, silicon oxynitride, or the like or a stacked film including two or more of them.

The through electrode 34 is provided between the first surface 30A and the second surface 30B of the semiconductor substrate 30. The through electrode 34 has a function of a connector for the organic photoelectric conversion section 20 and the gate Gamp of the amplifier transistor AMP and the floating diffusion FD1 and serves as a transmission path for the electric charge generated by the organic photoelectric conversion section 20. A reset gate Grst of the reset transistor RST is disposed next to the floating diffusion FD1 (the one source/drain region 36B of the reset transistor RST). This allows the reset transistor RST to reset the electric charge accumulated in the floating diffusion FD1.

It is possible to form the pad sections 39A and 39B, the upper first contact 39C, an upper second contact 39D, the lower first contact 45, the lower second contact 46, and the wiring line 52 by using, for example, doped silicon materials such as PDAS (Phosphorus Doped Amorphous Silicon) or metal materials including aluminum (Al), tungsten (W), titanium (Ti), cobalt (Co), hafnium (Hf), tantalum (Ta), and the like.

The protective layer 51 and the on-chip lens 54 each include a material having light transmissivity. The protective layer 51 and the on-chip lens 54 each include, for example, a single layer film including any of silicon oxide, silicon nitride, silicon oxynitride, or the like or a stacked film including two or more of them. This protective layer 51 has, for example, a thickness of 100 nm or more and 30000 nm or less.

The light shielding film 53 is provided, for example, in the protective layer 51 along with the wiring line 52 not to overlap with at least the accumulation electrode 21B, but to cover the region of the readout electrode 21A in direct contact with the semiconductor layer 23. It is possible to form the light shielding film 53 by using, for example, tungsten (W), aluminum (Al), an alloy of Al and copper (Cu), and the like.

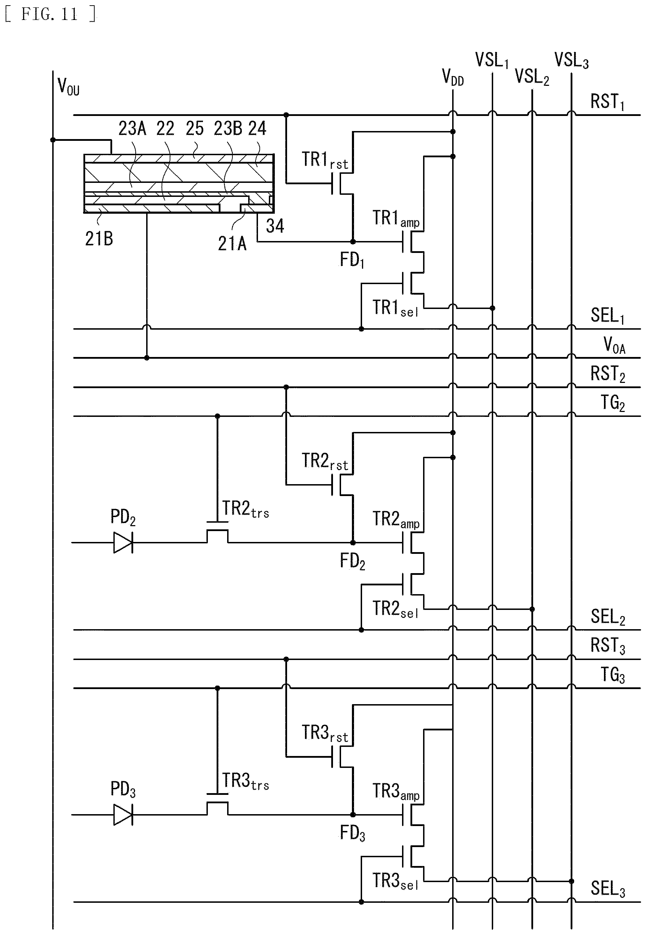

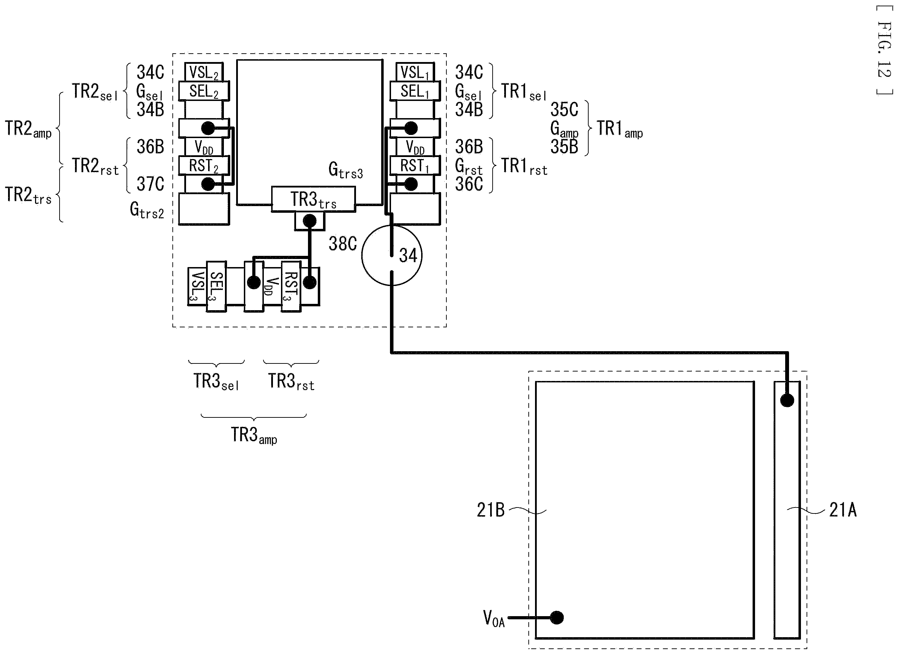

FIG. 11 is an equivalent circuit diagram of the imaging element 10 illustrated in FIG. 1. FIG. 12 schematically illustrates disposition of the lower electrode 21 and a transistor included in a controller in the imaging element 10 illustrated in FIG. 1.

The reset transistor RST (reset transistor TR1rst) is for resetting the electric charge transferred from the organic photoelectric conversion section 20 to the floating diffusion FD1 and includes, for example, a MOS transistor. Specifically, the reset transistor TR1rst includes the reset gate Grst, a channel formation region 36A, and the source/drain regions 36B and 36C. The reset gate Grst is coupled to a reset line RST1. The one source/drain region 36B of the reset transistor TR1rst also serves as the floating diffusion FD1. The other source/drain region 36C included in the reset transistor TR1rst is coupled to a power supply line VDD.

The amplifier transistor AMP is a modulation element that modulates, to a voltage, the amount of electric charge generated by the organic photoelectric conversion section 20 and includes, for example, a MOS transistor. Specifically, the amplifier transistor AMP includes the gate Gamp, a channel formation region 35A, and the source/drain regions 35B and 35C. The gate Gamp is coupled to the readout electrode 21A and the one source/drain region 36B (floating diffusion FD1) of the reset transistor TR1rst through the lower first contact 45, the coupling section 41A, the lower second contact 46, the through electrode 34, and the like. In addition, the one source/drain region 35B shares a region with the other source/drain region 36C included in the reset transistor TR1rst and is coupled to the power supply line VDD.

The selection transistor SEL (selection transistor TR1sel) includes a gate Gsel, a channel formation region 34A, and source/drain regions 34B and 34C. The gate Gsel is coupled to a selection line SEL1. The one source/drain region 34B shares a region with the other source/drain region 35C included in the amplifier transistor AMP and the other source/drain region 34C is coupled to a signal line (data output line) VSL1.

The transfer transistor TR2 (transfer transistor TR2trs) is for transferring, to the floating diffusion FD2, the signal charge corresponding to blue that has been generated and accumulated in the inorganic photoelectric conversion section 32B. The inorganic photoelectric conversion section 32B is formed at a deep position from the second surface 30B of the semiconductor substrate 30 and it is thus preferable that the transfer transistor TR2trs of the inorganic photoelectric conversion section 32B include a vertical transistor. The transfer transistor TR2trs is coupled to a transfer gate line TG2. The floating diffusion FD2 is provided in the region 37C near a gate Gtrs2 of the transfer transistor TR2trs. The electric charge accumulated in the inorganic photoelectric conversion section 32B is read out to the floating diffusion FD2 through a transfer channel formed along the gate Gtrs2.

The transfer transistor TR3 (transfer transistor TR3trs) is for transferring, to the floating diffusion FD3, the signal charge corresponding to red that has been generated and accumulated in the inorganic photoelectric conversion section 32R. The transfer transistor TR3 (transfer transistor TR3trs) includes, for example, a MOS transistor. The transfer transistor TR3trs is coupled to a transfer gate line TG3. The floating diffusion FD3 is provided in the region 38C near a gate Gtrs3 of the transfer transistor TR3trs. The electric charge accumulated in the inorganic photoelectric conversion section 32R is read out to the floating diffusion FD3 through a transfer channel formed along the gate Gtrs3.

The second surface 30B side of the semiconductor substrate 30 is further provided with a reset transistor TR2rst, an amplifier transistor TR2amp, and a selection transistor TR2sel included in the controller of the inorganic photoelectric conversion section 32B. Further, there are provided a reset transistor TR3rst, an amplifier transistor TR3amp, and a selection transistor TR3sel included in the controller of the inorganic photoelectric conversion section 32R.

The reset transistor TR2rst includes a gate, a channel formation region, and source/drain regions. The gate of the reset transistor TR2rst is coupled to a reset line RST2 and the one source/drain region of the reset transistor TR2rst is coupled to the power supply line VDD. The other source/drain region of the reset transistor TR2rst also serves as the floating diffusion FD2.

The amplifier transistor TR2amp includes a gate, a channel formation region, and source/drain regions. The gate is coupled to the other source/drain region (floating diffusion FD2) of the reset transistor TR2rst. The one source/drain region included in the amplifier transistor TR2amp shares a region with the one source/drain region included in the reset transistor TR2rst and is coupled to the power supply line VDD.

The selection transistor TR2sel includes a gate, a channel formation region, and source/drain regions. The gate is coupled to a selection line SEL2. The one source/drain region included in the selection transistor TR2sel shares a region with the other source/drain region included in the amplifier transistor TR2amp. The other source/drain region included in the selection transistor TR2sel is coupled to a signal line (data output line) VSL2.

The reset transistor TR3rst includes a gate, a channel formation region, and source/drain regions. The gate of the reset transistor TR3rst is coupled to a reset line RST3 and the one source/drain region included in the reset transistor TR3rst is coupled to the power supply line VDD. The other source/drain region included in the reset transistor TR3rst also serves as the floating diffusion FD3.

The amplifier transistor TR3amp includes a gate, a channel formation region, and source/drain regions. The gate is coupled to the other source/drain region (floating diffusion FD3) included in the reset transistor TR3rst. The one source/drain region included in the amplifier transistor TR3amp shares a region with the one source/drain region included in the reset transistor TR3rst and is coupled to the power supply line VDD.

The selection transistor TR3sel includes a gate, a channel formation region, and source/drain regions. The gate is coupled to a selection line SEL3. The one source/drain region included in the selection transistor TR3sel shares a region with the other source/drain region included in the amplifier transistor TR3amp. The other source/drain region included in the selection transistor TR3sel is coupled to a signal line (data output line) VSL3.

The reset lines RST1, RST2, and RST3, the selection lines SEL1, SEL2, and SEL3, and the transfer gate lines TG2 and TG3 are each coupled to a vertical drive circuit included in a drive circuit. The signal lines (data output lines) VSL1, VSL2, and VSL3 are coupled to a column signal processing circuit 113 included in the drive circuit.

(1-2. Method of Manufacturing Imaging Element)

It is possible to manufacture the imaging element 10 according to the present embodiment, for example, as follows.

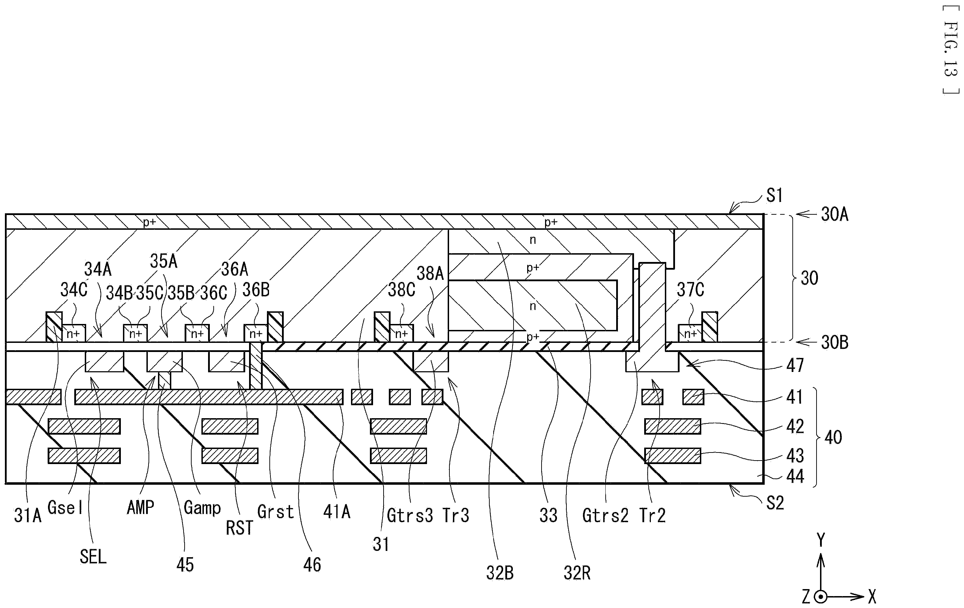

FIGs. 13 to 18 illustrate a method of manufacturing the imaging element 10 in the order of steps. First, as illustrated in FIG. 13, for example, the p-well 31 is formed in the semiconductor substrate 30. For example, the n-type inorganic photoelectric conversion sections 32B and 32R are formed in this p-well 31. A p+ region is formed near the first surface 30A of the semiconductor substrate 30.

As also illustrated in FIG. 13, for example, n+ regions that serve as the floating diffusions FD1 to FD3 are formed on the second surface 30B of the semiconductor substrate 30 and a gate insulating layer 33 and a gate wiring layer 47 are then formed. The gate wiring layer 47 includes the respective gates of the transfer transistor Tr2, the transfer transistor Tr3, the selection transistor SEL, the amplifier transistor AMP, and the reset transistor RST. This forms the transfer transistor Tr2, the transfer transistor Tr3, the selection transistor SEL, the amplifier transistor AMP, and the reset transistor RST. Further, the multilayer wiring layer 40 is formed on the second surface 30B of the semiconductor substrate 30. The multilayer wiring layer 40 includes the wiring layers 41 to 43 and the insulating layer 44. The wiring layers 41 to 43 include the lower first contact 45, the lower second contact 46, and the coupling section 41A.

As the base of the semiconductor substrate 30, for example, an SOI (Silicon on Insulator) substrate is used in which the semiconductor substrate 30, a buried oxide film (not illustrated), and a holding substrate (not illustrated) are stacked. Although not illustrated in FIG. 13, the buried oxide film and the holding substrate are joined to the first surface 30A of the semiconductor substrate 30. After ion implantation, annealing treatment is performed.

Next, a support substrate (not illustrated), another semiconductor base, or the like is joined onto the multilayer wiring layer 40 provided on the second surface 30B side of the semiconductor substrate 30 and flipped vertically. Subsequently, the semiconductor substrate 30 is separated from the buried oxide film and the holding substrate of the SOI substrate to expose the first surface 30A of the semiconductor substrate 30. It is possible to perform the steps described above with technology used in a normal CMOS process including ion implantation, a CVD (Chemical Vapor Deposition) method, and the like.

Next, as illustrated in FIG. 14, the semiconductor substrate 30 is processed from the first surface 30A side, for example, by dry etching to form, for example, an annular opening 34H. The depth of the opening 34H extends from the first surface 30A to the second surface 30B of the semiconductor substrate 30 and reaches, for example, the coupling section 41A as illustrated in FIG. 14.

Subsequently, for example, the negative fixed electric charge layer 26A and the dielectric layer 26B are formed in order on the first surface 30A of the semiconductor substrate 30 and the side surfaces of the opening 34H. It is possible to form the fixed electric charge layer 26A by forming a hafnium oxide film or an aluminum oxide film, for example, with an atomic layer deposition method (ALD method). It is possible to form the dielectric layer 26B by forming a silicon oxide film, for example, with a plasma CVD method. Next, the pad sections 39A and 39B are formed at predetermined positions on the dielectric layer 26B. In each of the pad sections 39A and 39B, a barrier metal including, for example, a stacked film (Ti/TiN film) of titanium and titanium nitride and a tungsten film are stacked. This makes it possible to use the pad sections 39A and 39B as light shielding films. After that, the interlayer insulating layer 27 is formed on the dielectric layer 26B and the pad sections 39A and 39B and the surface of the interlayer insulating layer 27 is planarized by using a CMP (Chemical Mechanical Polishing) method.

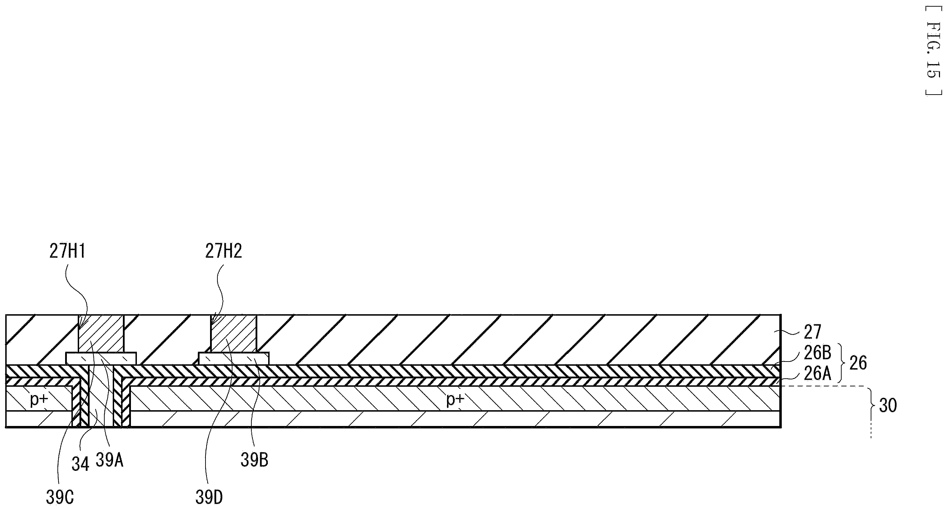

Subsequently, as illustrated in FIG. 15, openings 27H1 and 27H2 are respectively formed above the pad sections 39A and 39B. After that, these openings 27H1 and 27H2 are filled, for example, with electrically conductive materials such as Al to form the upper first contact 39C and the upper second contact 39D.

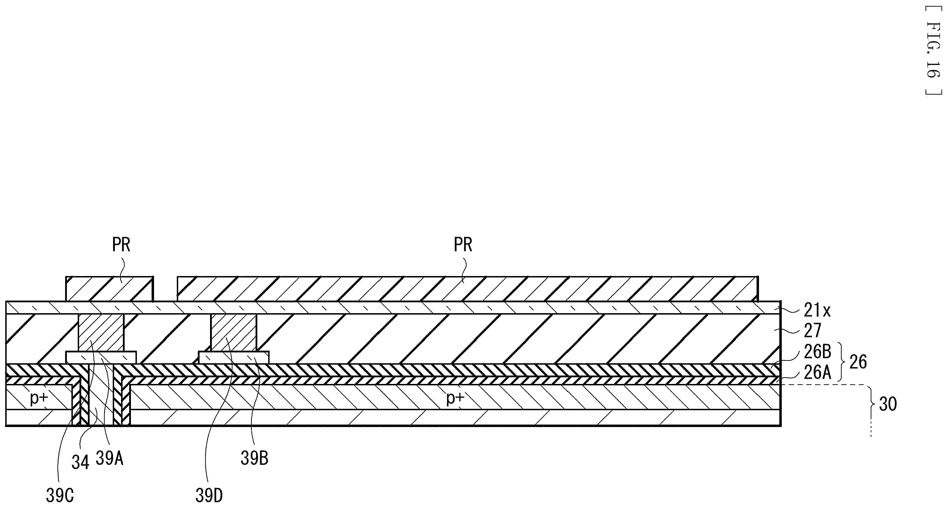

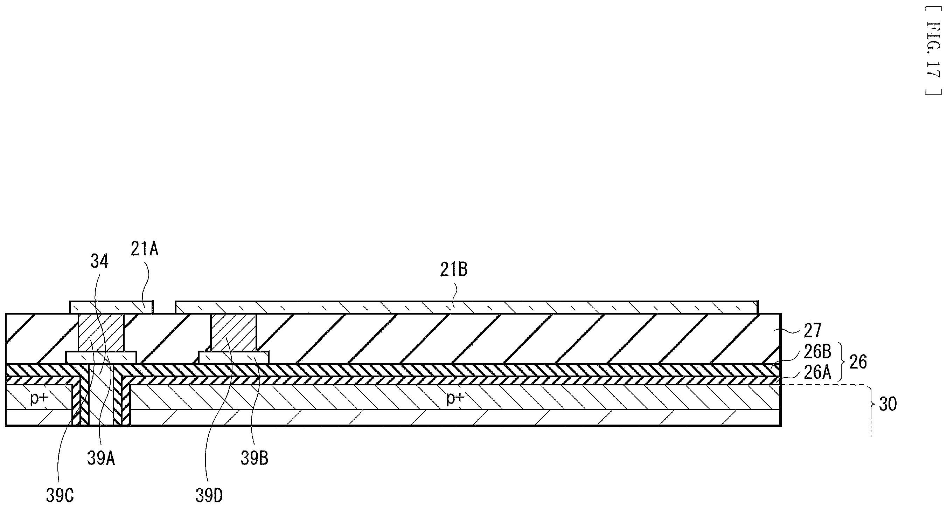

Next, as illustrated in FIG. 16, the electrically conducive film 21x is formed on the interlayer insulating layer 27 by using, for example, a sputtering method and patterning is then performed by using photolithography technology. Specifically, the photoresist PR is formed at a predetermined position in the electrically conducive film 21x and the electrically conducive film 21x is then processed by using dry etching or wet etching. After that, the readout electrode 21A and the accumulation electrode 21B are formed as illustrated in FIG. 17 by removing the photoresist PR.

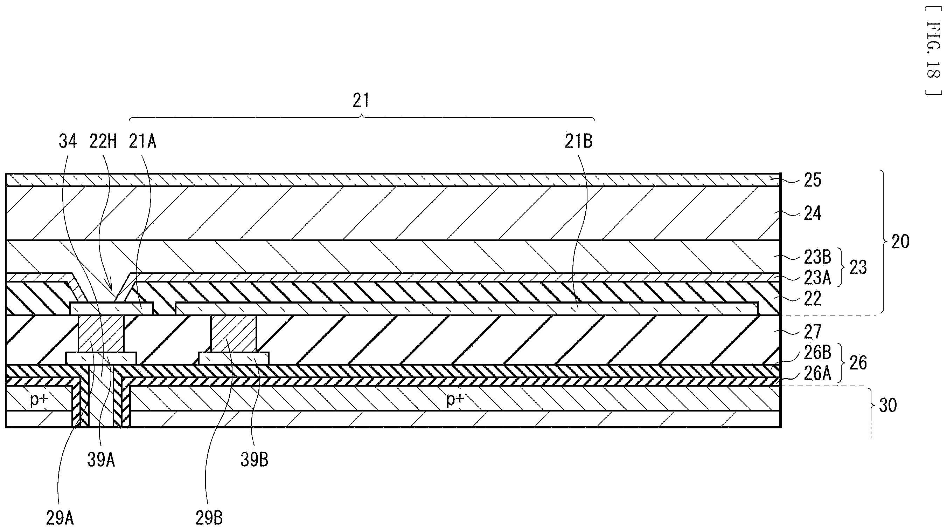

Subsequently, as illustrated in FIG. 18, the insulating layer 22, the semiconductor layer 23 including the first semiconductor layer 23A and the second semiconductor layer 23B, the photoelectric conversion layer 24, and the upper electrode 25 are formed. For example, a silicon oxide film is formed for the insulating layer 22 by using, for example, an ALD method. After that, the surface of the insulating layer 22 is planarized by using a CMP method. After that, the opening 22H is formed on the readout electrode 21Aby using, for example, wet etching. It is possible to form the semiconductor layer 23 by using, for example, a sputtering method. The photoelectric conversion layer 24 is formed by using, for example, a vacuum evaporation method. The upper electrode 25 is formed by using, for example, a sputtering method as with the lower electrode 21. Finally, the protective layer 51, the wiring line 52, the light shielding film 53, and the on-chip lens 54 are provided on the upper electrode 25. Thus, the imaging element 10 illustrated in FIG. 1 is completed.

It is to be noted that, in a case where other layers each including an organic material such as buffer layers also serving as electron blocking films, buffer layers also serving as hole blocking films, or work function adjustment layers are formed between the semiconductor layer 23 and the photoelectric conversion layer 24 and between the photoelectric conversion layer 24 and the upper electrode 25 as described above, it is preferable to form the respective layers continuously (in an in-situ vacuum process) in a vacuum step. In addition, the method of forming the photoelectric conversion layer 24 is not necessarily limited to a technique that uses a vacuum evaporation method. For example, spin coating technology, printing technology, or the like may be used. Further, a method of forming transparent electrodes (the lower electrode 21 and the upper electrode 25) includes, depending on materials included in the transparent electrodes, a physical vapor deposition method (PVD method) such as a vacuum evaporation method, a reactive evaporation method, an electron beam evaporation method, or an ion plating method, a pyrosol method, a method of pyrolyzing an organic metal compound, a spraying method, a dip method, a variety of chemical vapor deposition (CVD) methods including a MOCVD method, an electroless plating method, and an electroplating method.

(1-3. Signal Acquisition Operation of Imaging Element)

In a case where light enters the organic photoelectric conversion section 20 through the on-chip lens 54 in the imaging element 10, the light passes through the organic photoelectric conversion section 20 and the inorganic photoelectric conversion sections 32B and 32R in this order. While the light passes through the organic photoelectric conversion section 20 and the inorganic photoelectric conversion sections 32B and 32R, the light is photoelectrically converted for each of green light, blue light, and red light. The following describes operations of acquiring signals of the respective colors.

(Acquisition of Blue Color Signal by Organic Photoelectric Conversion Section 20)

First, the green light of the pieces of light having entered the imaging element 10 is selectively detected (absorbed) and photoelectrically converted by the organic photoelectric conversion section 20.

The organic photoelectric conversion section 20 is coupled to the gate Gamp of the amplifier transistor AMP and the floating diffusion FD1 through the through electrode 34. Thus, the electron of an exciton generated by the organic photoelectric conversion section 20 is taken out from the lower electrode 21 side, transferred to the second surface 30S2 side of the semiconductor substrate 30 through the through electrode 34, and accumulated in the floating diffusion FD1. At the same time as this, the amplifier transistor AMP modulates the amount of electric charge generated by the organic photoelectric conversion section 20 to a voltage.

In addition, the reset gate Grst of the reset transistor RST is disposed next to the floating diffusion FD1. This causes the reset transistor RST to reset the electric charge accumulated in the floating diffusion FD1.

The organic photoelectric conversion section 20 is coupled to not only the amplifier transistor AMP, but also the floating diffusion FD1 through the through electrode 34, allowing the reset transistor RST to easily reset the electric charge accumulated in the floating diffusion FD1.

In contrast, in a case where the through electrode 34 and the floating diffusion FD1 are not coupled, it is difficult to reset the electric charge accumulated in the floating diffusion FD1. A large voltage has to be applied to pull out the electric charge to the upper electrode 25 side. The photoelectric conversion layer 24 may be therefore damaged. In addition, a structure that allows for resetting in a short period of time leads to increased dark-time noise and results in a trade-off. This structure is thus difficult.

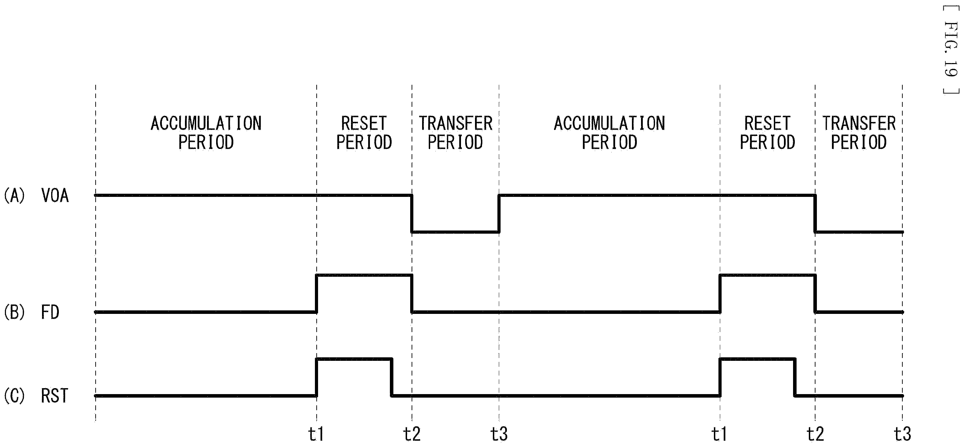

FIG. 19 illustrates an operation example of the imaging element 10. (A) illustrates the potential at the accumulation electrode 21B, (B) illustrates the potential at the floating diffusion FD1 (readout electrode 21A), and (C) illustrates the potential at the gate (Gsel) of the reset transistor TR1rst. In the imaging element 10, voltages are individually applied to the readout electrode 21A and the accumulation electrode 21B.

In the imaging element 10, the drive circuit applies a potential V1 to the readout electrode 21A and applies a potential V2 to the accumulation electrode 21B in an accumulation period. Here, it is assumed that the potentials V1 and V2 satisfy V2 > V1. This causes electric charge (signal charge; electrons) generated through photoelectric conversion to be drawn to the accumulation electrode 21B and accumulated in the region of the semiconductor layer 23 opposed to the accumulation electrode 21B (accumulation period). Additionally, the value of the potential in the region of the semiconductor layer 23 opposed to the accumulation electrode 21B becomes more negative with the passage of time of photoelectric conversion. It is to be noted that holes are sent from the upper electrode 25 to the drive circuit.

In the imaging element 10, a reset operation is performed in the latter half of the accumulation period. Specifically, at a timing t1, a scanning section changes the voltage of a reset signal RST from the low level to the high level. This turns on the reset transistor TR1rst in the unit pixel P. As a result, the voltage of the floating diffusion FD1 is set to the power supply voltage and the voltage of the floating diffusion FD1 is reset (reset period).

After the reset operation is completed, the electric charge is read out. Specifically, the drive circuit applies a potential V3 to the readout electrode 21A and applies a potential V4 to the accumulation electrode 21B at a timing t2. Here, it is assumed that the potentials V3 and V4 satisfy V3 < V4. This causes the electric charge accumulated in the region corresponding to the accumulation electrode 21B to be read out from the readout electrode 21A to the floating diffusion FD1. In other words, the electric charge accumulated in the semiconductor layer 23 is read out to the controller (transfer period).

The drive circuit applies a potential V1 to the readout electrode 21A and applies the potential V2 to the accumulation electrode 21B again after the readout operation is completed. This causes electric charge generated through photoelectric conversion to be drawn to the accumulation electrode 21B and accumulated in the region of the photoelectric conversion layer 24 opposed to the accumulation electrode 21B (accumulation period).

(Acquisition of Blue Color Signal and Red Color Signal by Inorganic Photoelectric Conversion Sections 32B and 32R)

Subsequently, the blue light and the red light of the pieces of light having passed through the organic photoelectric conversion section 20 are respectively absorbed and photoelectrically converted in order by the inorganic photoelectric conversion section 32B and the inorganic photoelectric conversion section 32R. In the inorganic photoelectric conversion section 32B, the electrons corresponding to the incident blue light are accumulated in an n region of the inorganic photoelectric conversion section 32B and the accumulated electrons are transferred to the floating diffusion FD2 by the transfer transistor Tr2. Similarly, in the inorganic photoelectric conversion section 32R, the electrons corresponding to the incident red light are accumulated in an n region of the inorganic photoelectric conversion section 32R and the accumulated electrons are transferred to the floating diffusion FD3 by the transfer transistor Tr3.

(1-4. Workings and Effects)

The imaging element 10 according to the present embodiment is provided with the semiconductor layer 23 between the lower electrode 21 including the readout electrode 21A and the accumulation electrode 21B and the photoelectric conversion layer 24 in the organic photoelectric conversion section 20. In the semiconductor layer 23, the first semiconductor layer 23A and the second semiconductor layer 23B are stacked in this order from the lower electrode 21 side. The first semiconductor layer 23A has a larger value for C5s than the value of the second semiconductor layer 23B for C5s. The second semiconductor layer 23B has a larger value for $E_{VO}$ or $E_{VN}$ than the value of the first semiconductor layer 23A for $E_{VO}$ or $E_{VN}$. This improves the characteristics of transporting the electric charge accumulated in the semiconductor layer 23 above the accumulation electrode 21B in the in-plane direction. In addition, the elimination of oxygen or nitrogen from the first semiconductor layer 23A is reduced and at the occurrence of traps at the interface between the semiconductor layer 23 and the photoelectric conversion layer 24 is reduced. The following describes this.

In recent years, a stacked imaging element in which a plurality of photoelectric conversion sections is stacked in the vertical direction has been developed as an imaging element included in a CCD image sensor, a CMOS image sensor, or the like. The stacked imaging element has a configuration in which two inorganic photoelectric conversion sections each including a photodiode (PD) are stacked, for example, in a silicon (Si) substrate and an organic photoelectric conversion section including a photoelectric conversion layer including an organic material is provided above the Si substrate.

The stacked imaging element is requested to have a structure that accumulates and transfers the signal charge generated by each of the photoelectric conversion sections. For example, among paired electrodes disposed to be opposed to each other with the photoelectric conversion layer interposed in between, the electrode on the inorganic photoelectric conversion section side includes the two electrodes of a first electrode and an electrode for electric charge accumulation in the organic photoelectric conversion section. This makes it possible to accumulate the signal charge generated by the photoelectric conversion layer. Such an imaging element temporarily accumulates signal charge above the electrode for electric charge accumulation and then transfers the signal charge to the floating diffusion FD in the Si substrate. This makes it possible to fully deplete the electric charge accumulation section and erase electric charge at the start of exposure. As a result, it is possible to suppress the occurrence of a phenomenon such as an increase in kTC noise, the deterioration of random noise, a decrease in image quality in imaging.

In addition, an imaging element provided with a composite oxide layer including indium-gallium-zinc composite oxide (IGZO) between the first electrode including an electrode for electric charge accumulation and the photoelectric conversion layer as described above to achieve an improvement in photoresponsivity is disclosed as an imaging element including a plurality of electrodes on the inorganic photoelectric conversion section side as described above. In such an imaging element, a trap included in the interface between the insulating film covering the electrode for electric charge accumulation and the composite oxide layer facilitates electrons to be eliminated. This serves as transfer noise and causes the deterioration of the afterimage characteristics.

In contrast, in the present embodiment, the semiconductor layer 23 is provided between the lower electrode 21 including the readout electrode 21A and the accumulation electrode 21B and the photoelectric conversion layer 24. In the semiconductor layer 23, the first semiconductor layer 23A and the second semiconductor layer 23B are stacked in this order from the lower electrode 21 side. This first semiconductor layer 23A has a larger value for C5s than the value of the second semiconductor layer 23B for C5s. This improves the characteristics of transporting the electric charge accumulated in the semiconductor layer 23 above the accumulation electrode 21B in the in-plane direction. In addition, the second semiconductor layer 23B has a larger value for $E_{VO}$ or $E_{VN}$ than the value of the first semiconductor layer 23A for $E_{VO}$ or $E_{VN}$. This reduces the elimination of oxygen or nitrogen from the surface of the first semiconductor layer 23A and reduces the occurrence of traps at the interface between the semiconductor layer 23 and the photoelectric conversion layer 24.

Table 2 tabulates $E_{VO}$ and C5s of the first semiconductor layer 23A and the second semiconductor layer 23B and S values and mobilities of carrier (electrons) in an experimental example 1 to an experimental example 12 in a case where the first semiconductor layer 23A is formed by using any of ITO, ITZO, or IZO and the second semiconductor layer 23B is formed by using any of ZTO, IGZO, IGZTO, ITZO, or ITO.

The respective samples (the experimental example 1 to the experimental example 12) for evaluation were each fabricated by forming a thermal oxide film having a thickness of 150 nm on a silicon substrate serving as a gate electrode, further forming the first semiconductor layer 23A having a thickness of 5 nm and the second semiconductor layer having a thickness of 30 nm in order, and then forming a source electrode and a drain electrode. The S value and the mobility were each calculated from an $I_D$-$V_{GS}$ curve obtained from the TFT evaluation. A smaller S value and a higher mobility lead to an afterimage reduction in imaging. Therefore, it can be said that a smaller S value and a higher mobility are suitable as an electrode according to the present embodiment.

[Table 2]

| | first semiconductor layer | | | second semiconductor layer | | | evaluation result | |
|---|---|---|---|---|---|---|---|---|
| | system | $E_{vo}$, | C5s | material system | $E_{vo}$ | C5s | S value [V/dec] | mobility [cm$^2$/Vs] |
| experimental example 1 | In-Sn-0 | 2. 0 | 1. 0 | Zn-Sn-0 | 2. 9 | 0. 3 | 0. 09 | 48 |
| experimental example 2 | In-Sn-0 | 1. 9 | 1. 0 | Zn-Sn-0 | 2. 9 | 0. 3 | 0. 22 | 27 |
| experimental example 3 | In-Sn-0 | 1. 9 | 1. 0 | Zn-Sn-0 | 2. 9 | 0. 3 | 0. 14 | 26 |
| experimental example 4 | In-Sn-Zn-0 | 2. 2 | 0. 9 | Zn-Sn-0 | 2. 9 | 0. 3 | 0. 17 | 13 |
| experimental example 5 | In-Zn-0 | 2. 7 | 0. 6 | Zn-Si-0 | 2. 9 | 0. 3 | 0. 19 | 12 |
| experimental example 6 | In-Zn-0 | 2. 6 | 0. 7 | Zn-Sn-0 | 2. 9 | 0. 3 | 0. 17 | 22. 2 |

(continued)

| | | first semiconductor layer | | | second semiconductor layer | | | evaluation result | |
|---|---|---|---|---|---|---|---|---|---|
| | | system | $E_{vo}$, | C5s | material system | $E_{vo}$ | C5s | S value [V/dec] | mobility [cm$^2$/Vs] |
| | experimental example 7 | In-Sn-0 | 2. 0 | 1. 0 | In-Ga-Zn-0 | 3. 0 | 0. 5 | 0. 09 | 43 |
| | experimental example 8 | In-Sn-0 | 2. 0 | 1. 0 | In-Ga-Zn-Sn-0 | 2. 9 | 0. 5 | 0. 09 | 34 |
| | experimental example 9 | In-Sn-0 | 2. 0 | 1. 0 | In-Sn-Zn-0 | 2. 4 | 0. 8 | 2. 58 | 6 |
| | experimental example 10 | In-Sn-0 | 2. 0 | 1.0 | In-Sn-Zn-0 | 2. 8 | 0. 6 | 0. 69 | 7.8 |
| | experimental example 11 | In-Sn-0 | 2. 0 | 1.0 | In-Sn-Zn-0 | 2. 1 | 0. 9 | no switching | |
| | experimental example 12 | In-Sn-0 | 2. 0 | 1.0 | In-Sn-0 | 1. 8 | 1. 0 | no switching | |

In the experimental example 1 to the experimental example 10 in each of which the first semiconductor layer 23A has a larger value for C5s than the value of the second semiconductor layer 23B for C5s and the second semiconductor layer 23B has a larger value for $E_{VO}$ than the value of the first semiconductor layer 23A for $E_{VO}$, a device operation was confirmable. However, the experimental example 11 having a similar magnitude relationship had no switching. This indicates that the second semiconductor layer 23B preferably has a value of more than 2.1 eV for $E_{VO}$. A value of 2.4 eV or more secures a device operation. A value of 2.8 eV or more secures a favorable operation. It has been found that the value of the first semiconductor layer 23A for C5s larger than or equal to 0.6 (60) % or more offers a sufficient mobility.

As described above, the imaging element 10 according to the present embodiment is provided with the semiconductor layer 23 in which the first semiconductor layer 23A and the second semiconductor layer 23B are stacked in this order from the lower electrode 21 side. The first semiconductor layer 23A has a larger value for C5s than the value of the second semiconductor layer 23B for C5s. The second semiconductor layer 23B has a larger value for $E_{VO}$ or $E_{VN}$ than the value of the first semiconductor layer 23A for $E_{VO}$ or $E_{VN}$. This decreases traps included in the interface with the insulating layer 22 and improves the characteristics of transporting the electric charge accumulated in the semiconductor layer 23 above the accumulation electrode 21B in the in-plane direction. In addition, the elimination of oxygen or nitrogen from the first semiconductor layer 23A is reduced and at the occurrence of traps at the interface between the semiconductor layer 23 and the photoelectric conversion layer 24 is reduced. This makes it possible to improve the afterimage characteristics.

In addition, in a case where the first semiconductor layer 23A by using, for example, $In_2O_3$ (ITO), some film formation methods lead to crystallization. In a case where the first semiconductor layer 23A is formed as a crystal layer of $In_2O_3$ (ITO), a defect level may occur on a grain boundary or at the interface with the insulating layer 22 and the electric characteristics may decrease. In contrast, in the imaging element 10 according to the present embodiment, the first semiconductor layer 23A is formed as an amorphous layer. This makes it possible to prevent the carrier density of the first semiconductor layer 23A from increasing and achieve a low carrier concentration. In addition, it is possible to suppress the occurrence of dangling bonds on a grain boundary in the first semiconductor layer 23A or at the interface with the insulating layer 22 and further reduce traps as compared with a case where the first semiconductor layer 23A is formed as a crystal layer. This makes it possible to further improve the afterimage characteristics.

Further, in the imaging element 10 according to the present embodiment, the ratio (t2/t1) of the thickness (t2) of the second semiconductor layer 23B to the thickness (t1) of the first semiconductor layer 23A is 4 or more and 8 or less. This allows the second semiconductor layer 23B to sufficiently absorb the carriers generated from the first semiconductor layer 23A. In addition, the first semiconductor layer 23A is formed as an amorphous layer. This makes it possible to achieve a low carrier concentration while preventing the carrier density of the semiconductor layer 23 from increasing. This makes it possible to further improve the afterimage characteristics.

Next, a second embodiment and modification examples (modification examples 1 to 8) of the present disclosure are described. The following assigns the same signs to components similar to those of the first embodiment described above and omits descriptions thereof as appropriate.

<2. Modification Examples>

(2-1. Modification Example 1)

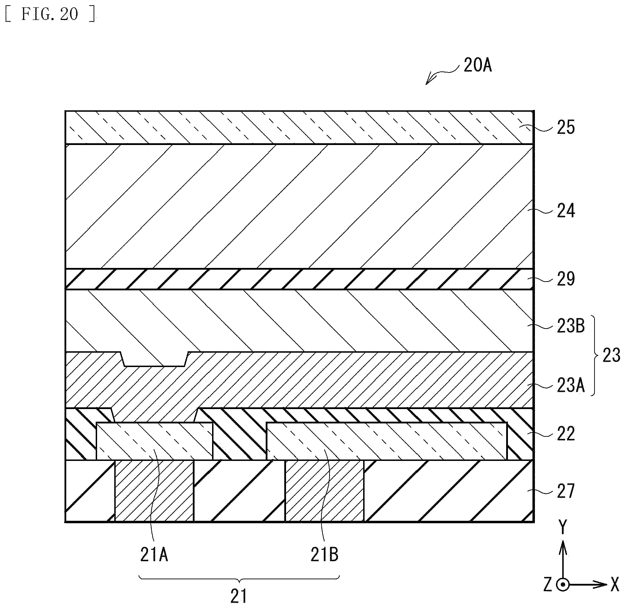

FIG. 20 schematically illustrates a cross-sectional configuration of the main portion (organic photoelectric conversion section 20A) of an imaging element according to the modification example 1 of the present disclosure. The organic photoelectric conversion section 20A according to the present modification example is different from that of the embodiment described above in that there is provided a protective layer 29 between the semiconductor layer 23 and the photoelectric conversion layer 24.

The protective layer 29 is for preventing oxygen from being eliminated from an oxide semiconductor material included in the semiconductor layer 23. Examples of materials included in the protective layer 29 include titanium oxide ($TiO_2$), titanium silicide oxide (TiSiO), niobium oxide ($Nb_2O_5$), $TaO_x$, and the like. It is effective in a case where the protective layer 29 has, for example, one atomic layer as the thickness thereof. It is preferable that the protective layer 29 have, for example, a thickness of 0.5 nm or more and 10 nm or less.

In this way, in the present modification example, the protective layer 29 is provided between the semiconductor layer 23 and the photoelectric conversion layer 24. This makes it possible to further reduce the elimination of oxygen or nitrogen from the surface of the semiconductor layer 23. This further reduces the occurrence of traps at the interface between the semiconductor layer 23 (specifically, the second semiconductor layer 23B) and the photoelectric conversion layer 24. In addition, it is possible to prevent signal charge (electrons) from flowing back to the photoelectric conversion layer 24 from the semiconductor layer 23 side. This makes it possible to further increase the afterimage characteristics and the reliability.

(2-2. Modification Example 2)

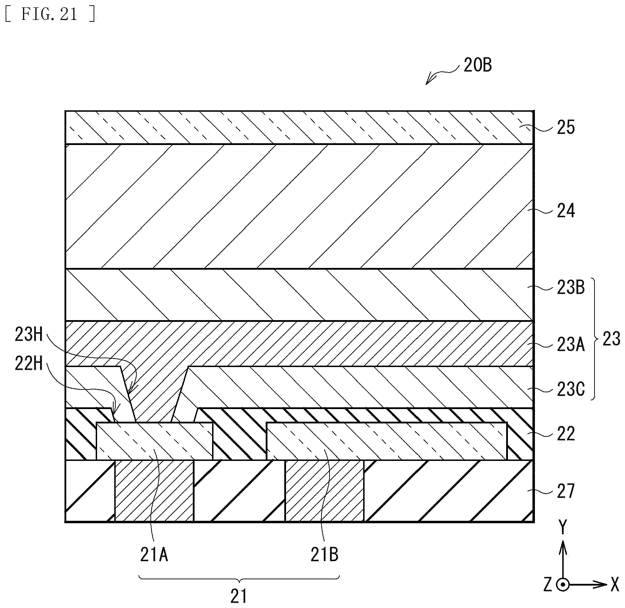

FIG. 21 schematically illustrates an example of a cross-sectional configuration of the main portion (organic photoelectric conversion section 20B) of an imaging element according to the modification example 2 of the present disclosure. The organic photoelectric conversion section 20B according to the present modification example is further provided with a third semiconductor layer 23C between the insulating layer 22 and the first semiconductor layer 23A. The insulating layer 22 is formed on the lower electrode 21. In other words, the organic photoelectric conversion section 20B according to the present modification example is different from that of the first embodiment described above in that the semiconductor layer 23 between the lower electrode 21 and the photoelectric conversion layer 24 has a three-layer structure in which the third semiconductor layer 23C, the first semiconductor layer 23A, and the second semiconductor layer 23B are stacked in this order from the lower electrode 21 side.

The third semiconductor layer 23C is for preventing the electric charge accumulated in the semiconductor layer 23 from being trapped near the interface with the insulating layer 22 because of a trap level caused by a dangling bond formed near the surface of the insulating layer 22. The third semiconductor layer 23C has an opening 23H in the opening 22H of the insulating layer 22. The readout electrode 21A and the first semiconductor layer 23A are electrically coupled through the openings 22H and 23H. It is preferable that the third semiconductor layer 23C have the conduction band minimum (CBM) that is shallower than the CBM of the first semiconductor layer 23A. This makes it possible to prevent electrons from being accumulated near the interface between the insulating layer 22 and the third semiconductor layer 23C. It is possible to use, for example, ZTO, IGZO, or the like as a material included in the third semiconductor layer 23C. It is possible to form the third semiconductor layer 23C by using, for example, a sputtering method as with the first semiconductor layer 23A and the second semiconductor layer 23B. In addition, for example, an ALD method may be used for formation.

In this way, in the present modification example, the third semiconductor layer 23C is provided between the lower electrode 21 and the first semiconductor layer 23A. This makes it possible to prevent electrons from being trapped near the interface with the insulating layer 22 because of the accumulation of electrons near the interface with the insulating layer 22 in addition to the effects of the first embodiment described above. In other words, an effect is attained of making it possible to prevent the deterioration of the afterimage characteristics.

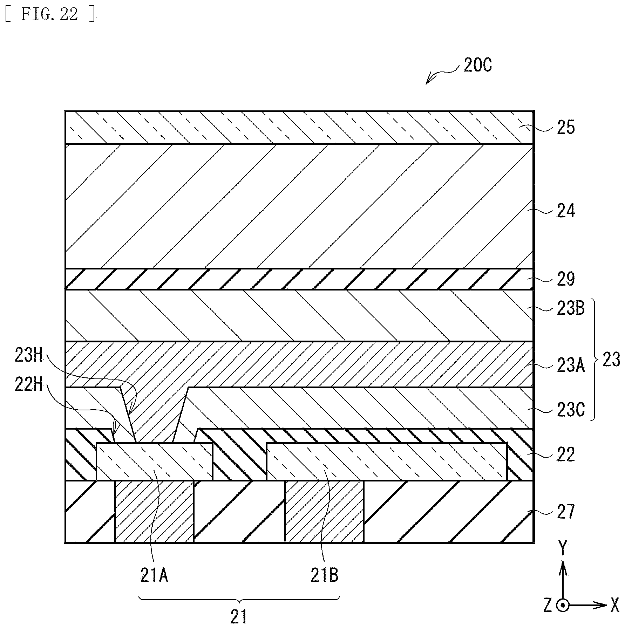

It is to be noted that the configuration of the present modification example may be combined with that of the modification example 1 described above. For example, as in an organic photoelectric conversion section 20C illustrated in FIG. 22, the semiconductor layer 23 may have a three-layer structure in which the third semiconductor layer 23C, the first semiconductor layer 23A, and the second semiconductor layer 23B are stacked in this order and may be further provided with the protective layer 29 on the second semiconductor layer 23B. This makes it possible to further increase the image quality in imaging and the reliability.

(2-3. Modification Example 3)

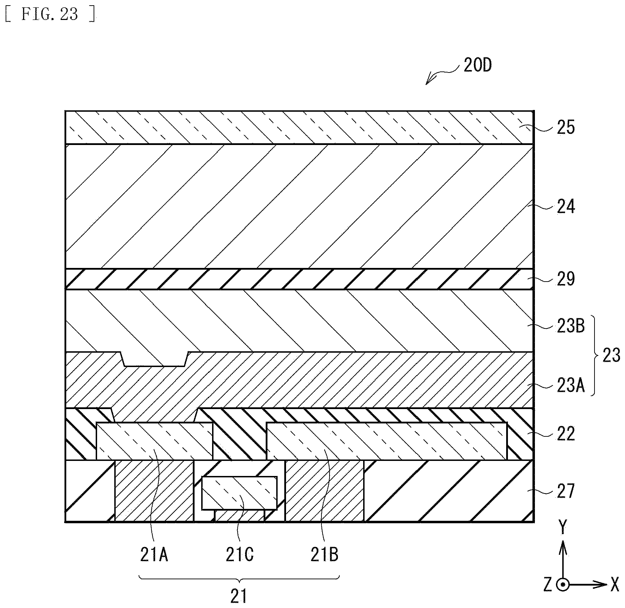

FIG. 23 schematically illustrates a cross-sectional configuration of the main portion (organic photoelectric conversion section 20D) of an imaging element according to the modification example 3 of the present disclosure. The organic photoelectric conversion section 20D according to the present modification example is different from that of the embodiment described above in that there is provided a transfer electrode 21C between the readout electrode 21A and the accumulation electrode 21B.

The transfer electrode 21C is for increasing the efficiency of transferring the electric charge accumulated above the accumulation electrode 21B to the readout electrode 21A. The transfer electrode 21C is provided between the readout electrode 21A and the accumulation electrode 21B. Specifically, the transfer electrode 21C is formed, for example, in a layer lower than the layer provided with the readout electrode 21A and the accumulation electrode 21B. The transfer electrode 21C is provided to cause a portion thereof to overlap with the readout electrode 21A and the accumulation electrode 21B.

It is possible to independently apply respective voltages to the readout electrode 21A, the accumulation electrode 21B, and the transfer electrode 21C. In the present modification example, the drive circuit applies a potential V5 to the readout electrode 21A, applies a potential V6 to the accumulation electrode 21B, and applies a potential V7 (V5 > V6 > V7) to the transfer electrode 21C in a transfer period following the completion of the reset operation. This causes the electric charge accumulated above the accumulation electrode 21B to move from the accumulation electrode 21B onto the transfer electrode 21C and the readout electrode 21A in this order and be read out to the floating diffusion FD1.

In this way, in the present modification example, the transfer electrode 21C is provided between the readout electrode 21A and the accumulation electrode 21B. This makes it possible to move electric charge from the readout electrode 21A to the floating diffusion FD1 more certainly. The characteristics of transporting electric charge to the readout electrode 21A are further improved to make it possible to reduce noise.

<3. Second Embodiment>

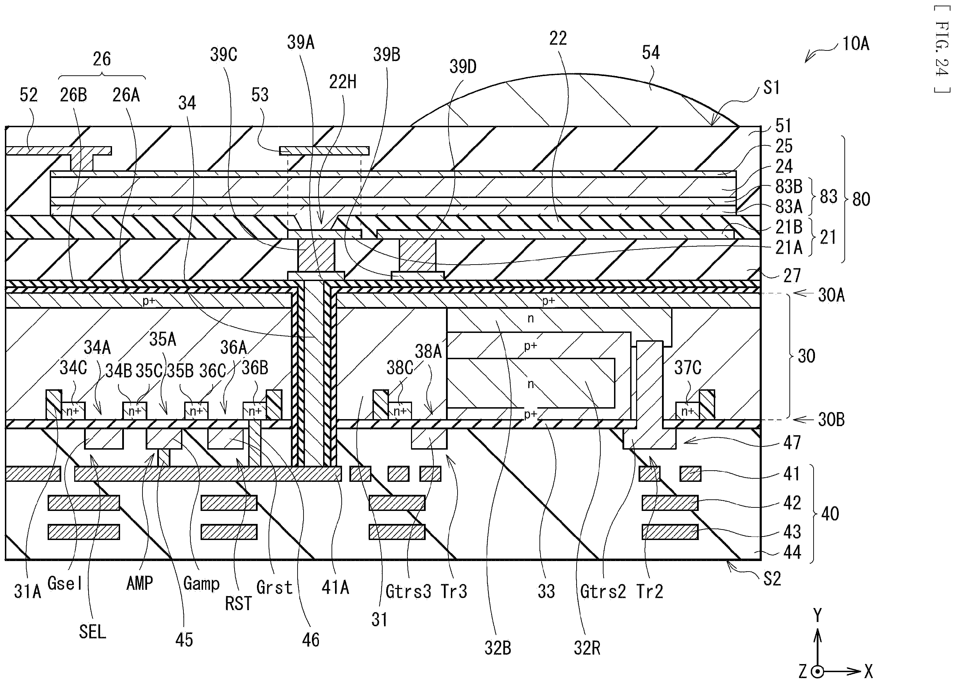

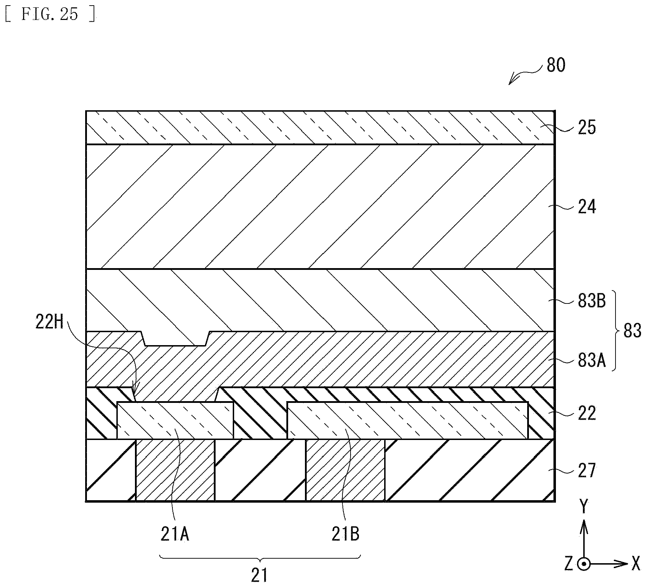

FIG. 24 illustrates a cross-sectional configuration of an imaging element (imaging element 10A) according to the second embodiment of the present disclosure. FIG. 25 is a schematic enlarged view of an example of a cross-sectional configuration of the main portion (organic photoelectric conversion section 80) of the imaging element 10A illustrated in FIG. 24. The imaging element 10A is included, for example, in one of pixels (unit pixels P) that are repeatedly disposed in an array in the pixel section 1A of an imaging device (e.g., the imaging device 1) such as a CMOS image sensor used for an electronic apparatus such as a digital still camera or a video camera.

In the organic photoelectric conversion section 80 of the imaging element 10A according to the present embodiment, a semiconductor layer 83 and a photoelectric conversion layer 84 are stacked in this order from the lower electrode 21 side between the lower electrode 21 including the readout electrode 21A and the accumulation electrode 21B and the upper electrode 25. The lower electrode 21 and the upper electrode 25 are disposed to be opposed to each other. The semiconductor layer 83 includes, for example, a first semiconductor layer 83A and a second semiconductor layer 83B. The first semiconductor layer 83A and the second semiconductor layer 83B are stacked in this order from the lower electrode 21 side. The first semiconductor layer 83A has a smaller value for $\Delta EN$ than the value of the second semiconductor layer 83B for $\Delta EN$. The second semiconductor layer 83B has a larger value for $E_{VO}$ than the value of the first semiconductor layer 83A for $E_{VO}$ as in the first embodiment described above.

The semiconductor layer 83 is for accumulating the electric charge generated by the photoelectric conversion layer 84. The semiconductor layer 83 has a stacked structure in which the first semiconductor layer 83A and the second semiconductor layer 83B are stacked in this order from the lower electrode 21 side as described above. Specifically, the first semiconductor layer 83A is provided on the insulating layer 22 that electrically separates the lower electrode 21 and the semiconductor layer 83. The first semiconductor layer 83A is electrically coupled directly to the readout electrode 21A in the opening 22H provided on the readout electrode 21A. The second semiconductor layer 83B is provided between the first semiconductor layer 83A and the photoelectric conversion layer 84.

It is possible to form the first semiconductor layer 83A to cause an oxide semiconductor material to be included that has a smaller value for $\Delta EN$ than the value of the second semiconductor layer 83B for $\Delta EN$. It is possible to form the second semiconductor layer 83B to cause an oxide semiconductor material to be included that has a larger value for $E_{VO}$ than the value of the first semiconductor layer 83A for $E_{VO}$ as in the first embodiment described above.

$\Delta EN$ is an index for determining which of ionicity or a covalent bond property an oxide semiconductor has. $\Delta EN$ is defined as a value ($\Delta EN = EN_{anion} - EN_{cation}$) obtained by subtracting an average electronegativity value $EN_{cation}$ of the cation species included in an inorganic semiconductor material layer from an average electronegativity value $EN_{anion}$ of the anion species included in the electrical inorganic semiconductor material layer in the oxide semiconductor. In a case of high ionicity ($\Delta EN$ is large), the electrostatic potential goes up and down more sharply in the oxide semiconductor. In a case of a high covalent bond property ($\Delta EN$ is small), the electrostatic potential goes up and down more gently. As an oxide semiconductor has a higher covalent bond property, the hydrogen atoms (protons or hydride ions) in the oxide semiconductor are likely to be dispersed even at lower temperature. It is possible to form a favorable film even under a low-temperature annealing condition. It is to be noted that the average here is a value obtained by averaging the electronegativity of various metal elements in accordance with the composition (atomic %) in the oxide semiconductor.

It is possible to form the first semiconductor layer 83A by using an oxide semiconductor material including, for example, two or more elements of In, Sn, Zn, Ga, Ti, Al, W, or the like. In addition, it is possible to form the second semiconductor layer 83B by using an oxide semiconductor material including, for example, two or more elements of Ga, Al, Ti, Zn, Sn, In, W, or the like.

More specifically, for example, in a case where the composition of an oxide semiconductor material included in the first semiconductor layer 83A is represented as AaBbOc, the element of A is any of In, Sn, Zn, Ga, Ti, Al, or W. The element of B is any element of In, Sn, Zn, Ga, Ti, Al, or W other than the element selected as A. It is preferable that the composition ratio thereof satisfy a > b or b > a. In addition, it is preferable that a and b satisfy a > b or b > a in a + b + c = 1.00. In a case where the composition of an oxide semiconductor material included in the first semiconductor layer 83A is represented as AaBbCcOd, the element of A is any of In, Sn, Zn, Ga, Ti, Al, or W. The element of B is any element of In, Sn, Zn, Ga, Ti, Al, or W other than the element selected as A. The element of C is any element of In, Sn, Zn, Ga, Ti, Al, or W other than the elements selected as A and B. It is preferable that a have the highest proportion as the composition ratio thereof and c > b or b > c be satisfied. It is more preferable that c > b be satisfied. In addition, it is preferable that a, b, and c satisfy a > b + c in a + b + c + d = 1.00.

In a case where the composition of an oxide semiconductor material included in the second semiconductor layer 83B is represented as AaBbOc, the element of A is any of Ga, Al, Ti, Zn, Sn, In, or W in the second semiconductor layer 83B. The element of B is any element of Ga, Al, Ti, Zn, Sn, In, or W other than the element selected as A. It is preferable that the composition ratio thereof satisfy a > b or b > a. In addition, it is preferable that a and b satisfy a > b or b > a in a + b + c = 1.00. In a case where the composition of an oxide semiconductor material included in the second semiconductor layer 83B is represented as AaBbCcOd, the element of A is any of Ga, Al, Ti, Zn, Sn, In, or W. The element of B is any element of Ga, Al, Ti, Zn, Sn, In, or W other than the element selected as A. The element of C is any element of Ga, Al, Ti, Zn, Sn, In, or W other than the elements selected as A and B. It is preferable that a have the highest proportion as the composition ratio thereof and c > b or b > c be satisfied. It is more preferable that c > b be satisfied. In addition, it is preferable that a, b, and c satisfy a > b + c in a + b + c + d = 1.00.

It is to be noted that surface roughness Ra of the second semiconductor layer 83B which forms an interface with the photoelectric conversion layer 84 is preferably 1.5 nm or less. In addition, it is preferable that root-mean-square roughness Rq of the second semiconductor layer 83B which forms an interface with the photoelectric conversion layer 84 be 2.5 nm or less. This makes it possible to form other organic layers including the protective layer 29 and the photoelectric conversion layer 84 described above. Further, it is preferable that the second semiconductor layer 83B have a carrier concentration of $1 \times 10^{14}/cm^{-3}$ or more and less than $1 \times 10^{17}/cm^{-3}$. This makes it possible to deplete the semiconductor layer 83.

It is preferable that the semiconductor layer 83 have a carrier mobility of 10 $cm^2/V \cdot s$ or more. The semiconductor layer 83 has, for example, an amorphous structure. The semiconductor layer 83 has, for example, a thickness of 10 nm or more and 150 nm or less.

It is to be noted that impurities such as hydrogen (H) or other metal elements enter the first semiconductor layer 83A and the second semiconductor layer 83B in some cases in the process of formation. However, as long as the impurities are small in amount (e.g., a mole fraction of 3% or less), there is no need to prevent the entry.

In addition, nitride semiconductor materials or oxynitride semiconductor materials are also usable as materials included in the first semiconductor layer 83A and the second semiconductor layer 83B as in the first embodiment described above. In a case where the first semiconductor layer 83A and the second semiconductor layer 83B are formed by using nitride semiconductor materials, the nitrogen deficiency generation energy $E_{VN}$ is used as an index in place of the oxygen deficiency generation energy $E_{VO}$. Even in that case, it is possible to include nitride semiconductor materials for formation to cause the first semiconductor layer 83A to have a smaller value for $\Delta EN$ than the value of the second semiconductor layer 83B for $\Delta EN$, cause the second semiconductor layer 83B to have a larger value for $E_{VN}$ than the value of the first semiconductor layer 83A for $E_{VN}$, and cause the second semiconductor layer 83B to have a larger value for $E_{VN}$ than the value of the first semiconductor layer 83A for $E_{VN}$.

The photoelectric conversion layer 84 is for converting light energy to electric energy. The photoelectric conversion layer 84 may have a configuration similar to that of the photoelectric conversion layer 24 according to the first embodiment described above. It is, however, preferable in the present embodiment that a Lowest Unoccupied Molecular Orbital (LUMO) level E1 of a material positioned near the semiconductor layer 83 and an LUMO level E2 of an oxide semiconductor material included in the semiconductor layer 83 satisfy E2 - E1 $\geq$ 0.1 eV It is more preferable that E2 - E1 > 0.1 eV be satisfied. This makes it possible to move the electrons generated by the photoelectric conversion layer 84 to the semiconductor layer 83.

It is to be noted that it is possible to control the energy levels of the semiconductor layer 83 and the photoelectric conversion layer 84, for example, by adjusting the introduction amount of oxygen gas (oxygen gas partial pressure) used to form the respective layers by using a sputtering method. In addition, it is possible to control the carrier mobility of the semiconductor layer 83 and the carrier concentration of the second semiconductor layer 83B by adjusting the composition proportions.

As described above, the imaging element 10A according to the present embodiment is provided with the semiconductor layer 83 between the lower electrode 21 including the readout electrode 21A and the accumulation electrode 21B and the photoelectric conversion layer 84. In the semiconductor layer 83, the first semiconductor layer 83A and the second semiconductor layer 83B are stacked in this order from the lower electrode 21 side. The first semiconductor layer 83A has a smaller value for ΔEN than the value of the second semiconductor layer 83B for ΔEN. The second semiconductor layer 83B has a larger value for $E_{VO}$ than the value of the first semiconductor layer 83A for $E_{VO}$. This promotes hydrogen to be dispersed in the first semiconductor layer 83A, reduces the occurrence of deficiency sites that trap electric charge, and improves the characteristics of transporting the electric charge accumulated in the semiconductor layer 83 above the accumulation electrode 21B in the in-plane direction. In addition, the occurrence of traps at the interface between the semiconductor layer 23 and the photoelectric conversion layer 24 is reduced. This makes it possible to improve the afterimage characteristics as in the first embodiment described above.

In addition, a layer including an organic material like the photoelectric conversion layer 84 has low heat resistance in general. Exposure to a high temperature condition may deteriorate the characteristics. In contrast, in the imaging element 10A according to the present embodiment, ΔEN is smaller for the first semiconductor layer 83A. It is thus possible to manufacture the imaging element 10A according to the present embodiment at lower temperature than that of a typical organic photoelectric conversion section. This is useful especially for the imaging elements 10B and 10C according to the modification examples 4 and 5 described below in each of which a plurality of organic photoelectric conversion sections is stacked. In a case where an organic photoelectric conversion section (e.g., an organic photoelectric conversion section 70 in the imaging element 10B) to be disposed in an upper layer is formed, it is possible to prevent a photoelectric conversion layer (e.g., the photoelectric conversion layer 24 of the organic photoelectric conversion section 20 in the imaging element 10B) of an organic photoelectric conversion section to be disposed in a lower layer from having deteriorated characteristics. This makes it possible to prevent the deterioration of the device characteristics.

Further, the configuration described above allows the imaging element 10A according to the present embodiment to exert well-balanced control over the LUMO value and the carrier mobility of the semiconductor layer 83.

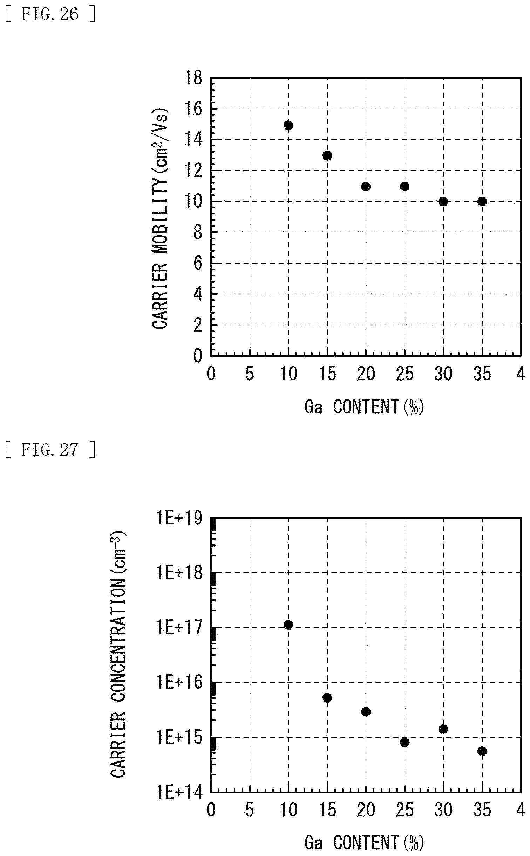

Table 3 tabulates carrier mobilities and carrier concentrations at the respective composition ratios in a case where the semiconductor layer 83 (second semiconductor layer 83B) is formed by using GZTO (Ga-Zn-Sn-O-based oxide semiconductor), IGZO (In-Ga-Zn-O-based oxide semiconductor), or ZnTiSnO. In addition, FIG. 26 illustrates the relationship between the Ga content and the carrier mobility in an experimental example 13 to an experimental example 18. FIG. 27 illustrates the relationship between the content and carrier concentration of Ga in the experimental example 13 to the experimental example 18. In each of the samples (experimental examples 13 to 21) for evaluation, first, the lower electrode 21 including ITO was formed on a substrate and the semiconductor layer 83 (second semiconductor layer 83B), the photoelectric conversion layer 84, a buffer layer including $MoO_X$, and the upper electrode 25 were then stacked sequentially on the lower electrode 21. The semiconductor layer 83 had a thickness of 100 nm.

[Table 3]

| | composition of second semiconductor layer | composition ratio | | | carrier mobility | carrier concentration | Δ EN |
|---|---|---|---|---|---|---|---|
| | | Ga | Zn | Sn | | | |
| experimental example 13 | GZT0 | 10 | 38 | 52 | 15 | up to $1 \times 10^{17}$ | 1.61 |
| experimental example 14 | GZT0 | 15 | 35 | 30 | 13 | up to $5 \times 10^{15}$ | 1.61 |
| experimental example 15 | GZT0 | 20 | 33 | 47 | 11 | up to $3 \times 10^{15}$ | 1.61 |
| experimental example 16 | GZT0 | 25 | 31 | 44 | 11 | up to $8 \times 10^{14}$ | 1.61 |
| experimental example 17 | GZT0 | 30 | 29 | 41 | 10 | up to $2 \times 10^{15}$ | 1.61 |
| experimental example 18 | GZT0 | 35 | 26 | 39 | 10 | up to $6 \times 10^{14}$ | 1.61 |

(continued)

|  | composition of second semiconductor layer | composition ratio | | | carrier mobility | carrier concentration | $\Delta$ EN |
|---|---|---|---|---|---|---|---|
|  |  | Ga | Zn | Sn |  |  |  |
| experimental example 19 | IGZ0 | 33 | 33 | 33 | 11 | up to $6 \times 10^{16}$ | 1.69 |
| experimental example 20 | ZnTiSn0 | 42 | 4 | 54 | 8 | up to $8 \times 10^{15}$ | 1. 62 |
| experimental example 2 1 | ZnTiSn0 | 34 | 8 | 58 | 9 | up to $5 \times 10^{15}$ | 1. 61 |

The experimental example 13 to the experimental example 21 described above each exhibited a dark current characteristic ($J_{dk}$) of $1 \times 10^{-10}/cm^2$ or less in a case where 2 V was applied as a positive bias. The experimental example 13 to the experimental example 21 described above each offered a result indicating an external quantum efficiency (EQE) of 75% or more in a case where 2 V was applied as a positive bias. It is to be noted that, in a case where the dark current characteristic ($J_{dk}$) and the EQE of a typical device provided with no semiconductor layer between a lower electrode and a photoelectric conversion layer were measured under the same condition, a result similar to those of the experimental example 13 to the experimental example 21 was obtained about the dark current characteristic ($J_{dk}$). In addition, a typical device had an EQE of 70%. This indicates that it is possible to increase the EQE of the imaging element 10B according to the present embodiment while maintaining the favorable dark current characteristic ($J_{dk}$).

It is to be noted that, in the imaging element 10A according to the present embodiment, the first semiconductor layer 83A is formed as an amorphous layer as in the first modification example described above. This makes it possible to prevent the carrier density of the first semiconductor layer 83A from increasing and achieve a low carrier concentration. In addition, it is possible to suppress the occurrence of dangling bonds on a grain boundary in the first semiconductor layer 83A or at the interface with the insulating layer 22 and further reduce traps as compared with a case where the first semiconductor layer 83A is formed as a crystal layer. This makes it possible to further improve the afterimage characteristics.

In addition, in the imaging element 10A according to the present embodiment, the ratio (t2/t1) of the thickness (t2) of the second semiconductor layer 83B to the thickness (t1) of the first semiconductor layer 83A is 4 or more and 8 or less as in the first embodiment described above. This allows the second semiconductor layer 83B to sufficiently absorb the carriers generated from the first semiconductor layer 83A. In addition, the first semiconductor layer 83A is formed as an amorphous layer. This makes it possible to achieve a low carrier concentration while preventing the carrier density of the semiconductor layer 83 from increasing. This makes it possible to further improve the afterimage characteristics.

Further, the present technology is also applicable to an imaging element having the following configurations.

<4. Modification Examples>

(4-1. Modification Example 4)

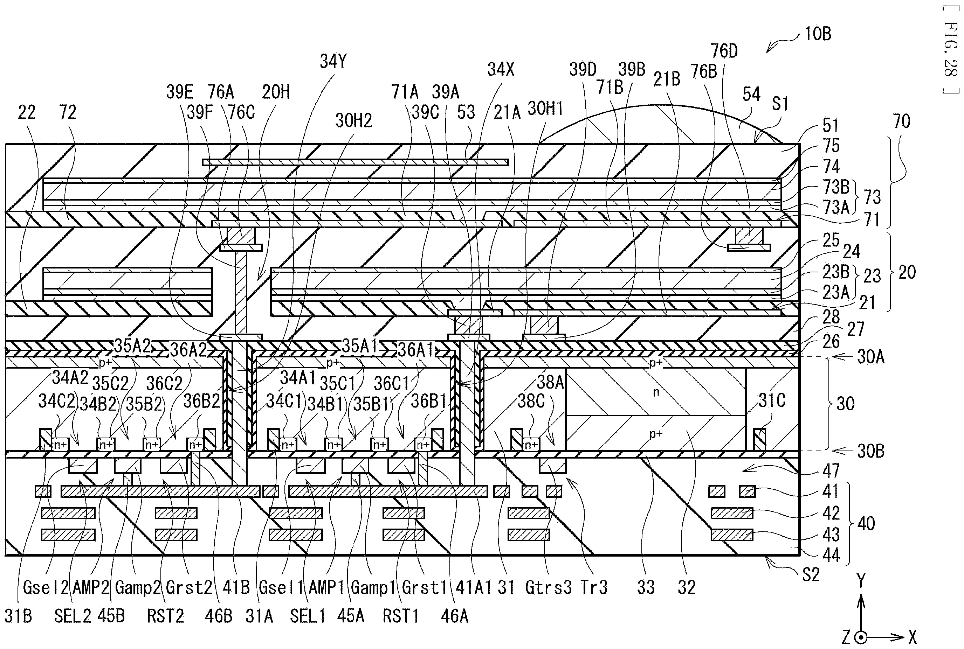

FIG. 28 illustrates a cross-sectional configuration of an imaging element (imaging element 10B) according to the modification example 4 of the present disclosure. The imaging element 10B is included, for example, in one of pixels (unit pixels P) that are repeatedly disposed in an array in the pixel section 1A of an imaging device (imaging device 1) such as a CMOS image sensor used for an electronic apparatus such as a digital still camera or a video camera. In the imaging element 10B according to the present modification example, the two organic photoelectric conversion sections 20 and 70 and the one inorganic photoelectric conversion section 32 are stacked in the vertical direction.

The organic photoelectric conversion sections 20 and 70 and the inorganic photoelectric conversion section 32 perform photoelectric conversion by selectively detecting respective pieces of light in different wavelength ranges. For example, the organic photoelectric conversion section 20 acquires a color signal of green (G). For example, the organic photoelectric conversion section 70 acquires a color signal of blue (B). For example, the inorganic photoelectric conversion section 32 acquires a color signal of red (R). This allows the imaging element 10B to acquire a plurality of types of color signals in the one unit pixel P without using any color filter.

The organic photoelectric conversion section 70 is stacked, for example, above the organic photoelectric conversion section 20. As with the organic photoelectric conversion section 20, the organic photoelectric conversion section 70 has a configuration in which a lower electrode 71, a semiconductor layer 73, a photoelectric conversion layer 74, and an upper electrode 75 are stacked in this order from the first surface 30A side of the semiconductor substrate 30. The semiconductor layer 73 includes, for example, a first semiconductor layer 73A and a second semiconductor layer 73B.

In addition, there is provided an insulating layer 72 between the lower electrode 71 and the semiconductor layer 73. For example, the lower electrodes 71 are formed separately for the respective imaging elements 10B. In addition, the lower electrodes 71 each include a readout electrode 71A and an accumulation electrode 71B that are separated from each other with the insulating layer 72 interposed in between. The readout electrode 71A of the lower electrode 71 is electrically coupled to the first semiconductor layer 72A through an opening 72H provided in the insulating layer 72. FIG. 28 illustrates an example in which the semiconductor layers 73, the photoelectric conversion layers 74, and the upper electrodes 75 are separately formed for the respective imaging elements 10B. For example, the semiconductor layer 73, the photoelectric conversion layer 74, and the upper electrode 75 may be, however, formed as continuous layers common to the plurality of imaging elements 10B.

The semiconductor layer 73 is for accumulating the electric charge generated by the photoelectric conversion layer 74. The semiconductor layer 73 has a stacked structure in which the first semiconductor layer 73A and the second semiconductor layer 73B are stacked in this order from the lower electrode 71 side as with the semiconductor layer 23. Specifically, the first semiconductor layer 73A is provided on the insulating layer 72 that electrically separates the lower electrode 71 and the semiconductor layer 73. The first semiconductor layer 73A is electrically coupled to the readout electrode 71A in the opening 72H provided on the readout electrode 71A. The second semiconductor layer 73B is provided between the first semiconductor layer 73A and the photoelectric conversion layer 74.

The first semiconductor layer 73A and the second semiconductor layer 73B respectively have configurations similar to those of the first semiconductor layer 23A and the second semiconductor layer 23B. In other words, the first semiconductor layer 73A has a larger value for C5s than the value of the second semiconductor layer 73B for C5s. The second semiconductor layer 73B has a larger value for $E_{VO}$ or $E_{VN}$ than the value of the first semiconductor layer 73A for $E_{VO}$ or $E_{VN}$. Examples of materials included in the semiconductor layer 73 (the first semiconductor layer 73A and the second semiconductor layer 73B) include IGZO (In-Ga-Zn-O-based oxide semiconductor), GZTO (Ga-Zn-Sn-O-based oxide semiconductor), ITZO (In-Sn-Zn-O-based oxide semiconductor), ITGZO (In-Sn-Ga-Zn-O-based oxide semiconductor), and the like.

The photoelectric conversion layer 74 converts light energy to electric energy. As with the photoelectric conversion layer 24, the photoelectric conversion layer 74 includes two or more types of organic materials (p-type semiconductor material or n-type semiconductor material) that each function as a p-type semiconductor or an n-type semiconductor. The photoelectric conversion layer 74 includes an organic material or a so-called dye material in addition to the p-type semiconductor and the n-type semiconductor. The organic material or the dye material photoelectrically converts light in a predetermined wavelength range and transmits light in another wavelength range. In a case where the photoelectric conversion layer 74 is formed by using the three types of organic materials including a p-type semiconductor, an n-type semiconductor, and a dye material, it is preferable that the p-type semiconductor and the n-type semiconductor be materials each having light transmissivity in the visible region (e.g., 450 nm to 800 nm). The photoelectric conversion layer 74 has, for example, a thickness of 50 nm to 500 nm. Examples of dye materials used for the photoelectric conversion layer 74 include coumarin and a diazo compound, derivatives thereof, or the like.

There are provided two through electrodes 34X and 34Y between the first surface 30A and the second surface 30B of the semiconductor substrate 30.

The through electrode 34X is electrically coupled to the readout electrode 21A of the organic photoelectric conversion section 20 as with the through electrode 34 according to the first embodiment described above. The organic photoelectric conversion section 20 is coupled to the gate Gamp of the amplifier transistor AMP and the one source/drain region 36B 1 of the reset transistor RST (reset transistor Trirst) also serving as the floating diffusion FD1 through the through electrode 34X. The upper end of the through electrode 34X is coupled to the readout electrode 21A, for example, through the pad section 39A and the upper first contact 39C.

The through electrode 34Y is electrically coupled to the readout electrode 71A of the organic photoelectric conversion section 70. The organic photoelectric conversion section 70 is coupled to the gate Gamp of the amplifier transistor AMP and the one source/drain region 36B2 of the reset transistor RST (reset transistor Tr2rst) also serving as the floating diffusion FD2 through the through electrode 34Y The upper end of the through electrode 34Y is coupled to the readout electrode 71A, for example, through a pad section 39E, an upper third contact 39F, a pad section A, and an upper fourth contact 76C. In addition, a pad section 76B is coupled to the accumulation electrode 71B through an upper fifth contact 76D. The accumulation electrode 71B is included in the lower electrode 71 along with the readout electrode 71A.

As described above, the imaging element 10B according to the present modification example has a configuration in which the two organic photoelectric conversion sections 20 and 70 and the one inorganic photoelectric conversion section 32 are stacked. As with the organic photoelectric conversion section 20, the organic photoelectric conversion section 70 is also provided with the semiconductor layer 73 between the lower electrode 71 and the photoelectric conversion layer 74. In the semiconductor layer 73, the first semiconductor layer 73A and the second semiconductor layer 73B are stacked in this order. The first semiconductor layer 73A has a larger value for C5s. The second semiconductor layer 73B has a larger value for Evo or $E_{VN}$. This makes it possible to obtain effects similar to those of the first embodiment described above.

(4-2. Modification Example 5)

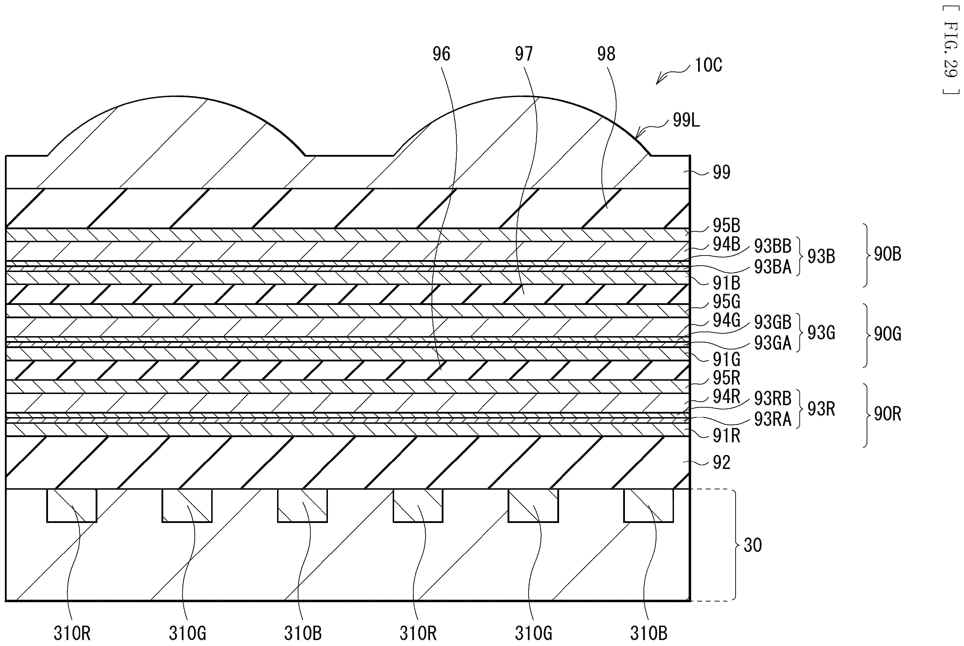

FIG. 29 schematically illustrates a cross-sectional configuration of an imaging element (imaging element 10C) according to the modification example 5 of the present disclosure. The imaging element 10C is included, for example, in one of pixels (unit pixels P) that are repeatedly disposed in an array in the pixel section 1A of an imaging device (imaging device 1) such as a CMOS image sensor used for an electronic apparatus such as a digital still camera or a video camera. The imaging element 10C according to the present modification example has a configuration in which a red color photoelectric conversion section 90R, a green color photoelectric conversion section 90G, and a blue color photoelectric conversion section 90B are stacked above the semiconductor substrate 30 in this order with an insulating layer 92 interposed in between. The red color photoelectric conversion section 90R, the green color photoelectric conversion section 90G, and the blue color photoelectric conversion section 90B are each formed by using an organic material. It is to be noted that FIG. 29 illustrates a simplified configuration of each of the organic photoelectric conversion sections 90R, 90G, and 90B. A specific configuration is similar to that of the organic photoelectric conversion section 20 or the like according to the first embodiment described above.

The red color photoelectric conversion section 90R, the green color photoelectric conversion section 90G, and the blue color photoelectric conversion section 90B respectively include semiconductor layers 93R, 93G, and 93B and photoelectric conversion layers 94R, 94G, and 94B between pairs of electrodes. Specifically, the red color photoelectric conversion section 90R, the green color photoelectric conversion section 90G, and the blue color photoelectric conversion section 90B respectively include the semiconductor layers 93R, 93G, and 93B and the photoelectric conversion layers 94R, 94G, and 94B between a first electrode 91R and a second electrode 95R, between a first electrode 91G and a second electrode 95G, and between a first electrode 91B and a second electrode 95B.

There is provided a protective layer 98 and an on-chip lens layer 99 on the blue color photoelectric conversion section 90B. The on-chip lens layer 99 includes an on-chip lens 99L on the front surface. There are provided a red color electricity storage layer 310R, a green color electricity storage layer 310G, and a blue color electricity storage layer 310B in the semiconductor substrate 30. The pieces of light entering the on-chip lenses 99L are photoelectrically converted by the red color photoelectric conversion section 90R, the green color photoelectric conversion section 90G, and the blue color photoelectric conversion section 90B and the signal charge is transmitted from the red color photoelectric conversion section 90R to the red color electricity storage layer 310R, from the green color photoelectric conversion section 90G to the green color electricity storage layer 310G, and from the blue color photoelectric conversion section 90B to the blue color electricity storage layer 310B. Although any of electrons or holes generated through photoelectric conversion may serve as the signal charge, the following gives description by exemplifying a case where electrons are read out as signal charge.

The semiconductor substrate 30 includes, for example, a p-type silicon substrate. The red color electricity storage layer 310R, the green color electricity storage layer 310G, and the blue color electricity storage layer 310B provided in this semiconductor substrate 30 each include an n-type semiconductor region and the signal charge (electrons) supplied from the red color photoelectric conversion section 90R, the green color photoelectric conversion section 90G, and the blue color photoelectric conversion section 90B is accumulated in these n-type semiconductor regions. The n-type semiconductor regions of the red color electricity storage layer 310R, the green color electricity storage layer 310G, and the blue color electricity storage layer 310B are formed, for example, by doping the semiconductor substrate 30 with an n-type impurity such as phosphorus (P) or arsenic (As). It is to be noted that the semiconductor substrate 30 may be provided on a support substrate (not illustrated) including glass or the like.

The semiconductor substrate 30 is provided with a pixel transistor for reading out electrons from each of the red color electricity storage layer 310R, the green color electricity storage layer 310G, and the blue color electricity storage layer 310B and transferring the electrons, for example, to a vertical signal line (e.g., a vertical signal line Lsig in FIG. 33 described below). The floating diffusion of this pixel transistor is provided in the semiconductor substrate 30 and this floating diffusion is coupled to the red color electricity storage layer 310R, the green color electricity storage layer 310G, and the blue color electricity storage layer 310B. The floating diffusion includes an n-type semiconductor region.

The insulating layer 92 includes, for example, a single layer film including one of silicon oxide ($SiO_x$), silicon nitride ($SiN_x$), silicon oxynitride (SiON), hafnium oxide ($HfO_x$), or the like or a stacked film including two or more of them. In addition, the insulating layer 92 may be formed by using an organic insulating material. Although not illustrated, the insulating layer 92 is provided with respective plugs and electrodes for coupling the red color electricity storage layer 310R and the red color photoelectric conversion section 90R, the green color electricity storage layer 310G and the green color photoelectric conversion section 90G, and the blue color electricity storage layer 310B and the blue color photoelectric conversion section 90B.

The red color photoelectric conversion section 90R includes the first electrode 91R, the semiconductor layer 93R (a first semiconductor layer 93RA and a second semiconductor layer 93RB), the photoelectric conversion layer 94R, and the second electrode 95R in this order from positions closer to the semiconductor substrate 30. The green color photoelectric conversion section 90G includes the first electrode 91G, the semiconductor layer 93G (a first semiconductor layer 93GA and a second semiconductor layer 93GB), the photoelectric conversion layer 94G, and the second electrode 95G in this order from positions closer to the red color photoelectric conversion section 90R. The blue color photoelectric conversion section 90B includes the first electrode 91B, the semiconductor layer 93B (a first semiconductor layer 93BA and a second semiconductor layer 93BB), the photoelectric conversion layer 94B, and the second electrode 95B in this order from positions closer to the green color photoelectric conversion section 90G. There is further provided an insulating layer 96 between the red color photoelectric conversion section 90R and the green color photoelectric conversion section 90G and there is further provided an insulating layer 97 between the green color photoelectric conversion section 90G and the blue color photoelectric conversion section 90B. The red color photoelectric conversion section 90R, the green color photoelectric conversion section 90G, and the blue color photoelectric conversion section 90B respectively absorb selectively red (e.g., wavelengths of 620 nm or more and less than 750 nm) light, green (e.g., wavelengths of 495 nm or more and less than 620 nm) light, and blue (e.g., wavelengths of 400 nm or more and less than 495 nm) light to generate electron-hole pairs.

The first electrode 91R, the first electrode 91G, and the first electrode 91B respectively extract the signal charge generated by the photoelectric conversion layer 94R, the signal charge generated by the photoelectric conversion layer 94G, and the signal charge generated by the photoelectric conversion layer 94B. Although not illustrated, each of the first electrodes 91R, 91G, and 91B includes a plurality of electrodes (e.g., a readout electrode and an accumulation electrode) that is separated from each other by an insulating layer in each of the unit pixels P as with the lower electrode 21 of the organic photoelectric conversion section 20 according to the first embodiment described above.

Each of the first electrodes 91R, 91G, and 91B includes, for example, an electrically conductive material having light transmissivity. For example, each of the first electrodes 91R, 91G, and 91B includes ITO. In addition to ITO, a tin oxide ($SnO_2$)-based material to which a dopant is added or a zinc oxide-based material obtained by adding a dopant to zinc oxide (ZnO) may be used as a material included in the lower electrode 21. Examples of the zinc oxide-based material include aluminum zinc oxide (AZO) to which aluminum (Al) is added as a dopant, gallium zinc oxide (GZO) to which gallium (Ga) is added, and indium zinc oxide (IZO) to which indium (In) is added. In addition, IGZO, ITZO, CuI, $InSbO_4$, ZnMgO, $CuInO_2$, $MgIN_2O_4$, CdO, $ZnSnO_3$, or the like may also be used in addition to these.

The semiconductor layers 93R, 93G, and 93B are for respectively accumulating the electric charge generated by the photoelectric conversion layers 94R, 94G, and 94B. The semiconductor layers 93R, 93G, and 93B have stacked structures in which the first semiconductor layers 93RA, 93GA, and 93BA and the second semiconductor layers 93RB, 93GB, and 93BB are stacked in this order from the first electrodes 91R, 91G, and 91B side as with the semiconductor layer 23 of the organic photoelectric conversion section 20 according to the first embodiment described above. Specifically, for example, in the organic photoelectric conversion section 90R, the first semiconductor layer 93RA, the second semiconductor layer 93RB, the photoelectric conversion layer 94R, and the second electrode 95R are stacked in this order from the first electrode 91R side. The same applies to the organic photoelectric conversion section 90G and the organic photoelectric conversion section 90B.

The first semiconductor layers 93RA, 93GA, and 93BA and the second semiconductor layers 93RB, 93GB, and 93BB respectively have configurations similar to those of the first semiconductor layer 23A and the second semiconductor layer 23B. In other words, the first semiconductor layers 93RA, 93GA, and 93BA respectively have larger values for C5s than the values of the second semiconductor layers 93RB, 93GB, and 93BB for C5s. The second semiconductor layers 93RB, 93GB, and 93BB respectively have larger values for $E_{VO}$ or $E_{VN}$ than the values of the first semiconductor layers 93RA, 93GA, and 93BA for $E_{VO}$ or $E_{VN}$. Examples of materials included in each of the semiconductor layers 93 (the first semiconductor layers 93RA, 93GA, and 93BA and the second semiconductor layers 93RB, 93GB, and 93BB) include IGZO (In-Ga-Zn-O-based oxide semiconductor), GZTO (Ga-Zn-Sn-O-based oxide semiconductor), ITZO (In-Sn-Zn-O-based oxide semiconductor), ITGZO (In-Sn-Ga-Zn-O-based oxide semiconductor), and the like.

Each of the photoelectric conversion layers 94R, 94G, and 94B converts light energy to electric energy. Each of the photoelectric conversion layers 94R, 94G, and 94B absorbs and photoelectrically converts light in a selective wavelength range and transmits light in the other wavelength ranges. Here, the light in the selective wavelength range is, for example, light in the wavelength range of wavelengths of 620 nm or more and less than 750 nm for the photoelectric conversion layer 94R. The light in the selective wavelength range is, for example, light in the wavelength range of wavelengths of 495 nm or more and less than 620 nm for the photoelectric conversion layer 94G. The light in the selective wavelength range is, for example, light in the wavelength range of wavelengths of 400 nm or more and less than 495 nm for the photoelectric conversion layer 94B.

Each of the photoelectric conversion layers 94R, 94G, and 94B includes two or more types of organic materials that each function as a p-type semiconductor or an n-type semiconductor as with the photoelectric conversion layer 24. Each of the photoelectric conversion layers 94R, 94G, and 94B includes an organic material or a so-called dye material in addition to the p-type semiconductor and the n-type semiconductor. The organic material or the dye material photoelectrically converts light in a predetermined wavelength range and transmits light in another wavelength range. Examples of such materials include rhodamine and merocyanine or derivatives thereof for the photoelectric conversion layer 94R. Examples of such materials include a BODIPY dye for the photoelectric conversion layer 94G. Examples of such materials include coumarin, a diazo compound, and a cyanine-based dye, derivatives thereof, or the like for the photoelectric conversion layer 94B.

The second electrode 95R, the second electrode 95G, and the second electrode 95B are for respectively extracting the holes generated by the photoelectric conversion layer 94R, the holes generated by the photoelectric conversion layer 94G, and the holes generated by the photoelectric conversion layer 94G. The holes extracted from the second electrodes 95R, 95G, and 95B are discharged, for example, to a p-type semiconductor region (not illustrated) in the semiconductor substrate 30 through the respective transmission paths (not illustrated).

As with the first electrodes 91R, 91G, and 91B, the second electrodes 95R, 95G, and 95B each include an electrically conductive material having light transmissivity. For example, each of the second electrodes 95R, 95G, and 95B includes ITO. In addition, the second electrodes 95R, 95G, and 95B may include, for example, electrically conductive materials including gold (Au), silver (Ag), copper (Cu), aluminum (Al), and the like.

The insulating layer 96 is for insulating the second electrode 95R and the first electrode 91G. The insulating layer 97 is for insulating the second electrode 95G and the first electrode 91B. Each of the insulating layers 96 and 97 includes, for example, metal oxide, metal sulfide, or an organic substance. Examples of the metal oxide include silicon oxide ($SiO_x$), aluminum oxide ($AlO_x$), zirconium oxide ($ZrO_x$), titanium oxide ($TiO_x$), zinc oxide ($ZnO_x$), tungsten oxide ($WO_x$), magnesium oxide ($MgO_x$), niobium oxide ($NbO_x$), tin oxide($SnO_x$), gallium oxide ($GaO_x$), and the like. The metal sulfide includes zinc sulfide (ZnS), magnesium sulfide (MgS), and the like.

As described above, the imaging element 10C according to the present modification example has a configuration in which three organic photoelectric conversion sections (the red color photoelectric conversion section 90R, the green color photoelectric conversion section 90G, and the blue color photoelectric conversion section 90B) are stacked. As with the organic photoelectric conversion section 20 according to the first embodiment described above, the organic photoelectric conversion sections 90R, 90G, and 90B are respectively provided with the semiconductor layers 93R, 93G, and 93B in which the first semiconductor layers 93RA, 93GA, and 93BA and the second semiconductor layers 93RB, 93GB, and 93BB are stacked in this order. The first semiconductor layers 93RA, 93GA, and 93BA and the second semiconductor layers 93RB, 93GB, and 93BB have predetermined values for C5s and predetermined values for $E_{VO}$ or $E_{VN}$. Specifically, the first semiconductor layers 93RA, 93GA, and 93BA have larger values for C5s than those of the second semiconductor layers 93RB, 93GB, and 93BB. The second semiconductor layers 93RB, 93GB, and 93BB have larger values for $E_{VO}$ or $E_{VN}$ than those of the first semiconductor layers 93RA, 93GA, and 93BA. This makes it possible to obtain effects similar to those of the first embodiment described above.

(4-3. Modification Example 6)

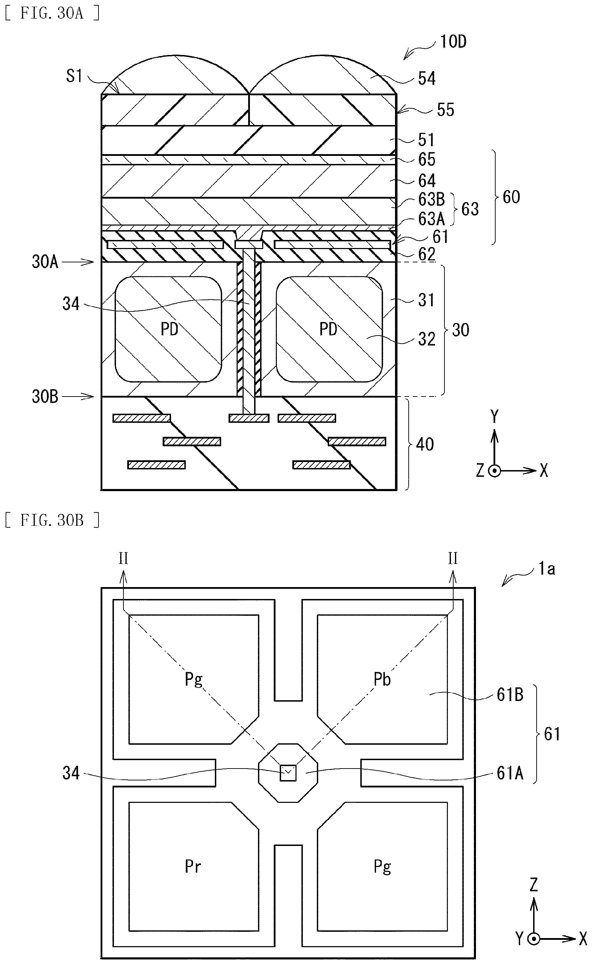

FIG. 30A schematically illustrates a cross-sectional configuration of an imaging element 10D according to the modification example 6 of the present disclosure. FIG. 30B schematically illustrates an example of a planar configuration of the imaging element 10D illustrated in FIG. 30A. FIG. 30A illustrates a cross section taken along the II-II line illustrated in FIG. 30B. The imaging element 10D is a stacked imaging element in which, for example, an inorganic photoelectric conversion section 32 and an organic photoelectric conversion section 60 are stacked. In the pixel section 1A of an imaging device (e.g., the imaging device 1) including this imaging element 10D, the pixel units 1a are repeatedly disposed as repeating units in an array having the row direction and the column direction as in the embodiment described above. Each of the pixel units 1a includes the four unit pixels P disposed, for example, in two rows and two columns, for example, as illustrated in FIG. 30B.

The imaging element 10D according to the present modification example is provided with color filters 55 above the organic photoelectric conversion sections 60 (light incidence side S 1) for the respective unit pixels P. The respective color filters 55 selectively transmit red light (R), green light (G), and blue light (B). Specifically, in the pixel unit 1a including the four unit pixels P disposed in two rows and two columns, two color filters each of which selectively transmits green light (G) are disposed on a diagonal line and color filters that selectively transmit red light (R) and blue light (B) are disposed one by one on the orthogonal diagonal line. The unit pixels (Pr, Pg, and Pb) provided with the respective color filters each detect the corresponding color light, for example, in the organic photoelectric conversion section 60. In other words, the respective unit pixels (Pr, Pg, and Pb) that detect red light (R), green light (G), and blue light (B) have a Bayer arrangement in the pixel section 1A.

The organic photoelectric conversion section 60 includes, for example, a lower electrode 61, an insulating layer 62, a semiconductor layer 63, a photoelectric conversion layer 64, and an upper electrode 65. The lower electrode 61, the insulating layer 62, the semiconductor layer 63, the photoelectric conversion layer 64, and the upper electrode 65 each have a configuration similar to that of the organic photoelectric conversion section 20 according to the embodiment described above. The inorganic photoelectric conversion section 32 detects light in a wavelength range different from that of the organic photoelectric conversion section 60.

In the imaging element 10D, pieces of light (red light (R), green light (G), and blue light (B)) in the visible light region among the pieces of light passing through the color filters 55 are absorbed by the organic photoelectric conversion sections 60 of the unit pixels (Pr, Pg, and Pb) provided with the respective color filters. The other light including, for example, light (infrared light (IR)) in the infrared light region (e.g., 700 nm or more and 1000 nm or less) passes through the organic photoelectric conversion sections 60. This infrared light (IR) passing through the organic photoelectric conversion section 60 is detected by the inorganic photoelectric conversion section 32 of each of the unit pixels Pr, Pg, and Pb. Each of the unit pixels Pr, Pg, and Pb generates the signal charge corresponding to the infrared light (IR). In other words, the imaging device 1 including the imaging element 10D is able to concurrently generate both a visible light image and an infrared light image.

(4-4. Modification Example 7)

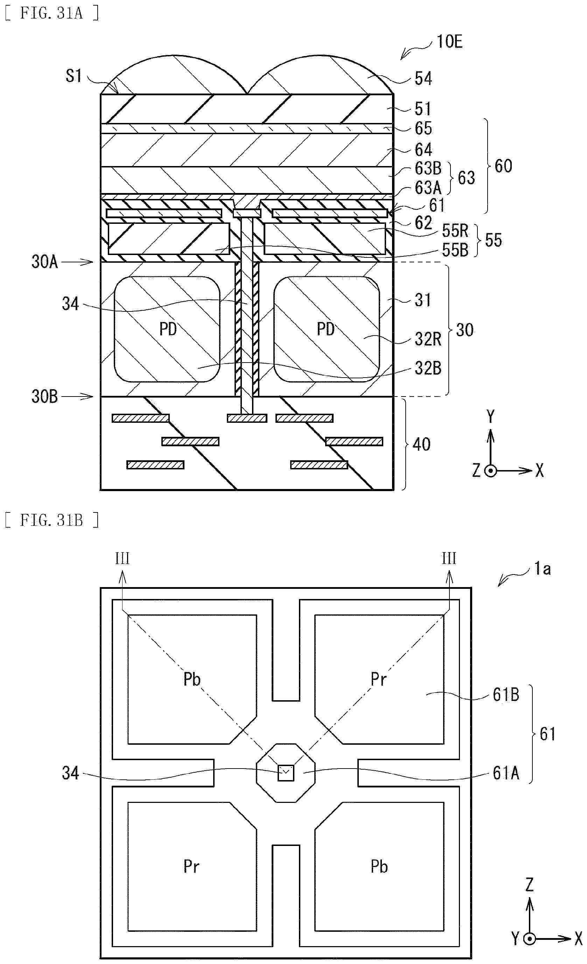

FIG. 31A schematically illustrates a cross-sectional configuration of an imaging element 10E according to the modification example 7 of the present disclosure. FIG. 31B schematically illustrates an example of a planar configuration of the imaging element 10E illustrated in FIG. 31A. FIG. 31A illustrates a cross section taken along the III-III line illustrated in FIG. 31B. In the modification example 6 described above, the example has been described in which the color filters 55 that selectively transmit red light (R), green light (G), and blue light (B) are provided above the organic photoelectric conversion sections 60 (light incidence side S1), but the color filters 55 may be provided between the inorganic photoelectric conversion sections 32 and the organic photoelectric conversion sections 60, for example, as illustrated in FIG. 31A.

For example, the color filters 55 in the imaging element 10E have a configuration in which color filters (color filters 55R) each of which selectively transmits at least red light (R) and color filters (color filters 55B) each of which selectively transmits at least blue light (B) are disposed on the respective diagonal lines in the pixel unit 1a. The organic photoelectric conversion section 60 (photoelectric conversion layer 64) is configured to selectively absorb a wavelength corresponding to green light. This allows the organic photoelectric conversion sections 60 and the respective inorganic photoelectric conversion sections (inorganic photoelectric conversion sections 32R and 32G) disposed below the color filters 55R and 55B to acquire signals corresponding to R, G, and B. The imaging element 10E according to the present modification example allows the respective photoelectric conversion sections of R, G, and B to each have larger area than that of an imaging element having a typical Bayer arrangement. This makes it possible to increase the S/N ratio.

(4-5. Modification Example 8)

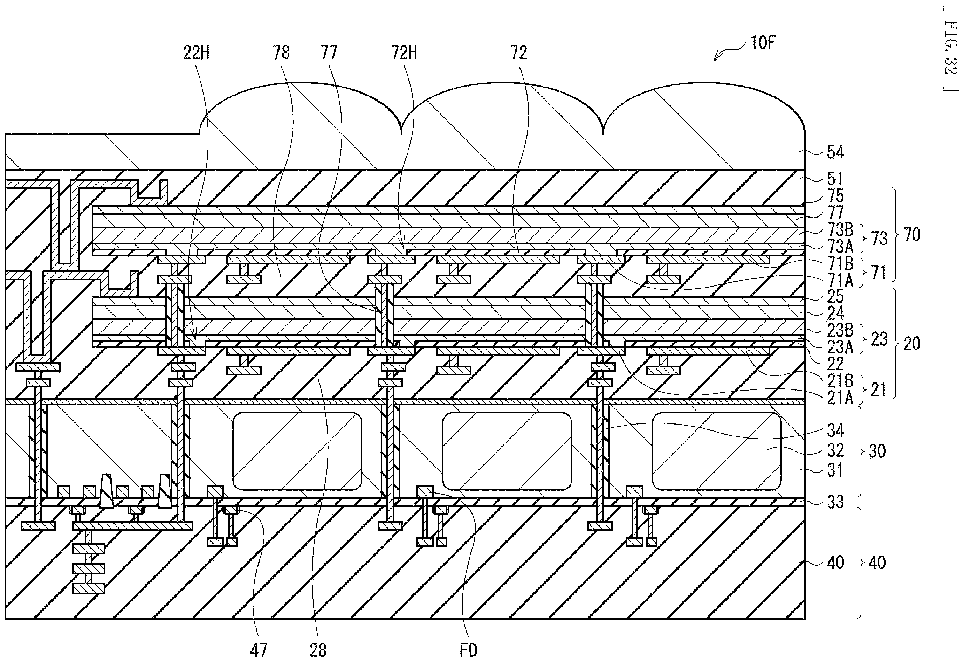

FIG. 32 schematically illustrates a cross-sectional configuration of an imaging element 10F according to the modification example 8 of the present disclosure. The imaging element 10F according to the present modification example is another example of a structure in which the two organic photoelectric conversion sections 20 and 70 and the one inorganic photoelectric conversion section 32 are stacked in the vertical direction as in the modification example 4 described above.

The organic photoelectric conversion sections 20 and 70 and the inorganic photoelectric conversion section 32 perform photoelectric conversion by selectively detecting respective pieces of light in different wavelength ranges. For example, the organic photoelectric conversion section 20 acquires a color signal of green (G). For example, the organic photoelectric conversion section 70 acquires a color signal of blue (B). For example, the inorganic photoelectric conversion section 32 acquires a color signal of red (R). This allows the imaging element 10F to acquire a plurality of types of color signals in one pixel without using any color filter.

The organic photoelectric conversion section 70 is stacked, for example, above the organic photoelectric conversion section 20. As with the organic photoelectric conversion section 20, the organic photoelectric conversion section 70 has a configuration in which a lower electrode 71, a semiconductor layer 73, a photoelectric conversion layer 74, and an upper electrode 75 are stacked in this order from the first surface 30A side of the semiconductor substrate 30. The semiconductor layer 73 includes, for example, the first semiconductor layer 73A and the second semiconductor layer 73B. The lower electrode 71 includes a readout electrode 71A and an accumulation electrode 71B as with the organic photoelectric conversion section 20. The lower electrode 71 is electrically separated by an insulating layer 72. The insulating layer 72 is provided with an opening 72H on the readout electrode 71A. There is provided an interlayer insulating layer 78 between the organic photoelectric conversion section 70 and the organic photoelectric conversion section 20.

A through electrode 77 is coupled to the readout electrode 71A. The through electrode 77 penetrates the interlayer insulating layer 78 and the organic photoelectric conversion section 20. The through electrode 77 is electrically coupled to the readout electrode 21A of the organic photoelectric conversion section 20. Further, the readout electrode 71A is electrically coupled to the floating diffusion FD provided in the semiconductor substrate 30 through the through electrodes 34 and 77. It is possible for the readout electrode 71A to temporarily accumulate the electric charge generated by the photoelectric conversion layer 74. Further, the readout electrode 71A is electrically coupled to the amplifier transistor AMP and the like provided in the semiconductor substrate 30 through the through electrodes 34 and 77.

<5. Application Examples>

(Application Example 1)

FIG. 33 illustrates an example of an overall configuration of an imaging device (imaging device 1) in which an imaging element (e.g., imaging element 10) according to the present disclosure is used for each of the pixels. This imaging device 1 is a CMOS image sensor. The imaging device 1 includes the pixel section 1A as an imaging area and the peripheral circuit portion 130 in a peripheral region of this pixel section 1A on the semiconductor substrate 30. The peripheral circuit portion 130 includes, for example, a row scanning section 131, a horizontal selection section 133, a column scanning section 134, and a system control section 132.

The pixel section 1A includes, for example, the plurality of unit pixels P (each corresponding to the imaging element 10) that is two-dimensionally disposed in a matrix. These unit pixels P are provided, for example, with a pixel drive line Lread (specifically, a row selection line and a reset control line) for each of the pixel rows and provided with a vertical signal line Lsig for each of the pixel columns. The pixel drive line Lread transmits drive signals for reading out signals from the pixels. One end of the pixel drive line Lread is coupled to the output end of the row scanning section 131 corresponding to each of the rows.

The row scanning section 131 is a pixel drive section that includes a shift register, an address decoder, and the like and drives the respective unit pixels P of the pixel section 1A, for example, row by row. Signals outputted from the respective unit pixels P in the pixel rows selectively scanned by the row scanning section 131 are supplied to the horizontal selection section 133 through the respective vertical signal lines Lsig. The horizontal selection section 133 includes an amplifier, a horizontal selection switch, and the like provided for each of the vertical signal lines Lsig.

The column scanning section 134 includes a shift register, an address decoder, and the like. The column scanning section 134 drives the respective horizontal selection switches of the horizontal selection section 133 in order while scanning the horizontal selection switches. The selective scanning by this column scanning section 134 causes signals of the respective pixels transmitted through each of the vertical signal lines Lsig to be outputted to a horizontal signal line 135 in order and causes the signals to be transmitted to the outside of the semiconductor substrate 30 through the horizontal signal line 135.

The circuit portion including the row scanning section 131, the horizontal selection section 133, the column scanning section 134, and the horizontal signal line 135 may be formed directly on the semiconductor substrate 30 or may be provided on external control IC. In addition, the circuit portion thereof may be formed in another substrate coupled by a cable or the like.

The system control section 132 receives a clock supplied from the outside of the semiconductor substrate 30, data for an instruction about an operation mode, and the like and also outputs data such as internal information of the imaging device 1. The system control section 132 further includes a timing generator that generates a variety of timing signals and controls the driving of the peripheral circuits such as the row scanning section 131, the horizontal selection section 133, and the column scanning section 134 on the basis of the variety of timing signals generated by the timing generator.

(Application Example 2)

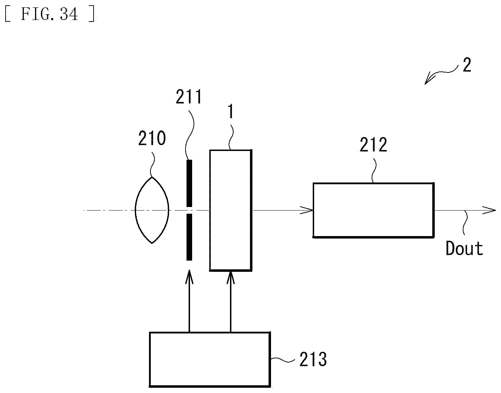

The imaging device 1 described above is applicable, for example, to any type of electronic apparatus with an imaging function including a camera system such as a digital still camera and a video camera, a mobile phone having an imaging function, and the like. FIG. 34 illustrates a schematic configuration of an electronic apparatus 2 (camera) as an example thereof. This electronic apparatus 2 is, for example, a video camera that is able to shoot a still image or a moving image. The electronic apparatus 2 includes the imaging device 1, an optical system (optical lens) 210, a shutter device 211, a drive section 213 that drives the imaging device 1 and the shutter device 211, and a signal processing section 212.

The optical system 210 guides image light (incident light) from a subj ect to the pixel section 1A of the imaging device 1. This optical system 210 may include a plurality of optical lenses. The shutter device 211 controls a period of time in which the imaging device 1 is irradiated with light and a period of time in which light is blocked. The drive section 213 controls a transfer operation of the imaging device 1 and a shutter operation of the shutter device 211. The signal processing section 212 performs various kinds of signal processing on signals outputted from the imaging device 1. An image signal Dout subjected to the signal processing is stored in a storage medium such as a memory or outputted to a monitor or the like.

(Application Example 3)

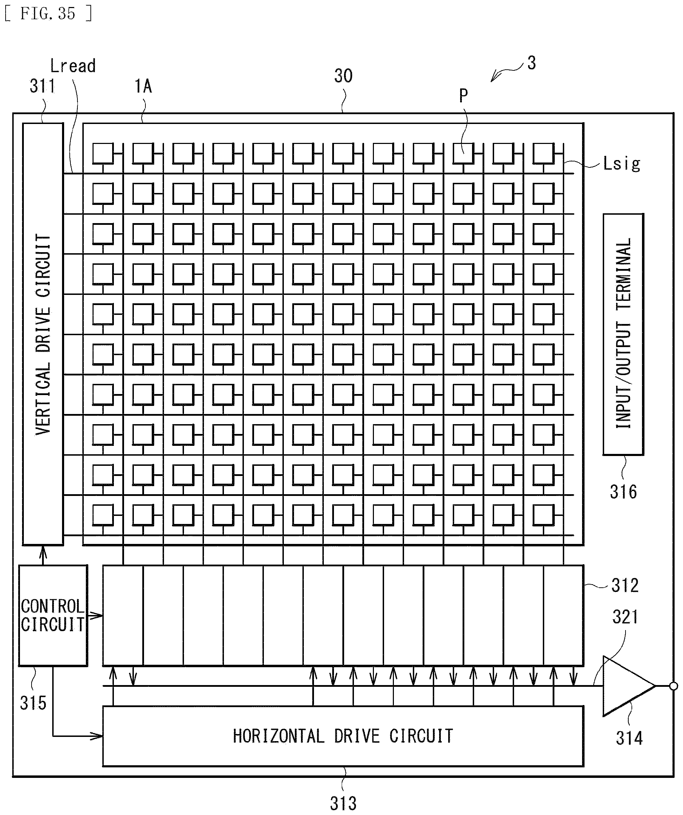

FIG. 35 illustrates an overall configuration of an imaging device (imaging device 3) in which an imaging element (e.g., imaging element 10) according to the present disclosure is used for each of the pixels. As described above, the imaging device 3 is, for example, a CMOS image sensor. The imaging device 3 takes in incident light (image light) from a subject through an optical lens system (not illustrated). The imaging device 3 converts the amount of incident light formed on the imaging surface as an image into electric signals in units of pixels and outputs the electric signals as pixel signals. The imaging device 3 includes the pixel section 1A as an imaging area on the semiconductor substrate 30. In addition, the imaging device 3 includes, for example, a vertical drive circuit 311, a column signal processing circuit 312, a horizontal drive circuit 313, an output circuit 314, a control circuit 315, and an input/output terminal 316 in a peripheral region of this pixel section 1A.

The pixel section 1A includes, for example, the plurality of unit pixels P that is two-dimensionally disposed in a matrix. These unit pixels P are provided, for example, with a pixel drive line Lread (specifically, a row selection line and a reset control line) for each of the pixel rows and provided with a vertical signal line Lsig for each of the pixel columns. The pixel drive line Lread transmits drive signals for reading out signals from the pixels. One end of the pixel drive line Lread is coupled to the output terminal of the vertical drive circuit 311 corresponding to each of the rows.

The vertical drive circuit 311 is a pixel drive section that includes a shift register, an address decoder, and the like and drives the respective unit pixels P of the pixel section 1A, for example, row by row. Signals outputted from the respective unit pixels P in the pixel rows selectively scanned by the vertical drive circuit 311 are supplied to the column signal processing circuit 312 through the respective vertical signal lines Lsig. The column signal processing circuit 312 includes an amplifier, a horizontal selection switch, and the like provided for each of the vertical signal lines Lsig.

The horizontal derive circuit 313 includes a shift register, an address decoder, and the like. The horizontal derive circuit 313 drives the respective horizontal selection switches of the column signal processing circuit 312 in order while scanning the horizontal selection switches. The selective scanning by this horizontal drive circuit 313 causes signals of the respective pixels transmitted through each of the vertical signal lines Lsig to be outputted to a horizontal signal line 121 in order and causes the signals to be transmitted to the outside of the semiconductor substrate 30 through the horizontal signal line 121.

The output circuit 314 performs signal processing on signals sequentially supplied from the respective column signal processing circuits 312 through the horizontal signal line 121 and outputs the signals. The output circuit 314 performs, for example, only buffering in some cases and performs black level adjustment, column variation correction, various kinds of digital signal processing, and the like in other cases.

The circuit portion including the vertical drive circuit 311, the column signal processing circuit 312, the horizontal drive circuit 313, the horizontal signal line 121, and the output circuit 314 may be formed directly on the semiconductor substrate 30 or may be provided on external control IC. In addition, the circuit portion thereof may be formed in another substrate coupled by a cable or the like.

The control circuit 315 receives a clock supplied from the outside of the semiconductor substrate 30, data for an instruction about an operation mode, and the like and also outputs data such as internal information of the imaging device 3. The control circuit 315 further includes a timing generator that generates a variety of timing signals and controls the driving of the peripheral circuits including the vertical drive circuit 311, the column signal processing circuit 312, the horizontal drive circuit 313, and the like on the basis of the variety of timing signals generated by the timing generator.

The input/output terminal 316 exchanges signals with the outside.

(Application Example 4)

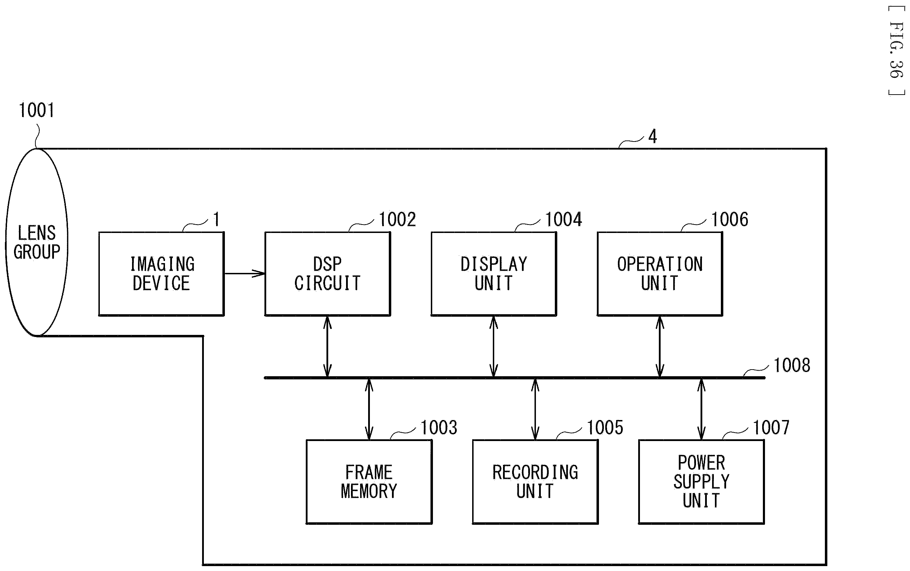

FIG. 36 illustrates a schematic configuration of another electronic apparatus (electronic apparatus 4).

The electronic apparatus 4 includes, for example, a lens group 1001, the imaging device 1, a DSP (Digital Signal Processor) circuit 1002, a frame memory 1003, a display unit 1004, a recording unit 1005, an operation unit 1006, and a power supply unit 1007. They are coupled to each other through a bus line 1008.

The lens group 1001 takes in incident light (image light) from a subject and forms am image on the imaging surface of the imaging device 1. The imaging device 1 converts the amount of incident light formed as an image on the imaging surface by the lens group 1001 into electric signals in units of pixels and supplies the DSP circuit 1002 with the electric signals as pixel signals.

The DSP circuit 1002 is a signal processing circuit that processes a signal supplied from the imaging device 1. The DSP circuit 1002 outputs image data that is obtained by processing the signal from the imaging device 1. The frame memory 1003 temporarily holds the image data processed by the DSP circuit 1002 in units of frames.

The display unit 1004 includes, for example, a panel-type display device such as a liquid crystal panel or an organic EL (Electro Luminescence) panel and records the image data of a moving image or a still image captured by the imaging device 1 in a recording medium such as a semiconductor memory or a hard disk.

The operation unit 1006 outputs an operation signal for a variety of functions of the electronic apparatus 4 in accordance with an operation by a user. The power supply unit 1007 appropriately supplies the DSP circuit 1002, the frame memory 1003, the display unit 1004, the recording unit 1005, and the operation unit 1006 with various kinds of power for operations of these supply targets.

<6. Practical Application Examples>

Further, the imaging device 1 described above is also applicable to the following electronic apparatuses (such as a capsule type endoscope 10100 or a mobile body including a vehicle and the like).

(Example of Practical Application to In-vivo Information Acquisition System)

Further, the technology (the present technology) according to the present disclosure is applicable to a variety of products. For example, the technology according to the present disclosure may be applied to an endoscopic surgery system.

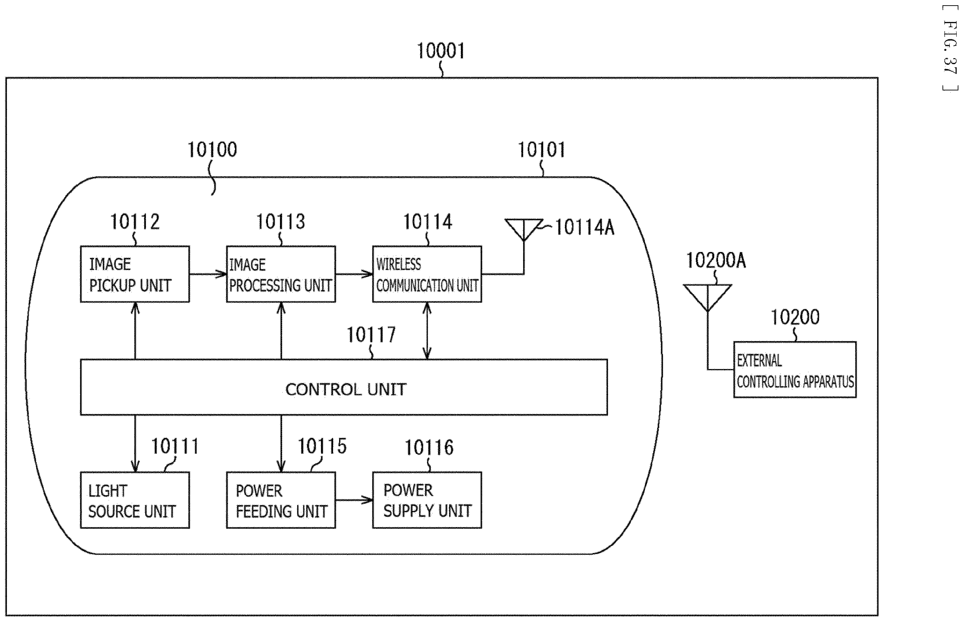

FIG. 37 is a block diagram depicting an example of a schematic configuration of an in-vivo information acquisition system of a patient using a capsule type endoscope, to which the technology according to an embodiment of the present disclosure (present technology) can be applied.

The in-vivo information acquisition system 10001 includes a capsule type endoscope 10100 and an external controlling apparatus 10200.

The capsule type endoscope 10100 is swallowed by a patient at the time of inspection. The capsule type endoscope 10100 has an image pickup function and a wireless communication function and successively picks up an image of the inside of an organ such as the stomach or an intestine (hereinafter referred to as in-vivo image) at predetermined intervals while it moves inside of the organ by peristaltic motion for a period of time until it is naturally discharged from the patient. Then, the capsule type endoscope 10100 successively transmits information of the in-vivo image to the external controlling apparatus 10200 outside the body by wireless transmission.

The external controlling apparatus 10200 integrally controls operation of the in-vivo information acquisition system 10001. Further, the external controlling apparatus 10200 receives information of an in-vivo image transmitted thereto from the capsule type endoscope 10100 and generates image data for displaying the in-vivo image on a display apparatus (not depicted) on the basis of the received information of the in-vivo image.

In the in-vivo information acquisition system 10001, an in-vivo image imaged a state of the inside of the body of a patient can be acquired at any time in this manner for a period of time until the capsule type endoscope 10100 is discharged after it is swallowed.

A configuration and functions of the capsule type endoscope 10100 and the external controlling apparatus 10200 are described in more detail below.

The capsule type endoscope 10100 includes a housing 10101 of the capsule type, in which a light source unit 10111, an image pickup unit 10112, an image processing unit 10113, a wireless communication unit 10114, a power feeding unit 10115, a power supply unit 10116 and a control unit 10117 are accommodated.

The light source unit 10111 includes a light source such as, for example, a light emitting diode (LED) and irradiates light on an image pickup field-of-view of the image pickup unit 10112.

The image pickup unit 10112 includes an image pickup element and an optical system including a plurality of lenses provided at a preceding stage to the image pickup element. Reflected light (hereinafter referred to as observation light) of light irradiated on a body tissue which is an observation target is condensed by the optical system and introduced into the image pickup element. In the image pickup unit 10112, the incident observation light is photoelectrically converted by the image pickup element, by which an image signal corresponding to the observation light is generated. The image signal generated by the image pickup unit 10112 is provided to the image processing unit 10113.

The image processing unit 10113 includes a processor such as a central processing unit (CPU) or a graphics processing unit (GPU) and performs various signal processes for an image signal generated by the image pickup unit 10112. The image processing unit 10113 provides the image signal for which the signal processes have been performed thereby as RAW data to the wireless communication unit 10114.

The wireless communication unit 10114 performs a predetermined process such as a modulation process for the image signal for which the signal processes have been performed by the image processing unit 10113 and transmits the resulting image signal to the external controlling apparatus 10200 through an antenna 10114A. Further, the wireless communication unit 10114 receives a control signal relating to driving control of the capsule type endoscope 10100 from the external controlling apparatus 10200 through the antenna 10114A. The wireless communication unit 10114 provides the control signal received from the external controlling apparatus 10200 to the control unit 10117.

The power feeding unit 10115 includes an antenna coil for power reception, a power regeneration circuit for regenerating electric power from current generated in the antenna coil, a voltage booster circuit and so forth. The power feeding unit 10115 generates electric power using the principle of non-contact charging.

The power supply unit 10116 includes a secondary battery and stores electric power generated by the power feeding unit 10115. In FIG. 37, in order to avoid complicated illustration, an arrow mark indicative of a supply destination of electric power from the power supply unit 10116 and so forth are omitted. However, electric power stored in the power supply unit 10116 is supplied to and can be used to drive the light source unit 10111, the image pickup unit 10112, the image processing unit 10113, the wireless communication unit 10114 and the control unit 10117.

The control unit 10117 includes a processor such as a CPU and suitably controls driving of the light source unit 10111, the image pickup unit 10112, the image processing unit 10113, the wireless communication unit 10114 and the power feeding unit 10115 in accordance with a control signal transmitted thereto from the external controlling apparatus 10200.

The external controlling apparatus 10200 includes a processor such as a CPU or a GPU, a microcomputer, a control board or the like in which a processor and a storage element such as a memory are mixedly incorporated. The external controlling apparatus 10200 transmits a control signal to the control unit 10117 of the capsule type endoscope 10100 through an antenna 10200A to control operation of the capsule type endoscope 10100. In the capsule type endoscope 10100, an irradiation condition of light upon an observation target of the light source unit 10111 can be changed, for example, in accordance with a control signal from the external controlling apparatus 10200. Further, an image pickup condition (for example, a frame rate, an exposure value or the like of the image pickup unit 10112) can be changed in accordance with a control signal from the external controlling apparatus 10200. Further, the substance of processing by the image processing unit 10113 or a condition for transmitting an image signal from the wireless communication unit 10114 (for example, a transmission interval, a transmission image number or the like) may be changed in accordance with a control signal from the external controlling apparatus 10200.

Further, the external controlling apparatus 10200 performs various image processes for an image signal transmitted thereto from the capsule type endoscope 10100 to generate image data for displaying a picked up in-vivo image on the display apparatus. As the image processes, various signal processes can be performed such as, for example, a development process (demosaic process), an image quality improving process (bandwidth enhancement process, a super-resolution process, a noise reduction (NR) process and/or image stabilization process) and/or an enlargement process (electronic zooming process). The external controlling apparatus 10200 controls driving of the display apparatus to cause the display apparatus to display a picked up in-vivo image on the basis of generated image data. Alternatively, the external controlling apparatus 10200 may also control a recording apparatus (not depicted) to record generated image data or control a printing apparatus (not depicted) to output generated image data by printing.

The example of the in-vivo information acquisition system to which the technology according to the present disclosure may be applied has been described above. The technology according to the present disclosure may be applied, for example, to the image pickup unit 10112 among the components described above. This increases the detection accuracy.

(Example of Practical Application to Endoscopic Surgery System)

The technology (the present technology) according to the present disclosure is applicable to a variety of products. For example, the technology according to the present disclosure may be applied to an endoscopic surgery system.

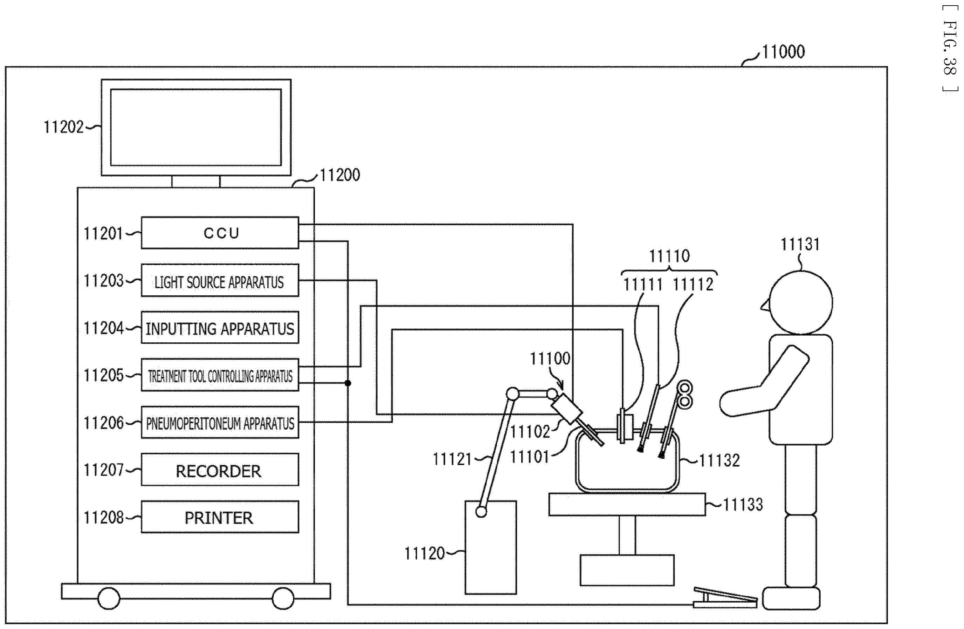

FIG. 38 is a view depicting an example of a schematic configuration of an endoscopic surgery system to which the technology according to an embodiment of the present disclosure (present technology) can be applied.

In FIG. 38, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

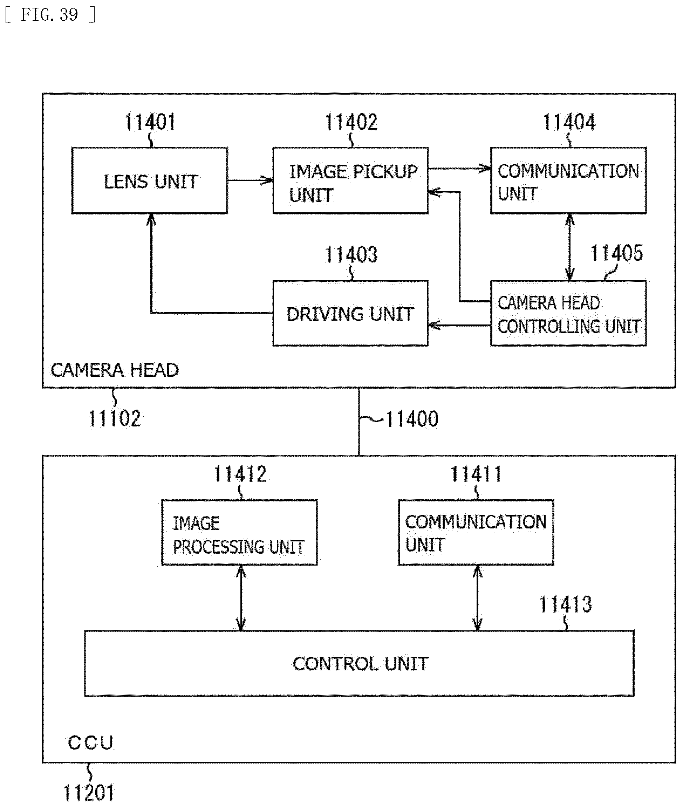

FIG. 39 is a block diagram depicting an example of a functional configuration of the camera head 11102 and the CCU 11201 depicted in FIG. 38.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The example of the endoscopic surgery system to which the technology according to the present disclosure may be applied has been described above. The technology according to the present disclosure may be applied to the image pickup unit 11402 among the components described above. The application of the technology according to the present disclosure to the image pickup unit 11402 increases the detection accuracy.

It is to be noted that the endoscopic surgery system has been described here as an example, but the technology according to the present disclosure may be additionally applied, for example, to a microscopic surgery system or the like.

(Example of Practical Application to Mobile Body)

The technology according to the present disclosure is applicable to a variety of products. For example, the technology according to the present disclosure may be achieved as a device mounted on any type of mobile body such as a vehicle, an electric vehicle, a hybrid electric vehicle, a motorcycle, a bicycle, a personal mobility, an airplane, a drone, a vessel, a robot, a construction machine, or an agricultural machine (tractor).

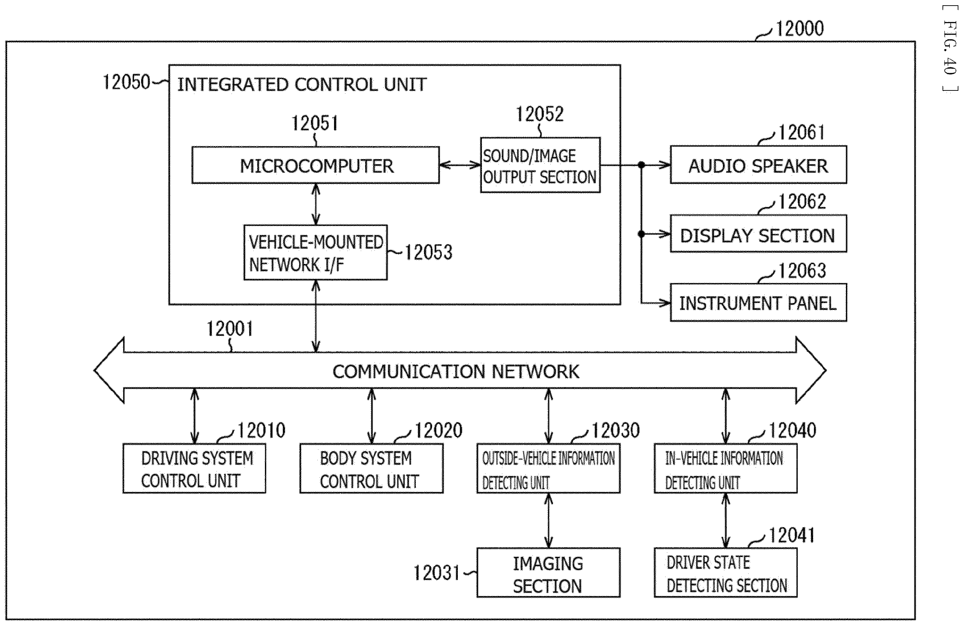

FIG. 40 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 40, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 40, an audio speaker 12061, a display section 12062, and an instrument panel 12063 are illustrated as the output device. The display section 12062 may, for example, include at least one of an on-board display and a head-up display.

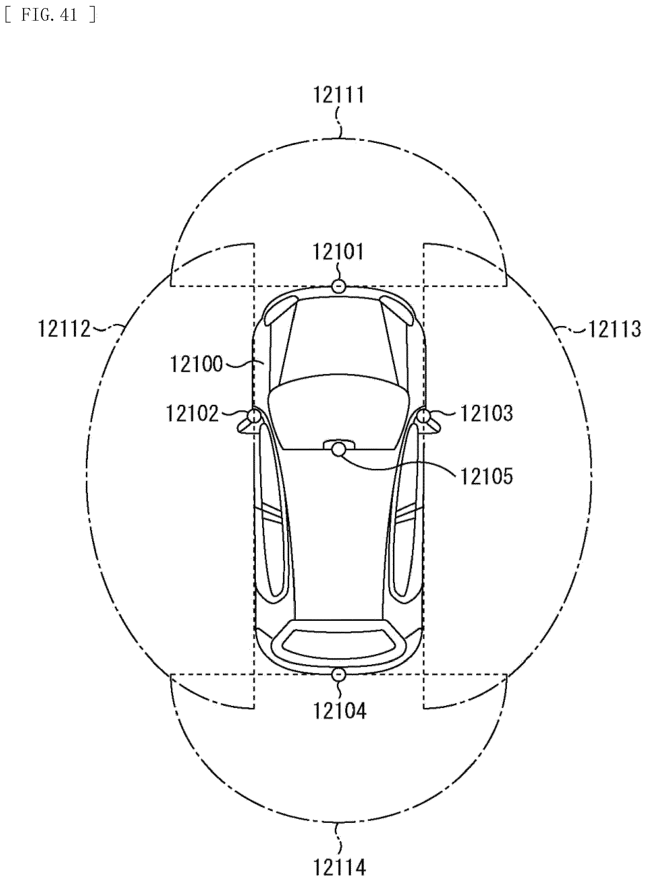

FIG. 41 is a diagram depicting an example of the installation position of the imaging section 12031.

In FIG. 41, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 41 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

Although the description has been given with reference to the first and second embodiments and the modification examples 1 to 8 and the application examples and the practical application examples, the contents of the present disclosure are not limited to the embodiment and the like described above. A variety of modifications are possible. For example, in the first embodiment described above, the imaging element 10 has a configuration in which the organic photoelectric conversion section 20 that detects green light and the inorganic photoelectric conversion sections 32B and 32R that respectively detect blue light and red light are stacked. The contents of the present disclosure are not, however, limited to such a structure. For example, the organic photoelectric conversion section may detect the red light or the blue light or the inorganic photoelectric conversion sections may each detect the green light.

Further, in the embodiment or the like described above, the example has been described in which a plurality of electrodes included in the lower electrode 21 includes the two electrodes of the readout electrode 21A and the accumulation electrode 21B or the three electrodes of the readout electrode 21A, the accumulation electrode 21B, and the transfer electrode 21C. In addition, there may be, however, provided four or more electrodes including a discharge electrode and the like.

It is to be noted that the effects described herein are merely examples, but are not limitative. In addition, there may be other effects.

It is to be noted that the present technology may also have configurations as follows. According to the present technology having the following configurations, the semiconductor layer is provided between the first electrode and second electrode and the photoelectric conversion layer. The first electrode and the second electrode are disposed in parallel. In the semiconductor layer, the first layer and the second layer are stacked in this order from the first electrode and second electrode side. This first layer has a larger value for C5s than the value of the second layer for C5s. The second layer has a larger value for $E_{VO}$ or $E_{VN}$ than the value of the first layer for $E_{VO}$ or $E_{VN}$. This improves the characteristics of transporting the electric charge accumulated in the semiconductor layer above the first electrode in the in-plane direction and reduces the occurrence of traps at the interface between the semiconductor layer and the photoelectric conversion layer. This makes it possible to improve the afterimage characteristics.

(1) An imaging element including:

a first electrode and a second electrode that are disposed in parallel;
a third electrode that is disposed to be opposed to the first electrode and the second electrode;
a photoelectric conversion layer that is provided between the first electrode and second electrode and the third electrode, the photoelectric conversion layer including an organic material; and
a semiconductor layer including a first layer and a second layer that are stacked in order from the first electrode and second electrode side between the first electrode and second electrode and the photoelectric conversion layer, in which
the first layer has a larger value for C5s indicating a contribution ratio of a 5s orbital to a conduction band minimum than a value of the second layer for C5s, and
the second layer has a larger value for $E_{VO}$ indicating oxygen deficiency generation energy or a larger value for $E_{VN}$ indicating nitrogen deficiency generation energy than a value of the first layer for $E_{VO}$ or $E_{VN}$.

(2) The imaging element according to (1), in which the first layer includes a material that satisfies C5s > 50% and the second layer includes a material that satisfies $E_{VO}$ > 2.3 eV
(3) The imaging element according to (1), in which the first layer includes a material that satisfies C5s > 80% and the second layer includes a material that satisfies $E_{VO}$ > 2.8 eV
(4) The imaging element according to any one of (1) to (3), in which the first layer includes an amorphous layer.
(5) The imaging element according to any one of (1) to (4), in which the second layer has a film thickness that is four times or more and eight times or less as large as a film thickness of the first layer.
(6) The imaging element according to any one of (1) to (5), further including an insulating layer that is provided between the first electrode and second electrode and the semiconductor layer and has an opening above the second electrode, in which

the second electrode and the semiconductor layer are electrically coupled through the opening.

(7) The imaging element according to any one of (1) to (6), in which the first layer and the second layer are each formed by using an IGTO-based oxide semiconductor, a GZTO-based oxide semiconductor, an ITZO-based oxide semiconductor, or an ITGZO-based oxide semiconductor.

(8) The imaging element according to any one of (1) to (7), in which the first layer is formed by using ITO, IZO, indium-rich ITZO, IGO, or tin-rich SnZnO.

(9) The imaging element according to any one of (1) to (8), in which the second layer is formed by using IGZO, IGZTO, ZTO, GZTO, or IGTO.

(10) The imaging element according to any one of (1) to (9), further including a protective layer between the photoelectric conversion layer and the semiconductor layer, the protective layer including an inorganic material.

(11) The imaging element according to any one of (1) to (10), in which the semiconductor layer further includes a third layer that is provided between the first electrode and second electrode and the first layer, the third layer having a conduction band minimum that is shallower than a conduction band minimum of the first layer.

(12) The imaging element according to any one of (1) to (11), in which

the first layer and the second layer each include an oxide semiconductor, and
the first layer has a smaller value for $\Delta EN$ indicating a value obtained by subtracting an average electronegativity value of cation species included in the oxide semiconductor from an average electronegativity value of anion species included in the oxide semiconductor than a value of the second layer for $\Delta EN$.

(13) The imaging element according to (12), in which an LUMO level E1 of a material of the photoelectric conversion layer included near the semiconductor layer and an LUMO level E2 of a material included in the semiconductor layer satisfy $E2 - E1 \geq 0.1$ eV

(14) The imaging element according to (12) or (13), in which the semiconductor layer includes a material having a carrier mobility of 10 $cm^2/V \cdot s$ or more.

(15) The imaging element according to any one of (12) to (14), in which the second layer has a carrier concentration of $1 \times 10^{14}/cm^{-3}$ or more and less than $1 \times 10^{17}/cm^{-3}$.

(16) The imaging element according to any one of (1) to (15), in which the first electrode and the second electrode are disposed on the photoelectric conversion layer on an opposite side to a light incidence surface.

(17) The imaging element according to any one of (1) to (16), in which respective voltages are individually applied to the first electrode and the second electrode.

(18) The imaging element according to (17), in which one or more organic photoelectric conversion sections and one or more inorganic photoelectric conversion sections are stacked, the organic photoelectric conversion sections each including the first electrode, the second electrode, the third electrode, the photoelectric conversion layer, and the semiconductor layer, the inorganic photoelectric conversion sections each performing photoelectric conversion in a wavelength range different from a wavelength range of each of the organic photoelectric conversion sections.

(19) The imaging element according to (18), in which

the inorganic photoelectric conversion section is formed to be buried in a semiconductor substrate, and
the organic photoelectric conversion section is formed on a first surface side of the semiconductor substrate.

(20) The imaging element according to (19), in which the semiconductor substrate has a first surface and a second surface that are opposed to each other and has a multilayer wiring layer formed on the second surface side.

(21) An imaging device including

a plurality of pixels that is each provided with one or more imaging elements, in which
the imaging elements each include

a first electrode and a second electrode that are disposed in parallel,
a third electrode that is disposed to be opposed to the first electrode and the second electrode,
a photoelectric conversion layer that is provided between the first electrode and second electrode and the third electrode, the photoelectric conversion layer including an organic material, and
a semiconductor layer including a first layer and a second layer that are stacked in order from the first electrode and second electrode side between the first electrode and second electrode and the photoelectric conversion layer,
the first layer having a larger value for C5s indicating a contribution ratio of a 5s orbital to a conduction band minimum than a value of the second layer for C5s,
the second layer having a larger value for $E_{VO}$ indicating oxygen deficiency generation energy or a larger value for $E_{VN}$ indicating nitrogen deficiency generation energy than a value of the first layer for $E_{VO}$ or $E_{VN}$.

The present application claims the priority on the basis of Japanese Patent Application No. 2020-064018 filed on March 31, 2020 with Japan Patent Office and Japanese Patent Application No. 2021-045946 filed on March 19, 2021 with Japan Patent Office, the entire contents of which are incorporated in the present application by reference.
It should be understood by those skilled in the art that various modifications, combinations, sub-combinations, and alterations may occur depending on design requirements and other factors insofar as they are within the scope of the appended claims or the equivalents thereof.

## Claims

1. An imaging element comprising:

   a first electrode and a second electrode that are disposed in parallel;
   a third electrode that is disposed to be opposed to the first electrode and the second electrode;
   a photoelectric conversion layer that is provided between the first electrode and second electrode and the third electrode, the photoelectric conversion layer including an organic material; and
   a semiconductor layer including a first layer and a second layer that are stacked in order from the first electrode and second electrode side between the first electrode and second electrode and the photoelectric conversion layer, wherein
   the first layer has a larger value for C5s indicating a contribution ratio of a 5s orbital to a conduction band minimum than a value of the second layer for C5s, and
   the second layer has a larger value for $E_{VO}$ indicating oxygen deficiency generation energy or a larger value for $E_{VN}$ indicating nitrogen deficiency generation energy than a value of the first layer for $E_{VO}$ or $E_{VN}$.

2. The imaging element according to claim 1, wherein the first layer includes a material that satisfies C5s > 50% and the second layer includes a material that satisfies $E_{VO} > 2.3$ eV

3. The imaging element according to claim 1, wherein the first layer includes a material that satisfies C5s > 80% and the second layer includes a material that satisfies $E_{VO} > 2.8$ eV

4. The imaging element according to claim 1, wherein the first layer includes an amorphous layer.

5. The imaging element according to claim 1, wherein the second layer has a film thickness that is four times or more and eight times or less as large as a film thickness of the first layer.

6. The imaging element according to claim 1, further comprising an insulating layer that is provided between the first electrode and second electrode and the semiconductor layer and has an opening above the second electrode, wherein
   the second electrode and the semiconductor layer are electrically coupled through the opening.

7. The imaging element according to claim 1, wherein the first layer and the second layer are each formed by using an IGTO-based oxide semiconductor, a GZTO-based oxide semiconductor, an ITZO-based oxide semiconductor, or an ITGZO-based oxide semiconductor.

8. The imaging element according to claim 1, wherein the first layer is formed by using ITO, IZO, indium-rich ITZO, IGO, or tin-rich SnZnO.

9. The imaging element according to claim 1, wherein the second layer is formed by using IGZO, IGZTO, ZTO, GZTO, or IGTO.

10. The imaging element according to claim 1, further comprising a protective layer between the photoelectric conversion layer and the semiconductor layer, the protective layer including an inorganic material.

11. The imaging element according to claim 1, wherein the semiconductor layer further includes a third layer that is provided between the first electrode and second electrode and the first layer, the third layer having a conduction band minimum that is shallower than a conduction band minimum of the first layer.

**12.** The imaging element according to claim 1, wherein

the first layer and the second layer each include an oxide semiconductor, and
the first layer has a smaller value for $\Delta$EN indicating a value obtained by subtracting an average electronegativity value of cation species included in the oxide semiconductor from an average electronegativity value of anion species included in the oxide semiconductor than a value of the second layer for $\Delta$EN.

**13.** The imaging element according to claim 12, wherein an LUMO level E1 of a material of the photoelectric conversion layer included near the semiconductor layer and an LUMO level E2 of a material included in the semiconductor layer satisfy E2 - E1 $\geq$ 0.1 eV

**14.** The imaging element according to claim 12, wherein the semiconductor layer includes a material having a carrier mobility of 10 cm$^2$/V·s or more.

**15.** The imaging element according to claim 12, wherein the second layer has a carrier concentration of $1\times10^{14}$/cm$^{-3}$ or more and less than $1\times10^{17}$/cm$^{-3}$.

**16.** The imaging element according to claim 1, wherein the first electrode and the second electrode are disposed on the photoelectric conversion layer on an opposite side to a light incidence surface.

**17.** The imaging element according to claim 1, wherein respective voltages are individually applied to the first electrode and the second electrode.

**18.** The imaging element according to claim 17, wherein one or more organic photoelectric conversion sections and one or more inorganic photoelectric conversion sections are stacked, the organic photoelectric conversion sections each including the first electrode, the second electrode, the third electrode, the photoelectric conversion layer, and the semiconductor layer, the inorganic photoelectric conversion sections each performing photoelectric conversion in a wavelength range different from a wavelength range of each of the organic photoelectric conversion sections.

**19.** The imaging element according to claim 18, wherein

the inorganic photoelectric conversion section is formed to be buried in a semiconductor substrate, and
the organic photoelectric conversion section is formed on a first surface side of the semiconductor substrate.

**20.** The imaging element according to claim 19, wherein the semiconductor substrate has a first surface and a second surface that are opposed to each other and has a multilayer wiring layer formed on the second surface side.

**21.** An imaging device comprising

a plurality of pixels that is each provided with one or more imaging elements, wherein the imaging elements each include

a first electrode and a second electrode that are disposed in parallel,
a third electrode that is disposed to be opposed to the first electrode and the second electrode,
a photoelectric conversion layer that is provided between the first electrode and second electrode and the third electrode, the photoelectric conversion layer including an organic material, and
a semiconductor layer including a first layer and a second layer that are stacked in order from the first electrode and second electrode side between the first electrode and second electrode and the photoelectric conversion layer,
the first layer having a larger value for C5s indicating a contribution ratio of a 5s orbital to a conduction band minimum than a value of the second layer for C5s,
the second layer having a larger value for $E_{VO}$ indicating oxygen deficiency generation energy or a larger value for $E_{VN}$ indicating nitrogen deficiency generation energy than a value of the first layer for $E_{VO}$ or $E_{VN}$.

[ FIG. 1 ]

[ FIG. 2 ]

[ FIG. 3 ]

[ FIG. 4 ]

[ FIG. 5 ]

[ FIG. 6 ]

[ FIG. 7 ]

[ FIG. 8 ]

[ FIG. 9 ]

[ FIG. 10 ]

[ FIG. 11 ]

[ FIG. 12 ]

EP 4 131 380 A1

[ FIG. 13 ]

[ FIG. 14 ]

[ FIG. 15 ]

[ FIG. 16 ]

[ FIG. 17 ]

[ FIG. 18 ]

EP 4 131 380 A1

[ FIG. 19 ]

EP 4 131 380 A1

| ACCUMULATION PERIOD | RESET PERIOD | TRANSFER PERIOD | ACCUMULATION PERIOD | RESET PERIOD | TRANSFER PERIOD |

(A) VOA

(B) FD

(C) RST

t1    t2    t3                     t1    t2    t3

[ FIG. 20 ]

20A

25

24

29

23B

23

23A

22

27

21A

21B

21

Y

Z X

[ FIG. 21 ]

[ FIG. 22 ]

[ FIG. 23 ]

[ FIG. 24 ]

[ FIG. 25 ]

[ FIG. 26 ]

[ FIG. 27 ]

[ FIG. 28 ]

[ FIG. 29 ]

[ FIG. 30A ]

[ FIG. 30B ]

[ FIG. 31A ]

[ FIG. 31B ]

[ FIG. 32 ]

[ FIG. 33 ]

[ FIG. 34 ]

[ FIG. 35 ]

[ FIG. 36 ]

[ FIG. 37 ]

EP 4 131 380 A1

EP 4 131 380 A1

[ FIG. 38 ]

73

[ FIG. 39 ]

[ FIG. 40 ]

[ FIG. 41 ]

**INTERNATIONAL SEARCH REPORT**

International application No.

PCT/JP2021/012399

| A. CLASSIFICATION OF SUBJECT MATTER |
|---|
| H01L 27/146(2006.01)i; H04N 5/359(2011.01)i; H04N 5/374(2011.01)i |
| FI: H01L27/146 E; H01L27/146 A; H04N5/359 700; H04N5/374 |
| According to International Patent Classification (IPC) or to both national classification and IPC |

| B. FIELDS SEARCHED |
|---|
| Minimum documentation searched (classification system followed by classification symbols) |
| H01L27/146; H04N5/359; H04N5/374 |

| Documentation searched other than minimum documentation to the extent that such documents are included in the fields searched | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

| Electronic data base consulted during the international search (name of data base and, where practicable, search terms used) |
|---|
|  |

| C. DOCUMENTS CONSIDERED TO BE RELEVANT | | |
|---|---|---|
| Category* | Citation of document, with indication, where appropriate, of the relevant passages | Relevant to claim No. |
| A | WO 2019/035252 A1 (SONY CORP.) 21 February 2019 (2019-02-21) entire text, all drawings | 1-21 |
| A | WO 2019/035254 A1 (SONY CORP.) 21 February 2019 (2019-02-21) entire text, all drawings | 1-21 |
| A | WO 2019/203222 A1 (SONY CORP.) 24 October 2019 (2019-10-24) entire text, all drawings | 1-21 |
| A | WO 2019/203213 A1 (SONY CORP.) 24 October 2019 (2019-10-24) entire text, all drawings | 1-21 |
| A | WO 2019/111603 A1 (SONY CORP.) 13 June 2019 (2019-06-13) entire text, all drawings | 1-21 |
| A | WO 2018/194051 A1 (SONY CORP.) 25 October 2018 (2018-10-25) entire text, all drawings | 1-21 |
| A | JP 2016-63165 A (TOSHIBA CORP.) 25 April 2016 (2016-04-25) entire text, all drawings | 1-21 |

☒ Further documents are listed in the continuation of Box C.     ☒ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 07 June 2021 (07.06.2021) | 15 June 2021 (15.06.2021) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

| International application No. |
| --- |
| PCT/JP2021/012399 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | US 2016/0037098 A1 (SAMSUNC ELECTRONICS CO., LTD.) 04 February 2016 (2016-02-04) entire text, all drawings | 1-21 |
| A | US 2013/0093911 A1 (SAMSUNC ELECTRONICS CO., LTD.) 18 April 2013 (2013-04-18) entire text, all drawings | 1-21 |
| A | JP 2018-46039 A (SONY SEMICONDUCTOR SOLUTIONS CORPORATION) 22 March 2018 (2018-03-22) entire text, all drawings | 1-21 |

Form PCT/ISA/210 (continuation of second sheet) (January 2015)

International application no.

PCT/JP2021/012399

| Patent Documents referred in the Report | Publication Date | Patent Family | Publication Date |
|---|---|---|---|
| WO 2019/035252 A1 | 21 Feb. 2019 | EP 3671840 A1 entire text, all drawings KR 10-2020-0035940 A CN 111033740 A TW 201911550 A | |
| WO 2019/035254 A1 | 21 Feb. 2019 | US 2020/0212108 A1 entire text, all drawings EP 3671838 A1 KR 10-2020-0036816 A CN 111033741 A JP 2019-36641 A | |
| WO 2019/203222 A1 | 24 Oct. 2019 | TW 201944590 A entire text, all drawings | |
| WO 2019/203213 A1 | 24 Oct. 2019 | TW 201946262 A | |
| WO 2019/111603 A1 | 13 Jun. 2019 | CN 111448663 A | |
| WO 2018/194051 A1 | 25 Oct. 2018 | US 2020/0119078 A1 entire text, all drawings CN 110520998 A KR 10-2020-0019113 A TW 201843823 A | |
| JP 2016-63165 A | 25 Apr. 2016 | CN 106206627 A | |
| US 2016/0037098 A1 | 04 Feb. 2016 | KR 10-2016-0017168 A | |
| US 2013/0093911 A1 | 18 Apr. 2013 | KR 10-2013-0041418 A | |
| JP 2018-46039 A | 22 Mar. 2018 | US 2019/0214417 A1 entire text, all drawings WO 2018/047517 A1 | |

Form PCT/ISA/210 (patent family annex) (January 2015)

**EP 4 131 380 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017157816 A
- JP 2020064018 A
- JP 2021045946 A

**Non-patent literature cited in the description**

- *Phys. Status Solidi A,* 2009, vol. 206 (5), 860-867